(19) Europäisches Patentamt
European Patent Office
Office européen des brevets

(11) EP 4 669 070 A1

(12) EUROPEAN PATENT APPLICATION
published in accordance with Art. 153(4) EPC

(43) Date of publication:
**24.12.2025 Bulletin 2025/52**

(21) Application number: **24757001.3**

(22) Date of filing: **16.02.2024**

(51) International Patent Classification (IPC):
***H10K 50/852*** *(2023.01)* ***H01S 5/36*** *(2006.01)*
***H10K 50/15*** *(2023.01)* ***H10K 50/16*** *(2023.01)*
***H10K 50/18*** *(2023.01)* ***H10K 50/858*** *(2023.01)*

(52) Cooperative Patent Classification (CPC):
**H01S 5/36; H10K 50/15; H10K 50/16; H10K 50/18; H10K 50/852; H10K 50/858**

(86) International application number:
**PCT/JP2024/005609**

(87) International publication number:
**WO 2024/172162 (22.08.2024 Gazette 2024/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **17.02.2023 JP 2023023194**
**28.03.2023 JP 2023051513**
**02.08.2023 PCT/JP2023/028247**

(71) Applicant: **KOALA Tech Inc.**
**Fukuoka-shi, Fukuoka 819-0388 (JP)**

(72) Inventors:
- **AUFFRAY Morgan**
**Fukuoka-shi, Fukuoka 819-0388 (JP)**
- **BENCHEIKH Fatima**
**Fukuoka-shi, Fukuoka 819-0388 (JP)**

(74) Representative: **Zimmermann & Partner Patentanwälte mbB**
**P.O. Box 330 920**
**80069 München (DE)**

(54) **ORGANIC SOLID STATE SEMICONDUCTOR LASER, AND METHOD FOR REDUCING PEAK WIDTH OF EMISSION SPECTRUM OF ORGANIC ELECTROLUMINESCENT ELEMENT**

(57) An organic solid-state semiconductor laser including a hole injection section, an electron injection section, a light-emitting layer of emitting light by recombining holes and electrons, and an optical resonator that propagates the emitted light inside the light-emitting layer, and including a hole-blocking layer on the electron injection section side of the light-emitting layer so as to be adjacent to the light-emitting layer or an electron-blocking layer on the hole injection section side of the light-emitting layer so as to be adjacent to the light-emitting layer has a small peak width of the emission spectrum.

EP 4 669 070 A1

## Description

Technical Field

The present invention relates to a method for reducing the peak width of the emission spectrum of an organic solid-state semiconductor laser using an organic compound as a laser oscillation material and an organic electroluminescent device.

Background Art

Compared to inorganic semiconductor lasers, organic solid-state semiconductor lasers that use an organic compound as a laser oscillation material have wider wavelength tunability, greater flexibility, and lower production costs, and are therefore expected to be applied to various fields using laser light, and research and development thereof is actively underway for their practical use.

For example, PTL 1 describes fabrication of organic solid-state semiconductor lasers using BSBCz (4,4'-bis[(N-carbazole)styryl]biphenyl) as a laser oscillation material, and confirmed laser oscillation. As shown in Fig. 19, the organic solid-state semiconductor laser fabricated herein includes an ITO cathode 101, a light-emitting layer 102 containing BSBCz, and an anode 103 including a stack structure of $MoO_3$ layer/Ag layer/Al layer, and the light-emitting layer 102 is formed to have a thickness of 210 nm.

Citation List

Patent Literature

PTL 1:WO2018/147470

Summary of Invention

Technical Problem

As described above, various organic solid-state semiconductor lasers with light-emitting layers containing BSBCz and the like between the anode and the cathode have been proposed. However, there is still a need to develop organic solid-state semiconductor lasers or organic electroluminescent devices with even better performance than before, and for example, it is desired to provide organic solid-state semiconductor lasers that can further improve laser efficiency and monochromaticity, and can achieve low-voltage drive.

Given the situation and for solving these problems of related-art technology, the inventors have investigated the possibility of providing an organic solid-state semiconductor laser or an organic electroluminescent device with a small peak width of the emission spectrum (light intensity distribution relative to wavelength).

Solution to Problem

The inventors have made assiduous studies for solving the above-mentioned problems and, as a result, have found a configuration that can significantly narrow the peak width of the emission spectrum. The present invention has been proposed based on these findings, and specifically has the following configuration.

[1] A method for narrowing a full-width half-maximum (FWHM) of an emission wavelength peak of an emission spectrum of an organic electroluminescent device provided with:

a hole injection section of injecting holes,
an electron injection section of injecting electrons, and
a light-emitting layer of emitting light by recombining holes and electrons, in which
the light generated in the light-emitting layer propagates in a lateral direction of the light-emitting layer, the method including
arranging a recombination-active region along the lateral direction of the light-emitting layer.

Here, the recombination-active region is a region where the recombination of holes and electrons occurs intensively to increase the exciton density (exciton-dense region). The location of the recombination-active region can be determined, for example, by simulating the exciton density distribution.

[2] A method for narrowing a full-width half-maximum (FWHM) of an emission wavelength peak of an emission spectrum of an organic electroluminescent device provided with:

a hole injection section of injecting holes,
an electron injection section of injecting electrons, and
a light-emitting layer arranged between the hole injection section and the electron injection section to emit light by recombining holes and electrons, in which
the light generated in the light-emitting layer propagates in a lateral direction of the light-emitting layer, the method including:

when a side of the light-emitting layer that is an exciton-dense region is on the electron injection section side, arranging a hole-blocking layer at a position between the light-emitting layer and the electron injection section and adjacent to the light-emitting layer; and
when the side of the light-emitting layer that is the exciton-dense region is on the hole injection section side, arranging an electron-blocking layer at a position between the light-emitting layer and the hole injection section and adjacent to the light-emitting layer.

[3] The method according to [1] or [2], in which the device is provided with a low refractive index layer with a lower refractive index than the light-emitting layer between the light-emitting layer and the hole injection section, and between the light-emitting layer and the electron injection section.
[4] The method according to any one of [1] to [3], in which the position of the exciton-dense region in the light-emitting layer is determined by simulating an exciton density distribution in the light-emitting layer.
[5] The method according to any one of [2] to [4], in which the side of the light-emitting layer that is the exciton-dense region is on the electron injection section side, and a hole-blocking layer is arranged between the light-emitting layer and the electron injection section and adjacent to the light-emitting layer.
[6] The method according to [5], in which the absolute value of the HOMO energy of the hole-blocking layer is greater (for example, by at least 0.1 eV, for example, by at least 0.2 eV, for example, by at least 0.4 eV) than the absolute value of the HOMO energy of the light-emitting layer.
[7] The method according to [5] or [6], in which the hole mobility of the hole-blocking layer is reduced.
[8] The method according to any one of [5] to [7], in which at least one layer (for example, an electron transport layer) is arranged between the hole-blocking layer and the electron injection section.
[9] The method according to [8], in which the electron mobility of the electron transport layer is lowered.
[10] The method according to [8] or [9], in which the absolute value of the HOMO energy of the electron transport layer is greater by at least 0.1 eV (for example, by at least 0.2 eV) than the absolute value of the HOMO energy of the light-emitting layer.
[11] The method according to any one of [5] to [10], in which the total thickness of the layer between the light-emitting layer and the electron injection section is increased.
[12] The method according to any one of [5] to [11], in which the total thickness of the one or more layers between the light-emitting layer and the electron injection section is greater by at least 2 times (for example, by at least 2.5 times, for example, by at least 3 times) than the total thickness of the one or more layers between the light-emitting layer and the hole injection section.
[13] The method according to any one of [5] to [12], in which the refractive index of the layer between the light-emitting layer and the electron injection section is lowered.
[14] The method according to any one of [5] to [13], in which the refractive index of the light-emitting layer is increased.
[15] The method according to any one of [5] to [14], in which the hole mobility of the light-emitting layer is increased.
[16] The method according to any one of [5] to [15], in which the light-emitting layer is thinned.
[17] The method according to any one of [5] to [16], in which the hole mobility of the layer between the hole injection section and the light-emitting layer is increased.
[18] The method according to any one of [2] to [4], in which the side of the light-emitting layer that is the exciton-dense region is on the hole injection section side, and the electron-blocking layer is arranged between the light-emitting layer and the hole injection section section, adjacent to the light-emitting layer.
[19] The method according to [18], in which the absolute value of the LUMO energy of the electron-blocking layer is smaller by at least 0.1 eV (for example, by at least 0.2 eV, for example, by at least 0.4 eV) than the absolute value of the HOMO energy of the light-emitting layer.
[20] The method according to [18] or [19], in which the electron mobility of the electron-blocking layer is reduced.
[21] The method according to any one of [18] to [20], in which a hole transport layer is arranged between the electron-blocking layer and the hole injection section.
[22] The method according to any one of [18] to [21], in which the hole mobility of the hole transport layer is lowered.

[23] The method according to any one of [18] to [22], in which the absolute value of the LUMO energy of the hole transport layer is smaller by at least 0.1 eV (for example, by at least 0.2 eV) than the absolute value of the LUMO energy of the light-emitting layer.
[24] The method according to any one of [18] to [23], in which the total thickness of the layer between the light-emitting layer and the hole injection section is thickened.
[25] The method according to any one of [18] to [24], in which the total thickness of one or more layers between the light-emitting layer and the hole injection section is at least 2 times (for example, at least 2.5 times, for example, at least 3 times) greater than the total thickness of one or more layers between the light-emitting layer and the electron injection section.
[26] The method according to any one of [18] to [25], in which the refractive index of the layer between the light-emitting layer and the hole injection section is lowered.
[27] The method according to any one of [18] to [26], in which the refractive index of the light-emitting layer is increased.
[28] The method according to any one of [18] to [27], in which the electron mobility of the light-emitting layer is increased.
[29] The method according to any one of [18] to [28], in which the light-emitting layer is thinned.
[30] The method according to any one of [18] to [29], in which the electron mobility of the layer between the electron injection section and the light-emitting layer is increased.
[31] The method according to any one of [1] to [30], in which a full-width half-maximum (FWHM) of an emission angle peak is 10 degrees or less (for example, 7 degrees or less, for example, 5 degrees or less, for example, 4 degrees or less, for example, 3 degrees or less, for example, 2 degrees or less, for example, 1 degree or less).
[32] The method according to any one of [1] to [31], in which the full-width half-maximum (FWHM) of the emission wavelength peak is 10 nm or less (for example, 7 nm or less, for example, 5 nm or less, for example, 4 nm or less, for example, 3 nm or less, for example, 2 nm or less, for example, 1 nm or less).
[33] The method according to any one of [1] to [32], in which the electron injection section has a structure of dielectric, metal and dielectric stacked in sequence (DMD structure).
[34] The method according to any one of [1] to [33], which is an organic electroluminescent device design method.
[35] The method according to any one of [1] to [34], in which the organic electroluminescent device is further provided with an optical resonator that propagates the emitted light inside the light-emitting layer, and the organic electroluminescent device emits laser light.
[36] The method according to [35], in which the optical resonator has a diffraction grating.
[37] The method according to [36], in which the hole-blocking layer or the electron-blocking layer is formed along the flat interface of the light-emitting layer.
[38] The method according to [36] or [37], in which the diffraction grating is positioned between the exciton-dense region and the hole injection section, or between the exciton-dense region and the electron injection section.
[39] The method according to [38], in which

when the device has a diffraction grating between the exciton-dense region and the hole injection section, the hole-blocking layer is positioned between the light-emitting layer and the electron injection section and adjacent to the light-emitting layer, and
when the device has a diffraction grating between the exciton-dense region and the electron injection section, the electron-blocking layer is positioned between the light-emitting layer and the hole injection section and adjacent to the light-emitting layer.

[40] The method according to any one of [35] to [39], which is an organic solid-state semiconductor laser design method.
[41] A device having an organic electroluminescent device fabricated by implementing the method described in any one of [1] to [40], in which the full-width half-maximum (FWHM) of the emission wavelength peak of the emission spectrum is reduced.
[42] A method for fabricating a device having an organic electroluminescent device, including a step of fabricating an organic electroluminescent device by the method described in any one of [1] to [40], in which the full-width half-maximum (FWHM) of the emission wavelength peak of the emission spectrum is reduced.
[43] An organic electroluminescent device fabricated by implementing the method described in any one of [1] to [40], in which the full-width half-maximum (FWHM) of the emission wavelength peak of the emission spectrum is reduced.
[44] An organic solid-state semiconductor laser fabricated by implementing the method described in any one of [35] to [40], in which the full-width half-maximum (FWHM) of the emission wavelength peak of the emission spectrum is reduced.
[45] A method for adjusting at least one of a thickness and a refractive index of a first spacer layer of an organic electroluminescent device, provided with:

a hole injection section of injecting holes,
an electron injection section of injecting electrons,
a light-emitting layer arranged between the hole injection section and the electron injection section to emit light by recombining holes and electrons, and
a first spacer layer arranged between the light-emitting layer and the electron injection section, the method including:
adjusting at least one of the thickness and the refractive index of the first spacer layer using an absorption model.

[46] The method according to [45], in which at least one of the thickness and the refractive index of the first spacer layer of the organic electroluminescent device is adjusted using an absorption model for a stack sample formed by stacking a light-emitting layer, a first spacer layer, and an electron injection section in that order.
[47] The method according to [46], in which the stack sample further has an optical resonator, and at least one of the thickness and the refractive index of the first spacer layer of the organic electroluminescent device is adjusted using an absorption model for the stack sample.
[48] The method according to [46] or [47], in which a relationship between the thickness of the first spacer layer and the absorption coefficient of the stack sample is determined for the stack sample using the absorption model, and in this relationship, the thickness of the first spacer layer of the organic electroluminescent device is selected from the range of the thicknesses of the first spacer layer for which the absorption coefficient is equal to or less than a set reference threshold.
[49] The method according to [46] or [47], in which a relationship between the refractive index of the first spacer layer and the absorption coefficient of the stack sample is determined for the stack sample using the absorption model, and in this relationship, the refractive index of the first spacer layer of the organic electroluminescent device is selected from the range of the refractive index of the first spacer layer for which the absorption coefficient is equal to or less than a set reference threshold.
[50] A method for adjusting at least one of a thickness and a refractive index of a second spacer layer of an organic electroluminescent device provided with:

a hole injection section of injecting holes,
an electron injection section of injecting electrons,
a light-emitting layer arranged between the hole injection section and the electron injection section to emit light by recombining holes and electrons, and
a second spacer layer arranged between the light-emitting layer and the hole injection section, the method including:
adjusting at least one of the thickness and the refractive index of the second spacer layer using an absorption model.

[51] The method according to [50], in which at least one of the thickness and the refractive index of the second spacer layer of the organic electroluminescent device is adjusted using an absorption model for a stack sample formed by stacking a hole injection section, a second spacer layer and a light-emitting layer in that order.
[52] The method according to [51], in which the stack sample further has an optical resonator, and at least one of the thickness and the refractive index of the second spacer layer of the organic electroluminescent device is adjusted using an absorption model for the stack sample.
[53] The method according to [51] or [52], in which a relationship between the thickness of the second spacer layer and the absorption coefficient of the stack sample is determined for the stack sample using the absorption model, and in this relationship, the thickness of the second spacer layer of the organic electroluminescent device is selected from the range of the thicknesses of the second spacer layer for which the absorption coefficient is equal to or less than a set reference threshold.
[54] The method according to [51] or [52], in which a relationship between the refractive index of the second spacer layer and the absorption coefficient of the stack sample is determined for the stack sample using the absorption model, and in this relationship, the refractive index of the second spacer layer of the organic electroluminescent device is selected from the range of the refractive index of the second spacer layer for which the absorption coefficient is equal to or less than a set reference threshold.
[55] An organic electroluminescent device, fabricated by implementing the method described in any one of [45] to [54].
[56] An organic solid-state semiconductor laser, fabricated by implementing the method described in any one of [45] to [54].
[57] An organic solid-state semiconductor laser including:

a hole injection section of injecting holes;

an electron injection section of injecting electrons;
a light-emitting layer arranged between the hole injection section and the electron injection section to emit light by recombining holes and electrons; and
an optical resonator that propagates the emitted light inside the light-emitting layer,
the organic solid-state semiconductor laser comprising
a hole-blocking layer on the electron injection section side of the light-emitting layer so as to be adjacent to the light-emitting layer, or
an electron-blocking layer on the hole injection section side of the light-emitting layer so as to be adjacent to the light-emitting layer.

[58] The organic solid-state semiconductor laser according to any one of [44], [56] or [57], having a hole-blocking layer on the electron injection section side of the light-emitting layer so as to be adjacent to the light-emitting layer.
[59] The organic solid-state semiconductor laser according to [58], in which the absolute value of the highest occupied molecular orbital (HOMO) energy of the hole-blocking layer is greater by at least 0.1 eV than the absolute value of the HOMO energy of the light-emitting layer.
[60] The organic solid-state semiconductor laser according to [58], in which the absolute value of the HOMO energy of the hole-blocking layer is greater by at least 0.2 eV than the absolute value of the HOMO energy of the light-emitting layer.
[61] The organic solid-state semiconductor laser according to [58], in which the absolute value of the HOMO energy of the hole-blocking layer is greater by at least 0.4 eV than the absolute value of the HOMO energy of the light-emitting layer.
[62] The organic solid-state semiconductor laser according to any one of [58] to [61], in which the hole-blocking layer contains a material having a low hole mobility.
[63] The organic solid-state semiconductor laser according to any one of [58] to [61], in which the hole-blocking layer contains a material having a hole mobility equal to or lower than that of TPBi ([1,3,5-tris(1-phenyl-1H-benzimidazol-2-yl)benzene]) (for example, equal to or lower than that of T2T (2,4,6-tris([1,1'-biphenyl]-3-yl)-1,3,5-triazine)).
[64] The organic solid-state semiconductor laser according to any one of [58] to [63], in which the thickness of the hole-blocking layer is 1 nm or more (for example, 3 nm or more, for example, 5 nm or more, for example, 8 nm or more, and, for example, 80 nm or less, for example 30 nm or less, for example 15 nm or less).
[65] The organic solid-state semiconductor laser according to any one of [58] to [64], further having an electron transport layer between the hole-blocking layer and the electron injection section.
[66] The organic solid-state semiconductor laser according to [65], in which the thickness of the electron transport layer is 10 nm or more (for example, 20 nm or more, for example, 40 nm or more, for example, 60 nm or more, and, for example, 100 nm or less, for example 80 nm or less).
[67] The organic solid-state semiconductor laser according to [65] to [66], in which the electron transport layer contains a material having an electron mobility equal to or lower than that of TPBi ([1,3,5-tris(1-phenyl-1H-benzimidazol-2-yl) benzene]).
[68] The organic solid-state semiconductor laser according to any one of [65] to [67], in which the absolute value of the HOMO energy of the electron transport layer is greater by at least 0.1 eV (for example, by at least 0.2 eV) than the absolute value of the HOMO energy of the light-emitting layer.
[69] The organic solid-state semiconductor laser according to any one of [58] to [68], in which the total thickness of one or more layers between the light-emitting layer and the electron injection section is greater by at least 2 times (for example, by at least 2.5 times, for example, by at least 3 times) than the total thickness of one or more layers between the light-emitting layer and the hole injection section.
[70] The organic solid-state semiconductor laser according to any one of [58] to [69], in which the light-emitting layer contains a material having a hole mobility equal to or higher than that of BSBCz (4,4'-bis[(N-carbazole)styryl] biphenyl).
[71] The organic solid-state semiconductor laser according to any one of [58] to [70], in which the light-emitting layer contains a laser oscillation material and a dopant material.
[72] The organic solid-state semiconductor laser according to [71], in which the dopant material contains a light-emitting material.
[73] The organic solid-state semiconductor laser according to [72], in which the light-emitting material is a compound selected from the group consisting of fluorene molecules, styrylbenzene molecules, carbazole-styrylbiphenyl compounds, TADF materials (thermally activated delayed fluorescent materials), star-shaped polymers, polyfluorenes, phenylenevinylene polymers and ladder-shaped polymers.
[74] The organic solid-state semiconductor laser according to any one of [71] to [73], in which the dopant material contains a triplet quencher.
[75] The organic solid-state semiconductor laser according to [74], in which the triplet quencher is a compound

containing an anthracene ring.
[76] The organic solid-state semiconductor laser according to [75], in which the anthracene ring-containing compound is the following compound.

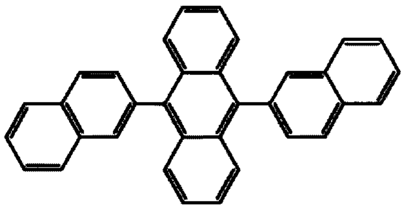

[77] The organic solid-state semiconductor laser according to any one of [58] to [76], having a layer containing a material that has a hole mobility equal to or greater than that of HATCN ([dipyrazino[2,3-f:2',3'-h]quinoxaline-2,3,6,7,10,11-hexacarbonitrile]) between the hole injection section and the light-emitting layer.
[78] The organic solid-state semiconductor laser according to any one of [44], [56] or [57], having an electron-blocking layer on the hole injection section side of the light-emitting layer so as to be adjacent to the light-emitting layer.
[79] The organic solid-state semiconductor laser according to [78], in which the absolute value of the lowest unoccupied molecular orbital (LUMO) energy of the electron-blocking layer is smaller by at least 0.1 eV than the absolute value of the LUMO energy of the light-emitting layer.
[80] The organic solid-state semiconductor laser according to [78], in which the absolute value of the LUMO energy of the electron-blocking layer is smaller by at least 0.2 eV than the absolute value of the LUMO energy of the light-emitting layer.
[81] The organic solid-state semiconductor laser according to [78], in which the absolute value of the LUMO energy of the electron-blocking layer is smaller by at least 0.4 eV than the absolute value of the LUMO energy of the light-emitting layer.
[82] The organic solid-state semiconductor laser according to any one of [78] to [81], in which the electron transport layer contains a material having a small electron mobility.
[83] The organic solid-state semiconductor laser according to any one of [78] to [82], in which the electron-blocking layer contains a material having a small electron mobility.
[84] The organic solid-state semiconductor laser according to any one of [78] to [83], in which the thickness of the electron-blocking layer is 1 nm or more (for example, 3 nm or more, for example, 5 nm or more, for example 8 nm or more, and for example, 80 nm or less, for example, 30 nm or less, for example 15 nm or less).
[85] The organic solid-state semiconductor laser according to any one of [78] to [84], further having a hole transport layer between the electron-blocking layer and the hole injection section.
[86] The organic solid-state semiconductor laser according to [85], in which the thickness of the hole transport layer is 10 nm or more (for example, 20 nm or more, for example, 40 nm or more, for example, 60 nm or more, and, for example, 100 nm or less, for example, 80 nm or less).
[87] The organic solid-state semiconductor laser according to[85] or [86], in which the hole transport layer contains a material that has a hole mobility equal to or smaller than that of HATCN ([dipyrazino[2,3-f:2',3'-h]quinoxaline-2,3,6,7,10,11-hexacarbonitrile]).
[88] The organic solid-state semiconductor laser according to any one of [85] to [87], in which the absolute value of the LUMO energy of the hole transport layer is smaller by at least 0.1 eV (for example, by at least 0.2 eV) than the absolute value of the LUMO energy of the light-emitting layer.
[89] The organic solid-state semiconductor laser according to any one of [78] to [88], in which the total thickness of one or more layers between the light-emitting layer and the hole injection section is greater by at least 2 times (for example, by at least 2.5 times, for example, by at least 3 times) than the total thickness of one or more layers between the light-emitting layer and the electron injection section.
[90] The organic solid-state semiconductor laser according to any one of [56] to [89], in which the refractive index of the layer between the light-emitting layer and the electron injection section is smaller than the refractive index of the light-emitting layer.
[91] The organic solid-state semiconductor laser according to any one of [56] to [90], in which the refractive index of the layer between the light-emitting layer and the hole injection section is smaller than the refractive index of the light-emitting layer.
[92] The organic solid-state semiconductor laser according to any one of [44], or [56] to [91], in which the thickness of the light-emitting layer is 10 nm or more and less than 200 nm.
[93] The organic solid-state semiconductor laser according to any one of [44], or [56] to [92], in which the hole mobility of the light-emitting layer is greater by at least 10 times than the electron mobility thereof.

[94] The organic solid-state semiconductor laser according to any one of [44], or [56] to [93], in which the light-emitting layer consists of a light-emitting material.

[95] The organic solid-state semiconductor laser according to any one of [44], or [56] to [94], in which the light-emitting layer is a layer of a host material doped with a light-emitting material.

[96] The organic solid-state semiconductor laser according to any one of [44], or [56] to [95], in which the hole injection section is an electrode.

[97] The organic solid-state semiconductor laser according to any one of [44], or [56] to [96], in which at least one of the electron injection section and the hole injection section is an electrode having a visible light transmittance of 10% or more (for example, 50% or more, for example, 80% or more, for example, 90% or more).

[98] The organic solid-state semiconductor laser according to any one of [43], or [53] to [94], in which the hole injection section contains ITO (indium tin oxide).

[99] The organic solid-state semiconductor laser according to any one of [44], or [56] to [98], in which the electron injection section is an electrode.

[100] The organic solid-state semiconductor laser according to any one of [44], or [56] to [99], in which the electron injection section is a metal electrode.

[101] The organic solid-state semiconductor laser according to any one of [44], or [56] to [100], in which the electron injection section has a structure of dielectric, metal and dielectric stacked in sequence.

[102] The organic solid-state semiconductor laser according to [101], in which the metal is silver (Ag).

[103] The organic solid-state semiconductor laser according to [101] or [102], in which the dielectric is molybdenum trioxide ($MoO_3$).

[104] The organic solid-state semiconductor laser according to any one of [56] to [103], which is a surface emission type.

[105] The organic solid-state semiconductor laser according to any one of [56] to [100], in which the light generated in the light-emitting layer propagates in the lateral direction of the light-emitting layer.

[106] The organic solid-state semiconductor laser according to [105], in which the device is provided with a low refractive index layer with a lower refractive index than the light-emitting layer between the light-emitting layer and the hole injection section, and between the light-emitting layer and the electron injection section.

[107] The organic solid-state semiconductor laser according to any one of [57] to [106], in which the optical resonator has a diffraction grating.

[108] The organic solid-state semiconductor laser according to [107], in which the hole-blocking layer or the electron-blocking layer is formed along the flat interface of the light-emitting layer.

[109] The organic solid-state semiconductor laser according to [107] or [108], in which the base edge of the diffraction grating is located at an interface on the hole injection section side of the light-emitting layer or is located on the hole injection section side than the interface, and the hole-blocking layer is located between the light-emitting layer and the electron injection section and adjacent to the light-emitting layer.

[110] The organic solid-state semiconductor laser according to [107] or [108], in which the base edge of the diffraction grating is located at an interface on the electron injection section side of the light-emitting layer or is located on the electron injection section side than the interface, and the electron-blocking layer is located between the light-emitting layer and the hole injection section and adjacent to the light-emitting layer.

[111] The organic solid-state semiconductor laser according to any one of [56] to [104], or [107] to [110], which is a top emission type.

[112] The organic solid-state semiconductor laser according to any one of [56] to [104], or [107] to [111], which is a bottom emission type.

[113] The organic solid-state semiconductor laser according to any one of [56] to [104], or [107] to [112], which is a dual emission type.

[114] The organic solid-state semiconductor laser according to any one of [56] to [110], which is an edge emission type.

[115] A program for implementing the method described in any one of [1] to [40] and [45] to [54].

The above "DMD structure" is an abbreviation for a dielectric-metal-dielectric structure. The structure can be employed in the invention as an electrode that utilizes the interference of the stack structure. In addition to $MoO_3$/Ag/$MoO_3$ used in Examples herein, ITO/Ag/ITO, ZnS/Ag/ZnS, ZnO/Ag/ZnO, InZnSnO/Ag/InZnSnO, ITO/Ag/$WO_3$, ZnO/Ag/$WO_3$, and $WO_3$/Ag/$WO_3$ can also be used as DMD structures. In one aspect of the invention, the DMD structure is used as the electron injection section. Devices with a DMD structure can be manufactured, for example, through a process of forming a DMD structure on a silicon substrate.

By constructing the electron injection section with a material having a high light transmittance, top-emission organic electroluminescent devices and organic solid-state semiconductor lasers can be provided. In one aspect of the invention, the electron injection section is a DMD structure having a high light transmittance or a thin Ag layer (for example, having a thickness of 40 nm or less, for example, 5 to 30 nm, for example 12 to 25 nm). By constructing the hole injection

section with a material having a high light transmittance, bottom-emission organic electroluminescent devices and organic solid-state semiconductor lasers can be provided. In one aspect of the invention, the hole injection section is an ITO layer. By using materials with a high light transmittance for both the electron injection section and the hole injection section, dual-emission (see-through) organic electroluminescent devices and organic solid-state semiconductor lasers can also be provided.

Advantageous Effects of Invention

The invention can realize an organic solid-state semiconductor laser and an organic electroluminescent device of which the peak width of the emission spectrum is reduced.

Brief Description of Drawings

[Fig. 1] This shows a structural example of the first embodiment of the organic solid-state semiconductor laser of the invention, in which (a) is a schematic cross-sectional view showing the state before current injection and (b) is a schematic cross-sectional view showing the behavior of holes and electrons during current injection.
[Fig. 2] This is a schematic cross-sectional view of a structural example of the second embodiment of the organic solid-state semiconductor laser of the invention.
[Fig. 3] This shows a specific example of a stack sample used in the first method of the invention, in which (a) is a schematic cross-sectional view of the stack sample, (b) is an electric field intensity distribution of a resonance mode of the stack sample, and (c) is a partially enlarged graph of (b).
[Fig. 4] This is a graph that shows the dependence on the first spacer layer thickness of the absorption coefficient $\alpha$ from an absorption model and the measured ASE threshold for the stack sample shown in Fig. 3(a).
[Fig. 5] This shows a specific example of a stack sample used in the second method of the invention, in which (a) is a schematic cross-sectional view of the stack sample, (b) is an electric field intensity distribution of a resonance mode of the stack sample, and (c) is a partially enlarged graph of (b).
[Fig. 6] This is a graph that shows the dependence on the second spacer layer thickness of the absorption coefficient $\alpha$ from an absorption model and the measured ASE threshold for the stack sample shown in Fig. 5(a).
[Fig. 7] This is an energy level diagram of the organic solid-state semiconductor laser (laser device 1) fabricated in Example 1.
[Fig. 8] This is a graph that shows the calculated exciton density distribution of the organic solid-state semiconductor lasers (laser devices 2 and 3, and comparative laser device 1) fabricated in Examples 2 and 3 and Comparative Example 1.
[Fig. 9] This shows a photonic band diagram, an angular light intensity distribution, and an emission spectrum of the organic solid-state semiconductor laser (laser device 1) fabricated in Example 1, (a) was obtained by measurement with a DC voltage of 5 V applied and (b) was obtained by measurement with a DC voltage of 10 V applied.
[Fig. 10] This shows a photonic band diagram, an angular light intensity distribution, and an emission spectrum of the organic solid-state semiconductor laser (laser device 2) fabricated in Example 2.
[Fig. 11] This shows a photonic band diagram, an angular light intensity distribution, and an emission spectrum of the organic solid-state semiconductor laser (laser device 3) fabricated in Example 3.
[Fig. 12] This shows a photonic band diagram, an angular light intensity distribution, and an emission spectrum of the organic solid-state semiconductor laser (laser device 4) fabricated in Example 4.
[Fig. 13] This shows a photonic band diagram, an angular light intensity distribution, and an emission spectrum of the organic solid-state semiconductor laser (comparative laser device 1) fabricated in Comparative Example 1.
[Fig. 14] This shows a photonic band diagram, an angular light intensity distribution, and an emission spectrum of the organic solid-state semiconductor laser (laser device 5) fabricated in Example 5.
[Fig. 15] This shows a photonic band diagram, an angular light intensity distribution, and an emission spectrum of the organic solid-state semiconductor laser (laser device 6) fabricated in Example 6.
[Fig. 16] This shows a photonic band diagram, an angular light intensity distribution, and an emission spectrum of the organic solid-state semiconductor laser (laser device 7) fabricated in Example 7.
[Fig. 17] This shows a photonic band diagram, an angular light intensity distribution, and an emission spectrum of the organic solid-state semiconductor laser (laser device 8) fabricated in Example 8.
[Fig. 18] This shows a photonic band diagram, an angular light intensity distribution, and an emission spectrum of the organic solid-state semiconductor laser (laser device 9) fabricated in Example 9, (a) was obtained by measurement from the substrate side and (b) was obtained by measurement from the cathode side.
[Fig. 19] This is a schematic cross-sectional view of one example of an organic solid-state semiconductor laser of the

related art.

[Fig. 20] This shows a comparison of an organic solid-state semiconductor laser of the related art and an organic solid-state semiconductor laser of the first embodiment, in which (a) is a schematic cross-sectional view of one example of the organic solid-state semiconductor laser of the related art, (b) is a schematic cross-sectional view of the behavior of holes and electrons in the organic solid-state semiconductor laser shown in (a), (c) is a schematic cross-sectional view of one aspect of the organic solid-state semiconductor laser of the first embodiment, and (d) is a schematic cross-sectional view of the behavior of holes and electrons in the organic solid-state semiconductor laser shown in (c).

Detailed Description

The contents of the invention will be described in detail below. The constitutional elements may be described below with reference to representative embodiments and specific examples of the present invention, but the invention is not limited to the embodiments and the specific examples. In the description herein, a numerical range expressed as "to" means a range that includes the numerical values described before and after "to" as the lower limit and the upper limit. The hydrogen atom that is present in the molecule of the compound used in the invention is not particularly limited in isotope species, and for example, all the hydrogen atoms in the molecule can be $^1H$, and all or a part of them can be $^2H$ (deuterium D). In the invention, "transparent" means that the transmittance of visible light is 50% or more, for example, 80% or more, for example, 90% or more, for example, 99% or more. The visible light transmittance can be measured with a UV/visible light spectrophotometer.

<Organic Solid-state Semiconductor Laser>

The organic solid-state semiconductor laser of the invention is provided with a hole injection section of injecting holes, an electron injection section of injecting electrons, a light-emitting layer of emitting light by recombining holes and electrons, and an optical resonator that propagates the emitted light inside the light-emitting layer,

the organic solid-state semiconductor laser comprising
a hole-blocking layer on the electron injection section side of the light-emitting layer so as to be adjacent to the light-emitting layer, or
an electron-blocking layer on the hole injection section side of the light-emitting layer so as to be adjacent to the light-emitting layer.

In the following description, an aspect of the organic solid-state semiconductor laser of the invention having a hole-blocking layer on the electron injection section side of the light-emitting layer so as to be adjacent to the light-emitting layer is referred to as "the first embodiment", and an aspect having an electron-blocking layer on the hole injection section side of the light-emitting layer so as to be adjacent to the light-emitting layer is referred to as "the second embodiment".

In the following, configurations of the first embodiment and the second embodiment of the invention are described.

[First Embodiment]

The organic solid-state semiconductor laser of the first embodiment has at least a hole injection section, a light-emitting layer, a hole-blocking layer, and an electron injection section stacked in that order, and has an optical resonator that propagates the emitted light inside the light-emitting layer. The organic solid-state semiconductor laser of the first embodiment can further have a spacer layer between the hole-blocking layer and the electron injection section, and can have one or more layers between the light-emitting layer and the hole injection section. Here, the light-emitting layer, the hole-blocking layer, the spacer layer, and one or more layers arranged between the light-emitting layer and the hole injection section can be organic layers. In the present description, the "organic layer" means a layer that contains an organic compound in an amount of 70% by weight or more, and the "organic compound" means a compound containing one or more carbon atoms. As the organic compound, employable herein are, for example, those consisting of atoms selected from the group consisting of a carbon atom, a hydrogen atom, an oxygen atom, a nitrogen atom, a boron atom and a halogen atom.

Fig. 1(a) shows a specific structural example of the first embodiment. In Fig. 1(a), 11 represents a hole injection section, 12 represents a hole injection layer, 13 represents a hole transport layer, 14 represents a light-emitting layer, 15 represents a hole-blocking layer, 16 represents an electron transport layer, 17 represents an electron injection section, and 18 represents a diffraction grating to constitute an optical resonator. Here, the electron transport layer 16 constitutes the spacer layer, and the hole injection layer 12 and the hole transport layer 13 correspond to the "one or more layers arranged between the light-emitting layer and the hole injection section" described above.

The organic solid-state semiconductor laser of the first embodiment has the hole-blocking layer 15 adjacent to the light-emitting layer 14 to achieve high laser efficiency and laser radiation with a small peak width of both the emission spectrum and the angular light intensity distribution. Furthermore, if necessary, a spacer layer 16 can be arranged between the hole-blocking layer 15 and the electron injection section 17 to further improve the laser efficiency. In the following, the reason for this is explained with reference to Fig. 20. In Fig. 20, (a) is a schematic cross-sectional view of an organic solid-state semiconductor laser of the related art having neither a hole-blocking layer nor a spacer layer, (b) is a schematic cross-sectional view of the behavior of carriers in the organic solid-state semiconductor laser shown in (a), (c) is a schematic cross-sectional view of one aspect of the organic solid-state semiconductor laser of the first embodiment, and (d) is a schematic cross-sectional view of the behavior of carriers in the organic solid-state semiconductor laser shown in (c).

The organic solid-state semiconductor laser of the related art shown in Fig. 20(a) has a light-emitting layer 202 of about 200 nm thickness formed with a laser oscillation material and a diffraction grating 204 between an electron injection section 201 and a hole injection section 203, having a homojunction structure that injects carriers into the single organic semiconductor layer (light-emitting layer 202) from the electron injection section 201 and the hole injection section 203. As shown in Fig. 20(b), in such an organic solid-state semiconductor laser with a homojunction structure, when carriers (holes(+) and electrons(-)) are injected from each of the injection sections 201 and 203 into the light-emitting layer 202, the entire light-emitting layer 202 becomes a carrier recombination region $RZ_L$ with a low exciton density. In addition, the fact that the light-emitting layer 202 is adjacent to the hole injection section 203 makes it easy for the light generated in the light-emitting layer 202 to form surface plasmon polaritons at the metal electrode of the hole injection section 203 and to be subject to optical absorption and scattering by the electrode, which also causes optical losses that impair laser efficiency.

In contrast, the organic solid-state semiconductor laser of the first embodiment shown in Fig. 20(c) has a heterojunction structure with at least the light-emitting layer 14 and the hole-blocking layer 15 (two or more organic semiconductor layers) between the hole injection section 11 and the electron injection section 17. Therefore, as shown in Fig. 20(d), when carriers are injected from injection sections 11 and 17, the holes(+) injected into the light-emitting layer 14 are transported toward the hole-blocking layer 15 side in the light-emitting layer 14, but an interface 15s between the light-emitting layer 14/hole-blocking layer 15 acts as a barrier and prevents the holes from moving toward the electron injection section 17 side from the interface 15s. Consequently, holes(+) stay near the interface 15s, and carrier recombination occurs intensively between the staying holes and the electrons(-) having moved from the hole-blocking layer 15 into the light-emitting layer 14, therefore forming an exciton-dense carrier recombination region $RZ_H$ near the interface 15s. As a result, induced emission light is efficiently generated in this region $RZ_H$, and laser radiation with a small peak width of both the emission spectrum and the angular light intensity distribution can be realized. Furthermore, when the spacer layer 16 is arranged between the hole-blocking layer 15 and the electron injection section 17, a space is created between the carrier recombination region $RZ_H$ and the electron injection section 17, so that the loss of the light generated in the carrier recombination region $RZ_H$ by forming surface plasmon polaritons on the electrode surface, and the light loss due to absorption and scattering at the electrode can be suppressed.

Thus, in the organic solid-state semiconductor laser of the invention, the recombination region corresponding to the gain region is concentrated in a limited area in the light-emitting layer, and furthermore, a spacer layer is arranged as necessary or otherwise to keep a distance from the electrode that causes the loss, thereby maintaining the gain higher than the loss and achieving stable laser oscillation. Because of these features, the organic solid-state semiconductor laser of the invention can further improve laser efficiency and monochromaticity, and also contributes to the realization of low-voltage drive.

In the following, the constituent members and layers of the organic solid-state semiconductor laser of the first embodiment are described.

(Substrate)

The organic solid-state semiconductor laser of the invention can be in a form in which respective members and layers are supported by a substrate. Regarding the substrate, in the case where the organic solid-state semiconductor laser is configured to extract laser light from the substrate side, a substrate with transparency to the laser light is used, and for example, a transparent substrate made of glass, transparent plastic, quartz or the like can be used. On the other hand, in the case where the organic solid-state semiconductor laser is configured to extract laser light from the opposite side of the substrate, the substrate is not particularly restricted, and in addition to the transparent substrates described above, other substrates made of silicon, paper or fabric can also be used. The organic solid-state semiconductor laser of the first embodiment can include a hole injection section, a light-emitting layer, a hole-blocking layer and an electron injection section stacked in that order on a substrate, or can include an electron injection section, a hole-blocking layer, a light-emitting layer and a hole injection section stacked in that order on a substrate.

(Hole injection Section)

The hole injection section has a function of injecting holes. For example, in the case where the light-emitting layer is arranged adjacent to the hole injection section, holes are injected directly from the hole injection section into the light-emitting layer. In the case where the device has one or more layers between the light-emitting layer and the hole injection section, holes are injected from the hole injection section into the layer adjacent to the hole injection section among the one or more layers, and the holes transported through the one or more layers are injected into the light-emitting layer.
In one aspect of the invention, the hole injection section of the first embodiment is an electrode, and is, for example, a transparent electrode. As to the electrode that is the hole injection section (hereinafter referred to as "anode"), for example, metals, alloys or electrically conductive compounds with a large work function (4 eV or higher) and mixtures of these materials can be used as electrode materials. Examples of such electrode materials include metals such as Au, and conductive transparent materials such as CuI, indium tin oxide (ITO), $SnO_2$, ZnO, and TiN. Materials such as IDIXO ($In_2O_3$-ZnO), which are amorphous materials that can form transparent conductive films, can also be used. The anode can be formed as a film by vapor deposition or sputtering with these electrode materials. A pattern of a desired shape can be formed on the formed thin film by photolithography as an anode, or in the case where pattern precision is not so necessary (about 100 μm or more), the pattern can be formed through a mask of a desired shape during vapor deposition or sputtering with the above electrode material. Otherwise, in the case where a coatable material such as an organic electroconductive compound is used, also employable is a wet film-forming method such as a printing method or a coating method.
However, in the case where the organic solid-state semiconductor laser has a configuration in which the laser light is extracted through the anode, the anode needs to be transparent. Specifically, to constitute a transparent anode, for example, the above conductive transparent material can be used for the anode, or a thin film of a metal or alloy with a thickness of 5 to 100 nm can be used for the anode, or an electrode with the DMD structure described below can be used for the anode. The thickness of the thin film of a metal or alloy is, for example, 40 nm or less, for example 5 to 30 nm, for example 12 to 25 nm.
The sheet resistance as an anode is, for example, several hundred Ω/sq or less. Furthermore, the film thickness depends on the material, but is usually selected in the range of 10 to 1000 nm, for example, 10 to 200 nm.

(Electron injection section)

The electron injection section a function of injecting electrons. For example, in the case where a hole-blocking layer is arranged adjacent to the electron injection section, electrons are injected into the hole-blocking layer from the electron injection section, and the electrons transported in the hole-blocking layer are injected into the light-emitting layer. In the case where a spacer layer is arranged between the hole-blocking layer and the electron injection section so as to be adjacent to the electron injection section, electrons are injected from the electron injection section into the spacer layer, and the electrons transported in the spacer layer and the hole-blocking layer are injected into the light-emitting layer.
In one aspect of the invention, the electron injection section of the first embodiment is an electrode, and is, for example, a metal electrode. The material of the metal electrode can be a simple metal element, a mixture of two or more simple metal elements, an alloy formed by fusing two or more simple metal elements, a mixture of a simple metal element and an alloy, or a mixture formed by mixing two or more alloys. For the electrode as the electron injection section (hereinafter referred to as "cathode"), a metal (referred to as an electron-injecting metal) or alloy with a smaller work function than the electrode material used for the anode can be used. An electrically conductive compound and a mixture thereof can also be used as the electrode material for the cathode. Specific examples of such cathode materials include sodium, sodium-potassium alloys, magnesium, lithium, magnesium/copper mixtures, magnesium/silver mixtures, magnesium/aluminum mixtures, magnesium/indium mixtures, aluminum/aluminum oxide ($Al_2O_3$) mixtures, indium, lithium/aluminum mixtures, and rare earth metals. Among these, mixtures of an electron-injecting metal and a second metal, which is a more stable metal with a larger work function value, can be used in point of electron injection capability and durability against oxidation, and for example, magnesium/silver mixtures, magnesium/aluminum mixtures, magnesium/indium mixtures, aluminum/aluminum oxide ($Al_2O_3$) mixtures, lithium/aluminum mixtures, and aluminum can be used. A coated metal film with a coating of lithium fluoride or the like on the surface of a thin film formed of an electron-injecting metal can also be used as the cathode. The cathode can be formed by vapor deposition or sputtering with these electrode materials.
However, in the case where the laser device has a configuration in which the laser light is extracted through the cathode, the cathode needs to be transparent. Specifically, for constituting the transparent cathode, a thin film of the above electrode material with a thickness of 5 to 100 nm (for example, 40 nm or less, for example, 5 to 30 nm, for example, 12 to 25 nm) can be used for the cathode, or a stack structure of a thin film of the conductive transparent material exemplified as the anode material with the above coated metal film (for example, a stack structure of ITO/Al/LiF) can be used for the cathode, or an electrode with the DMD structure described below can be used for the cathode.
The sheet resistance as the cathode is, for example, several hundred Ω/sq or less, and the film thickness is usually selected in the range of 10 nm to 5 μm, for example, 50 to 200 nm.

In one aspect of the invention, at least one of the electron injection section and the hole injection section is an electrode with a transmittance of visible light of 10% or more. Here, the visible light transmittance of the electrode is, for example, 50% or more, for example, 80% or more, for example, 90% or more.

(Light-Emitting Layer)

The light-emitting layer is a layer in which the recombination of holes and electrons injected from the hole injection section and the electron injection section, respectively, results in the formation of excitons to form an inverted distribution and induced emission. The light-emitting layer contains a laser oscillation material (optical gain medium) that can produce such induced emission.

The light-emitting layer can consist solely of a laser oscillation material, or it can be a layer formed of a host material doped with a laser oscillation material. The light-emitting layer can also contain a laser oscillation material and a dopant material. The dopant material can include light-emitting materials and triplet quenchers. By doping the light-emitting layer with a light-emitting material, the wavelength and the color of the light emitted by the light-emitting layer can be controlled. In addition, by doping the light-emitting layer with a triplet quencher, accumulation of triplet excitons in the light-emitting layer is suppressed, and generation of higher-order excited states due to collision between triplet excitons and also degradation of excited molecules caused by these higher-order excited states can be suppressed. As a result, light emission efficiency can be improved. In one aspect of the invention, the light-emitting layer is a layer consisting of a laser oscillation material. In one aspect of the invention, the light-emitting layer is a layer in which a laser oscillation material is doped into a host material. In one aspect of the invention, the light-emitting layer is a layer containing a mixture of a laser oscillation material and a dopant material. In one aspect of the invention, the light-emitting layer is a layer that contains a host material doped with a laser oscillation material and a dopant material. In one aspect of the invention, the dopant material is an organic compound. In one aspect of the invention, the dopant material contains a light-emitting material. In one aspect of the invention, the dopant material contains a triplet quencher. In one aspect of the invention, the dopant material contains a light-emitting material and a triplet quencher.

The laser oscillation material can be selected from organic compounds having at least one stilbene unit. Here, the stilbene unit has the following structure, in which at least one hydrogen atom can be substituted with a substituent.

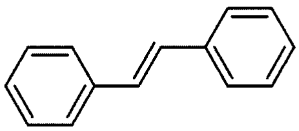

Stilbene unit

In one aspect of the invention, the laser oscillation material is selected from organic compounds with two or more stilbene units. In two or more stilbene units, the phenyl groups of adjacent stilbene units can be linked to each other at the 4'- and 4'-positions with a single bond, or at the 4'- and 4'- positions with a single bond and at the 3'- and 3'- positions via a methylene group to form a fluorene ring. Here, at least one hydrogen atom of the benzene ring constituting the stilbene unit can be substituted with a substituent (for example, an alkyl group with 1 to 10 carbon atoms or an aryl group with 6 to 15 carbon atoms). The hydrogen atom at the 9-position (methylene group) of the fluorene ring can be substituted with two alkyl groups (for example, having 1 to 10 carbon atoms, for example, 6 carbon atoms), and a hydrocarbon ring such as a fluorene ring can be spiro-bonded to the 9-position.

In the following, specific examples of laser oscillation materials that can be used in the present invention are listed. However, laser oscillation materials that can be used in the invention should not be construed as being limited by these specific examples.

First, 4,4'-bis[(N-carbazole)styryl]biphenyl (BSBCz), represented by the following formula, can be cited as a specific example of a laser oscillation material having a stilbene unit. In one aspect of the invention, the light-emitting layer contains BSBCz. In one aspect of the invention, the light-emitting layer is a layer consisting of BSBCz. In one aspect of the invention, the light-emitting layer is a layer in which BSBCz is doped into a host material. The layer of BSBCz doped into a host material can further contain a dopant material.

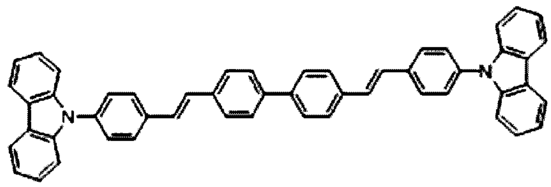

As examples of laser oscillation materials with a stilbene unit, the following compounds and polymers having the following repeating structures can also be mentioned. In the following formulae, $R_1$ and $R_2$ each represent an alkyl group with 1 to 10 carbon atoms, for example, a hexyl group. n and m each independently represent an integer of 2 to 20. n and m can be the same as or different from each other.

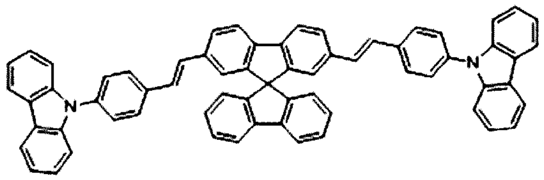

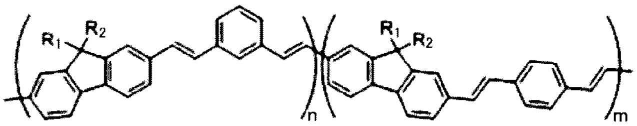

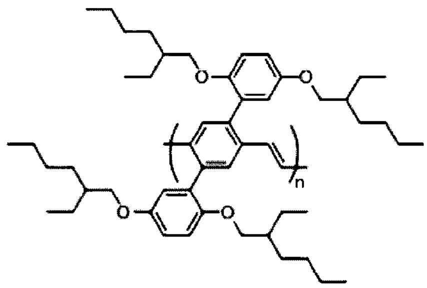

The laser oscillation material can be selected from organic compounds having at least one fluorene ring. As examples of laser oscillation materials with a fluorene ring, the following compounds and polymers having the following repeating structures can also be mentioned. In the following formulae, R represents an alkyl group with 1 to 10 carbon atoms, for example, a hexyl group. Me represents a methyl group, hexyl represents a hexyl group, and Oct represents an octyl group. n represents an integer of 2 to 30, for example, an integer of 2, 3, 4, 5, or 6. For the compounds with both a stilbene unit and a fluorene ring, specific examples of laser oscillation materials with a stilbene unit are shown in the above.

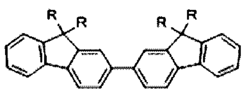

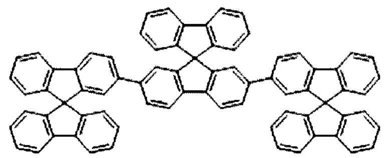

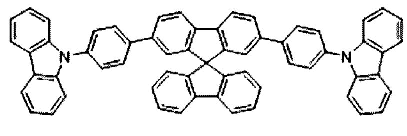

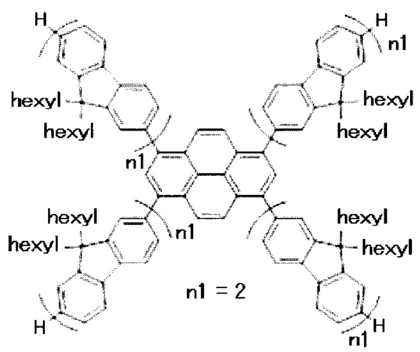

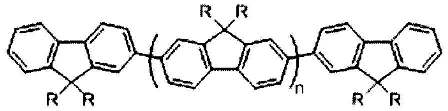

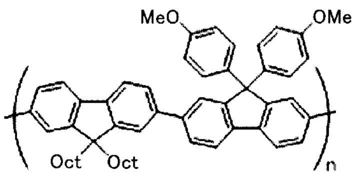

Also, the laser oscillation material can be selected from organic compounds having at least one following fused polycyclic structure (julolidine ring).

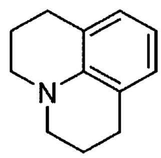

Julolidine ring

The following compounds are examples of laser oscillation materials with a julolidine ring.

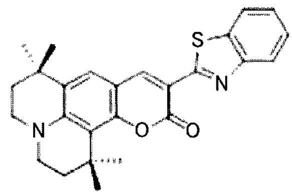

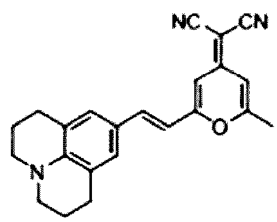

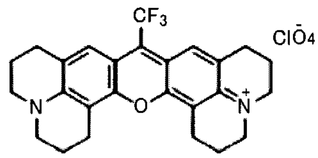

By employing, for example, others than the polymers (polymerized products of monomers) among the above-mentioned laser oscillation materials, the light-emitting layer can be easily formed using a vapor deposition method.

As the light-emitting material to be used as a dopant material, for example, light-emitting organic compounds can be employed, which can be any of fluorescent materials, delayed fluorescent materials, or phosphorescent materials. In this specification, "fluorescent material" is a light-emitting material whose emission intensity of fluorescence is higher than that of phosphorescence when observed at 20 °C, and "phosphorescent material" is a light-emitting material whose emission intensity of phosphorescence is higher than that of fluorescence when observed at 20 °C. "Delayed fluorescent material" is a material from which both fluorescence with a short emission lifetime and fluorescence with a long emission lifetime (delayed fluorescence) are observed at 20 °C. Fluorescence and phosphorescence can be distinguished by emission lifetime, since normal fluorescence (fluorescence that is not delayed fluorescence) has an emission lifetime on the order of ns and phosphorescence usually has an emission lifetime on the order of ms. Light-emitting organic compounds other than organometallic complexes are usually fluorescent materials or delayed fluorescent materials.

The light-emitting material used as a dopant material can be an organic compound known as an optical gain medium. However, the compound used as the light-emitting material shall be different from the compound used as the laser oscillation material in the organic solid-state semiconductor laser concerned. The configuration and driving conditions of the optical resonator of the organic solid-state semiconductor laser used in the invention are designed based on the conditions of the organic compound selected as the laser oscillation material (for example, emission wavelength and oscillation threshold) so that the organic compound can undergo laser oscillation.

The emission wavelength and the emission color of the light-emitting material are appropriately selected according to the emission wavelength of the laser oscillation material and the desired emission wavelength and color. For example, the emission wavelength of the light-emitting material can be selected from the visible region or from the infrared or ultraviolet regions.

For specific examples of the light-emitting material, reference can be made to the compound examples of fluorene molecules, styrylbenzene molecules, carbazole-styrylbiphenyl compounds, TADF materials (thermally activated delayed fluorescent materials), as well as compounds exemplified as star-shaped polymers, polyfluorenes, phenylene vinylene polymers and ladder-type polymers, as described in Adv. Photonics Res. 2021, 2, 2000155, and also to the examples of light-emitting molecules described in CCS Chem. 2020, 2, 1203-1216. Here, "star-shaped polymer" means a polymer with three or more branching chains extending radially from the common center (for example, benzene core, pyrene core, or truxene core), and "ladder-shaped polymer" means a polymer in which monomer units are linked by two or more bonds. Representative examples of the compounds among these are listed below. n represents an integer from 2 to 20 unless, otherwise stated.

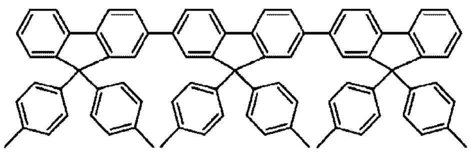

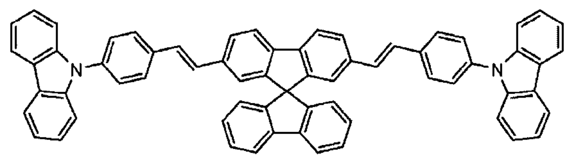

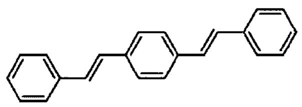

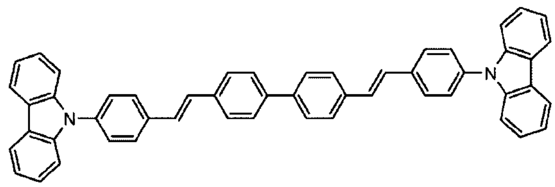

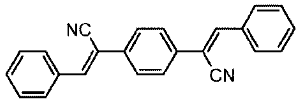

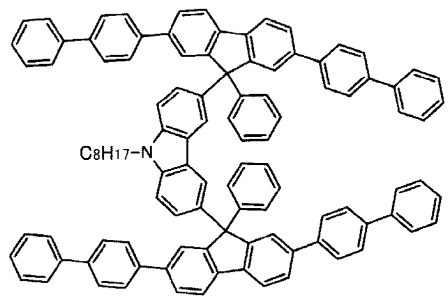

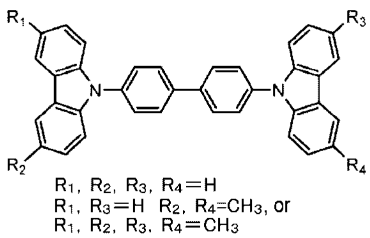

$R_1$, $R_2$, $R_3$, $R_4$=H
$R_1$, $R_3$=H $R_2$, $R_4$=$CH_3$, or
$R_1$, $R_2$, $R_3$, $R_4$=$CH_3$

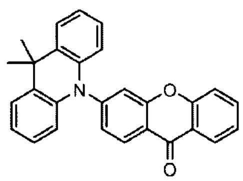

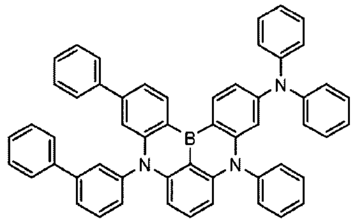

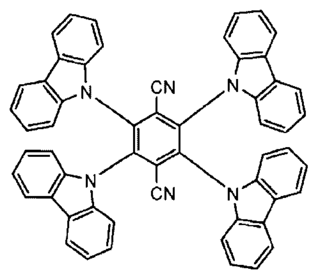

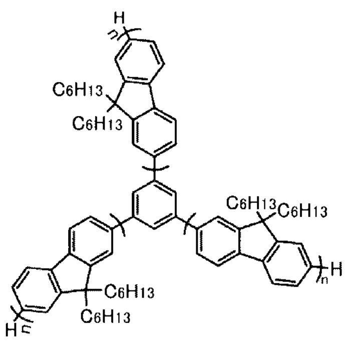

n is 1, 2, 3, or 4

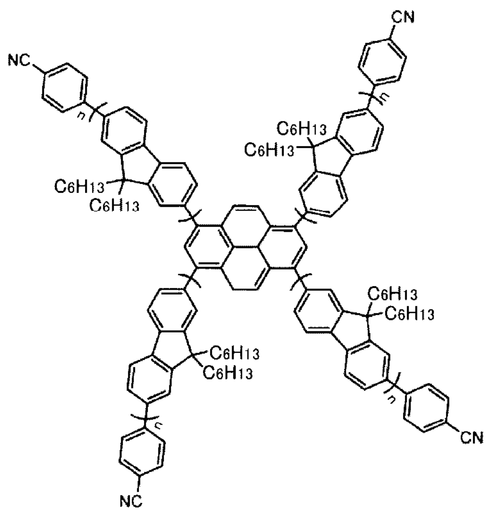

n is 1, 2, or 3

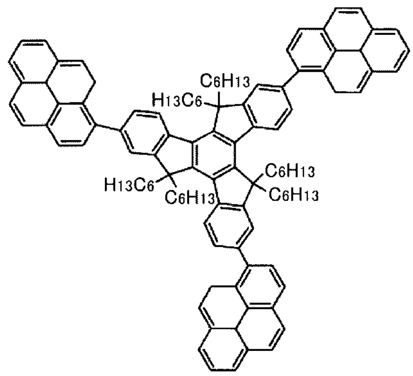

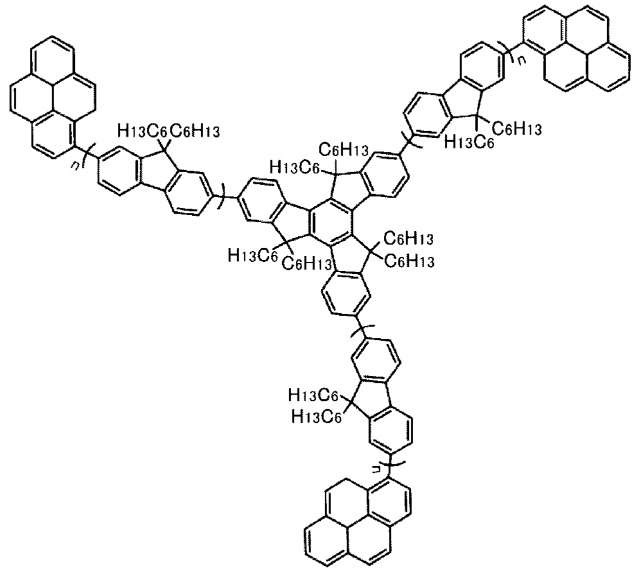

n is 1 or 2

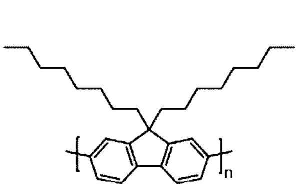

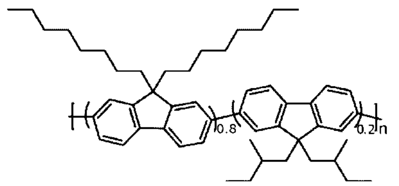

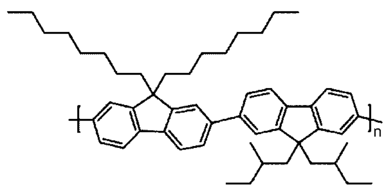

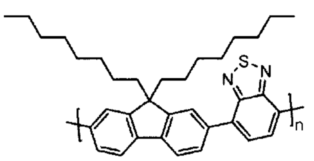

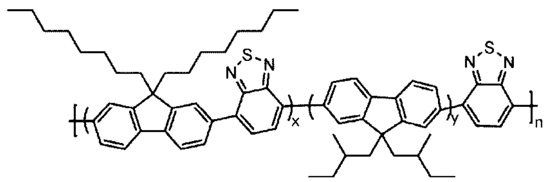

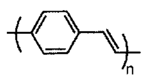

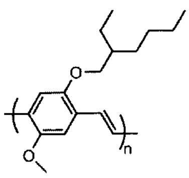

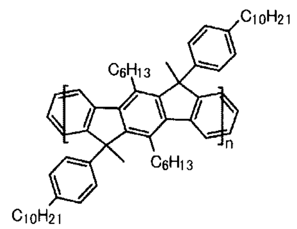

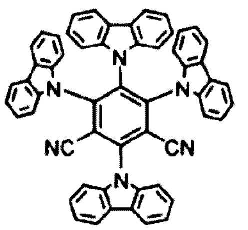

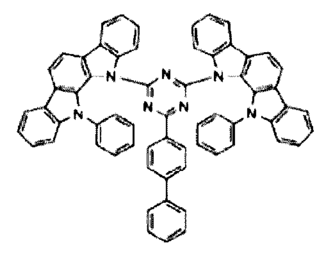

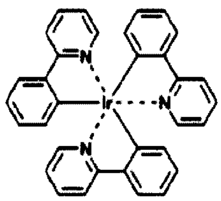

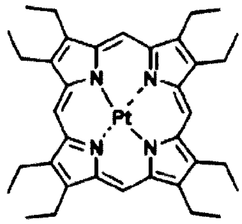

One of these light-emitting materials can be used alone or two or more thereof can be used in combination.

As the triplet quencher, herein employable are compounds having a lowest excited triplet energy lower than that of the laser oscillation material, for example, compounds having a lowest excited triplet energy lower than that of the laser oscillation material and having a lowest excited singlet energy higher than that of the laser oscillation material. The triplet quencher can be selected, for example, from organic compounds with an anthracene ring. Specific examples of triplet quenchers with an anthracene ring are given below.

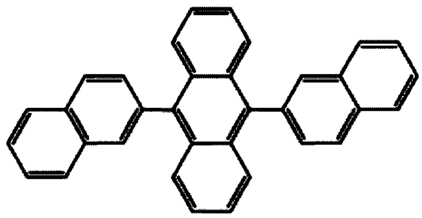

As the host material, employable are organic compounds of which at least any one of the excited singlet energy and the excited triplet energy is higher than that of the laser oscillation material. This makes it possible to confine the singlet exciton and the triplet exciton generated in the molecule of the laser oscillation material, thereby lowering the threshold current density for generating laser oscillation. Naturally, even if the singlet exciton and the triplet exciton cannot be confined sufficiently, they may contribute to lower threshold and improved laser properties, so any host material that can achieve lower threshold and improved laser properties can be used in the invention without any particular restriction. In the organic solid-state semiconductor laser of the invention, the light induced and emitted by the laser oscillation material propagates in the light-emitting layer by the action of the optical resonator, and is emitted externally as laser light. The light emitted by the laser device can include the spontaneous emission light or spontaneous amplified light from the laser oscillation material, and can include the light emitted from the host material, but is, for example, mainly including laser light.

In the case where a host material is used, the amount of the laser oscillation material to be in the light-emitting layer is, for example, 0.1 wt% or more, for example, 0.5 wt% or more, for example, 1 wt% or more, and for example, 99 wt% or less, for example, 90 wt% or less, for example, 70 wt% or less, for example, 50 wt% or less or 30 wt% or less, for example, 15 wt% or less.

As the host material in the light-emitting layer, for example, employable is an organic compound that has a hole-transporting capability and an electron-transporting capability, prevents the light emission from being a longer wavelength, and has a high glass transition temperature. The host material can be appropriately selected from known host materials in consideration of the energy conditions and the physical properties as described above.

The materials that make up the light-emitting layer (laser oscillation materials and host materials) can be made of, for example, materials that have a hole mobility equal to or greater than that of BSBCz. This allows holes to stay efficiently near the interface with the hole-blocking layer of the light-emitting layer, and carrier recombination can occur more intensively in this region. Here, the hole mobility of the light-emitting layer can be greater than the electron mobility thereof, for example, 10 times greater than the electron mobility. The thickness of the light-emitting layer can be, for example, 10 nm or more, for example, 30 nm or more, 50 nm or more, or 70 nm or more, and can be, for example, less than 200 nm, for example, 150 nm or less, or 100 nm or less.

The thickness of the light-emitting layer can be selected from, for example, a range of 10 nm to less than 200 nm.

(Hole-Blocking Layer)

The hole-blocking layer can be arranged so as to be adjacent to the light-emitting layer, for example, in contact with the light-emitting layer. In one preferred aspect of the invention, the hole-blocking layer is formed along the flat interface of the light-emitting layer.

As shown in Fig. 1(b), the hole-blocking layer 15 a function of preventing holes(+) that have been transported in the light-emitting layer 14 toward the hole-blocking layer 15 side from moving to the electron injection section 17 side from the interface between the light-emitting layer 14 and the hole-blocking layer 15. As a result, holes stay near the interface

between the light-emitting layer 14 and the hole-blocking layer 15 and recombine with the electrons(-) that have moved from the hole-blocking layer 15 into the light-emitting layer 14. As a result, carrier recombination occurs intensively near this interface, efficiently generating induced light emission and realizing laser radiation with a small peak width of both the emission spectrum and the angular light intensity distribution. Although the laser device shown in Fig. 1 is used here as an example to illustrate the effects of the invention, the configuration of the organic solid-state semiconductor laser of the invention should not be interpreted as limited by this specific example.

From the point of view of expressing such a hole-blocking function, a material is selected for the hole-blocking layer such that, for example, the absolute value of the energy of the highest occupied molecular orbital (HOMO) of the hole-blocking layer is greater than the absolute value of the HOMO energy of the light-emitting layer. For example, the absolute value of the HOMO energy of the hole-blocking layer can be greater than the absolute value of the HOMO energy of the light-emitting layer by at least 0.1 eV, or by at least 0.2 eV, or by at least 0.4 eV.

The hole-blocking layer can contain a material with low hole mobility, for example. TPBi ([1,3,5-tris(1-phenyl-1H-benzimidazol-2-yl)benzene]) and T2T (2,4,6-tris([1,1'-biphenyl]-3-yl)-1,3,5-triazine) can be cited as specific examples of materials of the hole-blocking layer. Other materials for the hole-blocking layer can be selected from the group consisting of materials with a hole mobility equivalent to or lower than that of TPBi, and materials with a hole mobility equivalent to or lower than that of T2T.

The material of the hole-blocking layer can be selected, for example, from a group of compounds having a nitrogen-containing aromatic heterocyclic ring, or from a group of compounds having a structure in which a nitrogen-containing aromatic heterocyclic ring and an aromatic hydrocarbon ring bond together, for example. Nitrogen-containing aromatic heterocyclic rings include nitrogen-containing aromatic 6-membered rings such as a pyridine ring, a pyrazine ring, a pyrimidine ring, a pyridazine ring and a triazine ring; azole rings such as an imidazole ring, a thiazole ring and an oxazole ring; and fused rings formed by fusing such a nitrogen-containing aromatic 6-membered ring or an azole ring and an aromatic hydrocarbon ring. The aromatic hydrocarbon ring can be a monocyclic ring or a fused ring in which at least two rings are fused. In the case of a fused ring, the number of fusing rings can be selected from a range of 2 to 6, for example. Specific examples of the ring include a benzene ring and a naphthalene ring.

The thickness of the hole-blocking layer can be, for example, 1 nm or more, for example, 3 nm or more, for example, 5 nm or more or 8 nm or more, and can be, for example, 80 nm or less, for example, 30 nm or less or 15 nm or less.

(Spacer Layer)

The spacer layer used in the first embodiment is a layer optionally arranged between the hole-blocking layer and the electron injection section. When a spacer layer is arranged between the hole-blocking layer and the electron injection section, a space is created between the carrier recombination region (near the interface between the light-emitting layer and the hole-blocking layer) and the electron injection section, which can suppress the loss of light generated in the carrier recombination region by forming surface plasmon polaritons on the electrode surface and the loss of light due to absorption and scattering at the electrode.

The spacer layer can be a single-layer or multilayer configuration. In the case where one or more layers are arranged between the light-emitting layer and the hole injection section, the total thickness of the spacer layer can be at least twice the total thickness of the layers between the light-emitting layer and the hole injection section, such as 2.5 or 3 times or more. For the description of one or more layers arranged between the light-emitting layer and the hole injection section, the description of "Other Layers" given below can be referred to. The spacer layer is thicker than the layer between the light-emitting layer and the hole injection section, which makes the electron travel distance longer than the hole travel distance and prevents electrons from advancing too far in the light-emitting layer. As a result, carrier recombination can occur intensively in a narrower area. The spacer layer can contain a material with a lower refractive index than the light-emitting layer, for example. This allows the light from the light-emitting layer to be reflected efficiently at the interface on the light-emitting layer side of the spacer layer, thereby more reliably suppressing light loss at the electrode as described above.

The spacer layer used in the first embodiment can be, for example, a layer with electron transport properties (electron transport layer) that can transport electrons injected from the electron injection section to the hole-blocking layer side. In the following, the electron transport layer is described as an example of the spacer layer.

(Electron Transport Layer)

A specific example of materials of the electron transport layer is TPBi. Other materials for the electron transport layer can be selected from a group of electron-transporting compounds with an electron mobility equivalent to or lower than that of TPBi. The low electron mobility of the electron transport layer prevents electrons from traveling too far in the light-emitting layer, allowing carrier recombination to occur intensively in a narrower region.

The material of the electron transport layer can be selected, for example, from a group of compounds having a

nitrogen-containing aromatic heterocyclic ring, or from a group of compounds having a structure in which a nitrogen-containing aromatic heterocyclic ring and an aromatic hydrocarbon ring bond together, for example. For the description and specific examples of the nitrogen-containing aromatic heterocyclic ring and the aromatic hydrocarbon ring, the description of the nitrogen-containing aromatic heterocyclic ring and the aromatic hydrocarbon ring in the section of the hole-blocking layer can be referred to. However, materials different from those of the hole-blocking layer can be used for the electron transport layer.

In one aspect of the invention, the electron transport layer is a layer with a larger absolute value of HOMO energy than the light-emitting layer. Specifically, the absolute value of the HOMO energy of the electron transport layer can be greater than the absolute value of the HOMO energy of the light-emitting layer by at least 0.1 eV, for example, by at least 0.2 eV.

The thickness of the electron transport layer can be, for example, 10 nm or more, for example, 20 nm or more, for example, 40 nm or more or 60 nm or more, and can be, for example, 100 nm or less, for example, 80 nm or less.

(Other Layers)

The organic solid-state semiconductor laser of the first embodiment can have one or more layers between the light-emitting layer and the hole injection section, if necessary. Examples of the layers between the light-emitting layer and the hole injection section include a hole injection layer and a hole transport layer. The hole injection layer has a function to lower the hole injection barrier in the hole injection section, and the hole transport layer has a function to transport the holes injected from the hole injection section to the light-emitting layer side. The hole transport layer can be a hole injection transport layer with a hole injection function.

Examples of the materials for the hole transport layer include triazole derivatives, oxadiazole derivatives, imidazole derivatives, carbazole derivatives, indolocarbazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline copolymers, and conductive polymer oligomers, especially thiophene oligomers, and can be selected from, for example, a compound group of porphyrin compounds, aromatic tertiary amine compounds and styrylamine compounds, and can be selected from a compound group of aromatic tertiary amine compounds.

NPD is a specific example of the materials for the hole transport layer. Other materials for the hole transport layer can be selected from a group of compounds that have a hole mobility equivalent to or higher than that of NPD. HATCN ([dipyrazino[2,3-f:2',3'-h]quinoxaline-2,3,6,7,10,11-hexacarbonitrile]) can be used as a specific example of the materials for the hole injection layer. Other materials for the hole injection layer can be selected from a group of compounds that have a LUMO or HOMO level between the Fermi level of the hole injection section and the HOMO level of the light-emitting layer. Between the light-emitting layer and the hole injection section, there can be a layer containing a material with a hole mobility equivalent to or greater than that of HATCN, for example.

(Optical Resonator)

The optical resonator a function of propagating the emitted light within the light-emitting layer. The optical resonator can be a distributed feedback (DFB) or distributed reflection (DBR) optical resonator that reflects light on a diffraction grating, or a Fabry-Perot type optical resonator including a reflector and a partial reflector placed opposite each other.

The diffraction grating to constitute the optical resonator is designed to satisfy the following Bragg equation. The diffraction grating used in the optical resonator can be a first-order diffraction grating where m is 1, a second-order diffraction grating where m is 2, or a third-order diffraction grating where m is 3, or even a higher-order diffraction grating. It can also be a mixed-order grating that is a combination of diffraction gratings of different orders.

$$\text{Bragg Equation: } m\lambda_{Bragg} = 2_{neff}\Lambda_m$$

where m is a diffraction order, $\lambda_{Bragg}$ is a Bragg wavelength, and A is a period of the diffraction grating.

In one aspect of the invention, the diffraction grating that constitutes the optical resonator is a diffraction grating having a periodic relief structure in which grating protrusions and grooves (grating grooves) divided by the grating protrusions are periodically arranged. The diffraction grating of the type can be a one-dimensional diffraction grating with striated grating protrusions arranged in a lateral direction, or can be a two-dimensional diffraction grating with striated grating protrusions aligned and intersecting in a longitudinal and lateral direction, or can be a two-dimensional diffraction grating with rectangular grating protrusions scattered in a matrix, or can be a three-dimensional diffraction grating with two-dimensional diffraction gratings stacked in the height direction. Here, the diffraction grating can be arranged so that at least

a part of the grating protrusion, for example, penetrates into the inside of the light-emitting layer from the hole injection section side of the light-emitting layer. In the following description, the part of the grating protrusion that penetrates into the inside of the light-emitting layer is referred to as "penetration area". The length of the penetration area of the grating protrusion can be selected from a range where the length of the penetration area is shorter than the thickness of the light-emitting layer, for example, at least 15 nm shorter than the thickness of the light-emitting layer. This ensures a carrier recombination region in the region where the grating protrusions do not penetrate, and carrier recombination and induced emission can occur efficiently here. Such diffraction gratings can be formed, for example, on the surface of the light-emitting layer side of the electrode that constitutes the hole injection section. In that case, the grating protrusions are formed on the light-emitting layer side surface of the electrode, and the electrode surface can be exposed out from the bottom of the grating grooves.

The diffraction grating can also be arranged between the carrier recombination region of the light-emitting layer and the hole injection section, with the base of the grating protrusion of the diffraction grating placed at the interface on the hole injection section side of the light-emitting layer or on the hole injection section side than the interface, and the hole-blocking layer can be positioned between the light-emitting layer and the electron injection section and adjacent to the light-emitting layer.

The grating protrusion can be made of an insulating material, for example. The insulating material can be an inorganic insulating material or can be an organic insulating material. Specific examples of the insulating materials include glass, silicon dioxide, and plastics.

[Second Embodiment]

Next, the second embodiment of the organic solid-state semiconductor laser is described.

The organic solid-state semiconductor laser of the second embodiment has a configuration of at least a hole injection section, an electron-blocking layer, a light-emitting layer, and an electron injection section stacked in that order, and also has an optical resonator that propagates the emitted light inside the light-emitting layer. The organic solid-state semiconductor laser of the second embodiment can further have a spacer layer between the electron-blocking layer and the hole injection section, and can have one or more layers between the light-emitting layer and the electron injection section. Here, the electron-blocking layer, the light-emitting layer, the spacer layer, and one or more layers arranged between the light-emitting layer and the electron injection section can be organic layers. An example of the specific structure of the second embodiment is shown in Fig. 2. In Fig. 2, 21 represents a hole injection section, 22 represents a hole transport layer, 23 represents an electron-blocking layer, 24 represents a light-emitting layer, 25 represents an electron transport layer, 26 represents an electron injection layer, 27 represents an electron injection section, and 28 represents a diffraction grating that forms an optical resonator. Here, the hole transport layer 22 constitutes the spacer layer, and the electron transport layer 25 and the electron injection layer 26 correspond to the "one or more layers arranged between the light-emitting layer and the electron injection section" described above.

In the following, the constituent layers and members of the organic solid-state semiconductor laser of the second embodiment are described. For the description of the substrate and the light-emitting layer, the description in the "Substrate" and "Light-emitting layer" description sections in the first embodiment can be referred to. The organic solid-state semiconductor laser of the second embodiment can contain a hole injection section, an electron-blocking layer, a light-emitting layer and an electron injection section stacked in that order on a substrate, or can contain an electron injection section, a light-emitting layer, an electron-blocking layer and a hole injection section stacked in that order on a substrate.

(Hole Injection Section)

The hole injection section a function of injecting holes. For example, in the case where an electron-blocking layer is arranged adjacent to the hole injection section, holes are injected into the electron-blocking layer from the hole injection section, and the holes transported through the electron-blocking layer are injected into the light-emitting layer. In the case where a spacer layer is arranged between the electron-blocking layer and the hole injection section so as to be adjacent to the hole injection section, electrons are injected from the hole injection section into the spacer layer, and the electrons transported through the spacer layer and the electron-blocking layer are injected into the light-emitting layer.

In one aspect of the invention, the hole injection section of the second embodiment is an electrode, and is, for example, a transparent electrode. For the description and specific examples of the electrode (anode), which is the hole injection section, the description in the "Hole injection section" description section in the first embodiment can be referred to.

(Electron injection section)

The electron injection section a function of injecting electrons into the laser device. For example, in the case where the light-emitting layer is arranged adjacent to the electron injection section, electrons are injected directly from the electron injection section into the light-emitting layer. In the case where the device has one or more layers between the light-emitting layer and the electron injection section, electrons are injected from the electron injection section into the layer adjacent to the electron injection section among the one or more layers, and the electrons transported through the one or more layers are injected into the light-emitting layer.

In one aspect of the invention, the electron injection section of the second embodiment is an electrode, and is, for example, a metal electrode. For the description and specific examples of the electrode (cathode), which is the electron injection section, the description in the "Electron Injection Section" description section in the first embodiment can be referred to.

(Electron-Blocking Layer)

The electron-blocking layer can be arranged so as to be adjacent to the light-emitting layer, for example, is arranged in contact with the light-emitting layer. In one preferred aspect of the invention, the electron-blocking layer is formed along the flat interface of the light-emitting layer.

The electron-blocking layer has a function to prevent the electrons transported through the light-emitting layer toward the electron-blocking layer from moving to the hole injection section side from the interface between the light-emitting layer and the electron-blocking layer. As shown in Fig. 2, this causes electrons (e-) to stay near the interface with the electron-blocking layer of the light-emitting layer and recombine with the holes that have moved from the electron-blocking layer into the light-emitting layer. As a result, carrier recombination occurs intensively near this interface, efficiently generating induced light emission and realizing laser radiation with a small peak width of both the emission spectrum and the angular light intensity distribution. Although the laser device shown in Fig. 2 is used here as an example to illustrate the effects of the invention, the configuration of the organic solid-state semiconductor laser of the invention should not be interpreted as limited by this specific example.

From the point of view of expressing such an electron-blocking function, a material is selected for the electron-blocking layer such that, for example, the absolute value of the energy of the lowest unoccupied molecular orbital (LUMO) of the electron-blocking layer is smaller than the absolute value of the LUMO energy of the light-emitting layer. For example, the absolute value of the LUMO energy of the electron-blocking layer can be smaller than the absolute value of the LUMO energy of the light-emitting layer by at least 0.1 eV, or by at least 0.2 eV, or by at least 0.4 eV.

The electron-blocking layer can contain a material with a low electron mobility, for example. NPD (N,N'-di(1-naphthyl)-N,N'-diphenylbenzidine) is an example of the electron-blocking layer material. Other materials for the electron-blocking layer can be selected from a group of materials with an electron mobility equivalent to or lower than that of NPD.

The thickness of the electron-blocking layer can be, for example, 1 nm or more, for example, 3 nm or more, for example, 5 nm or more or 8 nm or more, and can be, for example, 80 nm or less, for example, 30 nm or less or 15 nm or less.

(Spacer Layer)

The spacer layer used in the second embodiment is a layer optionally arranged between the electron-blocking layer and the hole injection section. By placing a spacer layer between the electron-blocking layer and the hole injection section, a space is created between the carrier recombination region (near the interface between the light-emitting layer and the electron-blocking layer) and the hole injection section, and therefore the loss of light generated in the carrier recombination region by forming surface plasmon polaritons on the electrode surface and the loss of light due to absorption and scattering at the electrode can be suppressed.

The spacer layer can be a single-layer or multilayer configuration. In the case where one or more layers are arranged between the light-emitting layer and the electron injection section, the total thickness of the spacer layer can be at least twice the total thickness of the layers between the light-emitting layer and the electron injection section, such as 2.5 or 3 times or more. For the description of one or more layers arranged between the light-emitting layer and the electron injection section, the description of "Other Layers" given below can be referred to. The spacer layer is thicker than the layer between the light-emitting layer and the electron injection section, which makes the hole travel distance longer than the electron travel distance and prevents holes from advancing too far in the light-emitting layer. As a result, carrier recombination can occur intensively in a narrower area. The spacer layer can contain a material with a lower refractive index than the light-emitting layer, for example. This allows the light from the light-emitting layer to be reflected efficiently at the interface on the light-emitting layer side of the spacer layer, thereby more reliably suppressing light loss at the electrode as described above.

The spacer layer used in the second embodiment can be, for example, a layer with hole transport properties (hole

transport layer) that can transport holes injected from the hole injection section to the electron-blocking layer side. In the following, the hole transport layer is described as an example of the spacer layer.

(Hole Transport Layer)

Materials for the hole transport layer that can be used are hole-transporting compounds that have a hole mobility equivalent to or lower than that of HATCN. The low hole mobility of the hole transport layer prevents holes from traveling too far in the light-emitting layer, allowing carrier recombination to occur intensively in a narrower region. However, materials different from those of the electron-blocking layer can be used for the hole transport layer.

In one aspect of the invention, the hole transport layer is a layer with a smaller absolute value of LUMO energy than the light-emitting layer. Specifically, the absolute value of the LUMO energy of the hole transport layer can be smaller than the absolute value of the LUMO energy of the light-emitting layer by at least 0.1 eV, for example, by at least 0.2 eV.

The thickness of the hole transport layer can be, for example, 10 nm or more, for example, 20 nm or more, for example, 40 nm or more or 60 nm or more, and can be, for example, 100 nm or less, for example, 80 nm or less.

(Other Layers)

The organic solid-state semiconductor laser of the second embodiment can have one or more layers between the light-emitting layer and the electron injection section, if necessary. Examples of the layers between the light-emitting layer and the electron injection section include an electron injection layer and an electron transport layer. The electron injection layer has a function to lower the electron injection barrier in the electron injection section, and the electron transport layer has a function to transport the electrons injected from the electron injection section to the light-emitting layer side. The electron transport layer can be an electron injection transport layer that also functions as an electron injection layer.

Materials for the electron transport layer also include, for example, nitro-substituted fluorene derivatives, diphenylquinone derivatives, thiopyran dioxide derivatives, carbodiimides, fluorenylidene-methane derivatives, anthraquinodimethane and anthrone derivatives, and oxadiazole derivatives. Furthermore, in the above oxadiazole derivatives, thiadiazole derivatives in which the oxygen atom of the oxadiazole ring is substituted with a sulfur atom, and quinoxaline derivatives having a quinoxaline ring known as an electron-withdrawing group can also be used as electron transport materials. In addition, polymeric materials in which these materials are introduced into the polymer chain or in which these materials are used as the principal chain of the polymer can also be used.

A specific example of materials of the electron transport layer is TPBi. Other materials for the electron transport layer can be selected from a group of compounds that have an electron mobility equivalent to or higher than that of TPBi.

(Optical Resonator)

The description of the optical resonator can refer to the description in the "Optical Resonator" description section in the first embodiment above, except for the description of the diffraction grating arrangement and the grating protrusion penetration area.

In the diffraction grating used in the second embodiment, for example, at least a part of the grating protrusion can be arranged to penetrate into the inside of the light-emitting layer from the electron injection section side of the light-emitting layer. In the grating protrusion, the length of the penetration area penetrating into the light-emitting layer can be selected from a range where the length of the penetration area is shorter than the thickness of the light-emitting layer, for example, at least 15 nm shorter than the thickness of the light-emitting layer. This ensures a carrier recombination region in the region where the grating protrusions do not penetrate, and carrier recombination and induced emission can occur efficiently here. Such diffraction gratings can be formed, for example, on the surface of the light-emitting layer side of the electrode that constitutes the electron injection section. In that case, the grating protrusions are formed on the light-emitting layer side surface of the electrode, and the electrode surface can be exposed out from the bottom of the grating grooves.

The diffraction grating can also be arranged between the carrier recombination region of the light-emitting layer and the electron injection section, with the base of the grating protrusion of the diffraction grating placed at the interface on the electron injection section side of the light-emitting layer or on the electron injection section side than the interface, and the electron-blocking layer can be positioned between the light-emitting layer and the hole injection section and adjacent to the light-emitting layer.

The organic solid-state semiconductor lasers of the first and second embodiments can be surface-emitting laser devices that emit laser light from the surface or edge-emitting laser devices that emit laser light from the end surface. In the case of a surface-emitting laser device, it can be a bottom-emission type that emits laser light from the substrate side, or a top-emission type that emits laser light from the side opposite to the substrate. The organic solid-state semiconductor lasers of the first and second embodiments can be dual-emission laser devices where the back side can be seen through

from the front side. Although laser light can leak out from surfaces other than the surface set as the laser light-emitting surface for these types of laser device, for example, the majority (over 50%) of the laser light is emitted from the set laser light-emitting surface.

In organic solid-state semiconductor lasers where the electron injection section is on the opposite side of the substrate from the light-emitting layer across the light-emitting layer, a top-emission type organic solid-state semiconductor laser can be provided by configuring the electron injection section with a material having high optical transmittance. In one aspect of the invention, the electron injection section is a DMD structure having a high light transmittance or a thin Ag layer (for example, having a thickness of 40 nm or less, for example, 5 to 30 nm, for example 12 to 25 nm). By constructing the hole injection section with a material having a high light transmittance, bottom-emission organic solid-state semiconductor lasers can be provided. In one aspect of the invention, the hole injection section is an ITO layer. By constructing the electron injection section and the hole injection section with a material having a high light transmittance, dual-emission organic solid-state semiconductor lasers can be provided.

On the other hand, in organic solid-state semiconductor lasers where the hole injection section is on the opposite side of the substrate from the light-emitting layer across the light-emitting layer, a top-emission type organic solid-state semiconductor laser can be provided by configuring the hole injection section with a material having high optical transmittance. In one aspect of the invention, the hole injection section is a DMD structure or ITO layer with a high light transmittance. By constructing the electron injection section with a material having a high light transmittance, bottom-emission organic solid-state semiconductor lasers can be provided. In one aspect of the invention, the electron injection section is a stack structure of ITO/Al/LiF. Here, the thickness of Al and LiF is selected from a range of 0.5 to 10 nm. By constructing the hole injection section and the electron injection section with a material having a high light transmittance, dual-emission organic solid-state semiconductor lasers can be provided.

Here, "DMD structure" is an abbreviation for a dielectric-metal-dielectric structure, and means a stack structure of dielectric/metal/dielectric. The DMD structure can be employed in the invention as an electrode that utilizes the interference of the stack structure. Ag can be used for the metal to constitute the DMD structure. $MoO_3$, ITO, ZnS, InZnSnO, and $WO_3$ can be used as dielectrics for the DMD structure. The materials of the two dielectric layers on both sides of the metal layer can be the same or different from each other. In one aspect of the invention, the materials of the two dielectric layers of the DMD structure are the same. In addition to $MoO_3$/Ag/$MoO_3$ used in Examples herein, ITO/Ag/ITO, ZnS/Ag/ZnS, ZnO/Ag/ZnO, InZnSnO/Ag/InZnSnO, ITO/Ag/$WO_3$, ZnO/Ag/$WO_3$, and $WO_3$/Ag/$WO_3$ can also be used as DMD structures.

The thickness of the two dielectric layers on both sides of the metal layer can be the same or different from each other.

By controlling the refractive index of the layers that constitute the organic solid-state semiconductor laser, the light generated by the laser oscillation material is confined inside the optical resonator. This reduces optical loss at the electrode and lowers the laser oscillation threshold. Specifically, the refractive index of each layer can be controlled as in the following aspects.

In one aspect of the invention, the organic solid-state semiconductor laser is configured as the first embodiment, in which the refractive index of the layer between the light-emitting layer and the electron injection section (hole-blocking layer, or hole-blocking layer and spacer layer) is smaller than that of the light-emitting layer. In one aspect of the invention, the organic solid-state semiconductor laser is configured as the second embodiment, in which the refractive index of the layer between the light-emitting layer and the electron injection section (for example, electron injection layer or electron transport layer) is smaller than that of the light-emitting layer. In the organic solid-state semiconductor lasers of those aspects, the light generated by the laser oscillation material is efficiently reflected at the interface between the light-emitting layer and the layer adjacent to the electron injection section side of the light-emitting layer and confined in the optical resonator (refractive index waveguiding) or gain waveguiding is formed, thereby efficiently causing laser oscillation. The laser light generated here can be extracted out, for example, by transmitting through the layer between the light-emitting layer and the hole injection section, or the hole injection section or the substrate, so that the organic solid-state semiconductor lasers of these aspects can be used, for example, as bottom-emission laser devices.

In one aspect of the invention, the organic solid-state semiconductor laser is configured as the first embodiment, in which the refractive index of the layer between the light-emitting layer and the hole injection section (for example, hole injection layer or hole transport layer) is smaller than that of the light-emitting layer. In one aspect of the invention, the organic solid-state semiconductor laser is configured as the second embodiment, in which the refractive index of the layer between the light-emitting layer and the hole injection section (electron-blocking layer, or electron-blocking layer and spacer layer) is smaller than that of the light-emitting layer. In the organic solid-state semiconductor lasers of those embodiments, the light generated by the laser oscillation material is efficiently reflected at the interface between the light-emitting layer and the layer adjacent to the hole injection section side of the light-emitting layer and confined in the optical resonator (refractive index waveguiding) or gain waveguiding is formed, thereby efficiently causing laser oscillation. The laser light generated here can be extracted out, for example, by transmitting through the layer between the light-emitting layer and the electron injection section, or the electron injection section, so that the organic solid-state semiconductor

lasers of these aspects can be used, for example, as top-emission laser devices.

In one aspect of the invention, the organic solid-state semiconductor laser is configured as the first embodiment, in which both the refractive index of the layer between the light-emitting layer and the electron injection section and that of the layer between light-emitting layer and the hole injection section are smaller than the refractive index of the light-emitting layer. In one aspect of the invention, the organic solid-state semiconductor laser is configured as the second embodiment, in which both the refractive index of the layer between the light-emitting layer and the electron injection section and that of the layer between light-emitting layer and the hole injection section are smaller than the refractive index of the light-emitting layer. In the organic solid-state semiconductor lasers of these aspects, the light generated by the laser oscillation material is efficiently reflected at the interfaces between the light-emitting layer and the layers adjacent to both sides of the light-emitting layer, and confined in the optical resonator, so that the light travels laterally in the light-emitting layer and can efficiently cause laser oscillation. Also, in one aspect of the invention, the organic solid-state semiconductor laser is configured as the first or second embodiment, and the gain is high in the center of the lateral path of its light-emitting layer. In the organic solid-state semiconductor lasers of these aspects, light passing through the center of the lateral path is strongly amplified, so that light naturally travels in that lateral path (high gain region). In the organic solid-state semiconductor lasers of these aspects, light needs only to propagate laterally in the light-emitting layer, and the final direction of light extraction can be vertical.

The organic solid-state semiconductor lasers of these aspects are characterized in that, in the case of the first embodiment thereof, light propagates in the lateral direction, while the movement of holes in the vertical direction is hindered (blocked) by the hole-blocking layer, and that, in the case of the second embodiment thereof, light propagates in the lateral direction, while the movement of electrons in the vertical direction is hindered (blocked) by the electron-blocking layer.

As described above, the organic solid-state semiconductor laser of the invention has a hole-blocking layer or an electron-blocking layer, which causes carrier recombination to occur intensively near the interface between the light-emitting layer and the hole-blocking layer or near the interface between the light-emitting layer and the electron-blocking layer, resulting in reduction in the peak width of the emission spectrum and the peak width of the angular light intensity distribution. As a result, organic solid-state semiconductor lasers with excellent laser characteristics such as laser efficiency and monochromaticity are realized. Herein, the "peak width of emission spectrum" in the present description means a full width at half maximum (FWHM) of the emission peak with the highest intensity among the emission peaks that appear in the light intensity distribution (emission spectrum) relative to wavelength, and the "peak width of angular light intensity distribution" means a full width at half maximum (FWHM) of the emission peak with the highest intensity among the emission peaks that appear in the light intensity distribution measured at different angles of a light receiving device. The peak width of the emission spectrum observed in the organic solid-state semiconductor laser of the invention is, for example, 10 nm or less, for example, 7 nm or less, for example, 5 nm or less, for example, 4 nm or less, for example, 3 nm or less, for example, 2 nm or less, for example, 1 nm or less. The peak width of the angular light intensity distribution observed with the organic solid-state semiconductor laser of the invention is, for example, 10° or less, for example, 7° or less, for example, 5° or less, for example, 4° or less, for example, 3° or less, for example, 2° or less, for example, 1° or less.

<Method for reducing full-width half-maximum of emission wavelength peak of emission spectrum>

Next, the method for reducing the full-width half-maximum of the emission wavelength peak of emission spectrum (the peak width of emission spectrum) of the invention is described.

The method of the invention is a method for narrowing the full-width half-maximum (FWHM) of the emission wavelength peak of the emission spectrum of an organic electroluminescent device provided with a hole injection section of injecting holes, an electron injection section of injecting electrons, and a light-emitting layer arranged between the hole injection section and the electron injection section to emit light by recombining holes and electrons, in which
the light generated in the light-emitting layer propagates in a lateral direction of the light-emitting layer, the method including:

> when the side of the light-emitting layer that is the exciton-dense region is on the electron injection section side, arranging the hole-blocking layer at a position between the light-emitting layer and the electron injection section and adjacent to the light-emitting layer, and
> when the side of the light-emitting layer that is the exciton-dense region is on the hole injection section side, arranging the electron-blocking layer at a position between the light-emitting layer and the hole injection section and adjacent to the light-emitting layer.

The organic electroluminescent device covered by the invention can be, for example, an organic electroluminescent device in which the light generated in the light-emitting layer propagates in the lateral direction of the light-emitting layer. Here, the "lateral direction of the light-emitting layer" means the direction along the interface of the light-emitting layer

(the direction orthogonal to the thickness direction). The organic electroluminescent device in which light propagates in the lateral direction of the light-emitting layer can be obtained by forming refractive index waveguides or gain waveguides in the device. The refractive index waveguide is formed by configuring at least one layer between the light-emitting layer and the hole injection section and at least one layer between the light-emitting layer and the electron injection section as a low refractive index layer with a lower refractive index than the light-emitting layer. For example, at least one of the electron transport layer and the hole-blocking layer and at least one of the electron-blocking layer and the hole transport layer can be configured as a low refractive index layer. In one aspect of the invention, the layer adjacent to the electron injection section side of the light-emitting layer and the layer adjacent to the hole injection section side of the light-emitting layer are both low refractive index layers with a lower refractive index than the light-emitting layer. The gain waveguide can be formed by designing the device so that the gain is higher at the center of the lateral path. For the description of these waveguides, reference can be made to the refractive index waveguide and gain waveguide descriptions in the <Organic Solid-State Semiconductor Lasers> section. In such an organic electroluminescent device, light propagates in the lateral direction, while the movement of holes in the vertical direction is hindered (blocked) by the hole-blocking layer. Alternatively, while light propagates in the lateral direction, the movement of electrons in the vertical direction is hindered (blocked) by the electron-blocking layer. In the organic electroluminescent device covered by the invention, light needs only to propagate laterally in the light-emitting layer, and the final direction of light extraction can be vertical.

The organic electroluminescent device covered by the invention can be an ordinary organic electroluminescent device that emits mainly spontaneous emission light, or an organic electroluminescent device that is provided with an optical resonator that propagates the emitted light in the light-emitting layer and emits laser light (for example, organic solid-state semiconductor laser).

For the description of the hole injection section, the electron injection section, and the light-emitting layer that constitute the organic electroluminescent device, and the description of the optical resonator arranged as necessary, as well as the description of the hole-blocking layer or the electron-blocking layer arranged depending on the location of the exciton-dense region, reference can be made to the corresponding descriptions in the [First Embodiment] section and the [Second Embodiment] section given hereinabove. The organic electroluminescent device covered by the invention can also have any other layers than the hole injection section, the electron injection section, the light-emitting layer, the hole-blocking layer, and the electron-blocking layer. The other layers can include an electron transport layer, a hole transport layer, and a spacer layer, and can have any other layers and substrates. Also, for the description of these layers, reference can be made to the description in the section of [First Embodiment] and the section of [Second Embodiment] given hereinabove.

The organic electroluminescent device can be the organic solid-state semiconductor laser of the first embodiment or the second embodiment, or the organic electroluminescent device with the optical resonator excluded from these organic solid-state semiconductor lasers. However, the organic electroluminescent device covered by the invention can also be an organic electroluminescent device in which the light generated in the light-emitting layer propagates in the lateral direction of the light-emitting layer.

The "exciton-dense region" in the invention can mean a virtual cross-sectional region orthogonal to the thickness direction at the position having a highest exciton density in the light-emitting layer when holes from the hole injection section and electrons from the electron injection section are injected into the light-emitting layer and carrier recombination occurs. The location of the exciton-dense region can be determined by simulating the exciton density distribution in the light-emitting layer.

For example, in the simulation results in Fig. 8 obtained in Examples, the interface between the hole-blocking layer HBL and the light-emitting layer EML, corresponding to the peak of the exciton density distribution, corresponds to the "exciton-dense region".

The "side that is the exciton-dense region" in the invention is determined to be on the hole injection side of the light-emitting layer in the case where the exciton-dense region is on the hole injection section side of the light-emitting layer than the median side in the thickness direction of the light-emitting layer, and in the case where the exciton-dense region is on the electron injection section side of the light-emitting layer than the median side thereof, the region is determined to be on the electron injection section side of the light-emitting layer.

Therefore, in the simulation results shown in Fig. 8, the electron injection section side is determined to be the "side of exciton-dense region," and a hole-blocking layer is arranged at the position between the light-emitting layer and the electron injection section and adjacent to the light-emitting layer. In the case where the simulation results show that the exciton density distribution peak is on the hole injection section side of the light-emitting layer, the hole injection section side can be determined to be the "side of exciton-dense region" and an electron-blocking layer can be arranged at the position between the light-emitting layer and the hole injection section and adjacent to the light-emitting layer.

In the organic electroluminescent device in which the exciton-dense region is on the electron injection section side and a hole-blocking layer is arranged at the position adjacent to the electron injection section side of the light-emitting layer, holes(+) that have moved through the light-emitting layer stay at the interface between the light-emitting layer/hole-blocking layer, resulting in occurrence of intensive carrier recombination in a narrow region near this interface to form a

carrier recombination region $RZ_H$ with a high exciton density. Accordingly, the peak width of the emission spectrum can be thereby reduced.

On the other hand, in the organic electroluminescent device where the exciton-dense region is on the hole injection section side and the electron-blocking layer is located adjacent to the hole injection section side of the light-emitting layer, the electrons(-) that have moved through the light-emitting layer stay at the interface between the light-emitting layer/electron-blocking layer, and as a result, carrier recombination occurs intensively in a narrow region near this interface, forming a carrier recombination region $RZ_H$ with a high exciton density. Accordingly, the peak width of the emission spectrum can be thereby reduced.

The organic electroluminescent device covered by the invention can be an ordinary organic electroluminescent device, or an organic electroluminescent device that is provided with an optical resonator that propagates the emitted light in the light-emitting layer and emits laser light (for example, organic solid-state semiconductor laser). In the case where the optical resonator is a diffraction grating with grating protrusions and grating grooves, the position of the hole-blocking or electron-blocking layer can be along the flat interface of the light-emitting layer. This results in the formation of a carrier recombination region $RZ_H$ along the flat interface, which is advantageous for narrowing the peak width of the emission spectrum.

In one preferred aspect of the invention, the target organic electroluminescent device has a diffraction grating between the exciton-dense region of the light-emitting layer and the hole injection section, in which the hole-blocking layer can be arranged between the light-emitting layer and the electron injection section and adjacent to the light-emitting layer.

In one preferred aspect of the invention, the target organic electroluminescent device has a diffraction grating between the exciton-dense region of the light-emitting layer and the electron injection section, in which the electron-blocking layer can be arranged between the light-emitting layer and the hole injection section and adjacent to the light-emitting layer.

<Method for adjusting thickness and refractive index of spacer layer of organic electroluminescent device>

Next described is a method for adjusting the thickness and the refractive index of the spacer layer of the organic electroluminescent device of the invention.

The organic electroluminescent device covered by the invention can have a spacer layer at least one of between the light-emitting layer and the electron injection section and between the light-emitting layer and the hole injection section.

The spacer layer provides space between the light-emitting layer/electron injection section or between the light-emitting layer/hole injection section to thereby suppress the loss of light from the light-emitting layer caused by forming surface plasmon polaritons on the electrode surface of the electron injection section and the hole injection section or light loss caused by absorption and scattering at the electrodes. The spacer layer effectively lowers the ASE (amplified spontaneous emission) threshold and the laser oscillation threshold by suppressing the optical absorption, especially at the electrode, which causes significant losses.

Since the optical loss suppression effect of the spacer layer as described above depends on the thickness and the refractive index of the spacer layer, it is important to adjust the thickness and the refractive index of the spacer layer to effectively lower the ASE threshold and the laser oscillation threshold. Under these circumstances, the invention uses the absorption model expressed by the following equation as an index for adjusting the thickness and the refractive index of the spacer layer.

$$I = I_0 e^{-\alpha x}$$

In the equation, I represents the intensity of light after passing through a distance x, $I_0$ represents the initial intensity of light, $\alpha$ represents the absorption coefficient of the medium of the electron injection section (electrode) and the spacer layer, and x represents the distance where light passes through the medium. Here, the absorption coefficient $\alpha$ is expressed by the following equation.

$$\alpha = 4\pi k/\lambda$$

In the equation, k represents the light absorption coefficient of the medium and is the imaginary part of the complex refractive index n* expressed by the following expression. $\lambda$ represents the wavelength of light in the medium.

$$n^* = n + ik$$

In the equation, n* represents the complex refractive index, n represents the real refractive index of the medium, k represents the absorption coefficient of the medium, and i represents the imaginary unit.

The ASE threshold and the laser oscillation threshold are very sensitive to optical absorption loss, and therefore, by adjusting the thickness and the refractive index of the spacer layer based on this absorption model, organic electroluminescent devices with small optical absorption loss and low ASE threshold and laser oscillation threshold can be ensured. The following is a specific description of the method of adjusting the spacer layer in the invention. In the following description, the method of adjusting the spacer layer (first spacer layer) between the light- emitting layer/electron injection section is referred to as the first method, and the method of adjusting the spacer layer (second spacer layer) between the light-emitting layer/hole injection section is referred to as the second method.

The "ASE threshold" in the invention is a value obtained as the excitation intensity at the point where the slope changes in the excitation intensity-optical output characteristic measured for a stack sample without an optical resonator, and the "laser oscillation threshold" in the invention is a value obtained as the excitation intensity at the point where the slope changes in the excitation intensity-optical output characteristic measured for a stack sample with an optical resonator.

[First Method]

The first method is a method for adjusting at least one of a thickness and a refractive index of the first spacer layer of an organic electroluminescent device, provided with a hole injection section of injecting holes, an electron injection section of injecting electrons, a light-emitting layer arranged between the hole injection section and the electron injection section to emit light by recombining holes and electrons, and a first spacer layer arranged between the light-emitting layer and the electron injection section, the method including:

adjusting at least one of the thickness and the refractive index of the first spacer layer using an absorption model.

The organic electroluminescent device targeted by the first method can be an ordinary organic electroluminescent device that primarily emits spontaneous emission light, or can be an organic electroluminescent device that is provided with an optical resonator that propagates the emitted light within the light-emitting layer and emits laser light (for example, organic solid-state semiconductor laser).

For the description of the hole injection section, the electron injection section, the light-emitting layer and the first spacer layer that constitute the organic electroluminescent device, and for the description of the optical resonator that is optionally arranged in the device, reference can be made to the corresponding descriptions in the [First Embodiment] section and the [Second Embodiment] section given hereinabove. Here, the first spacer layer corresponds to the "spacer layer" in the first embodiment. For the material for the first spacer layer, it is preferable to use a material with a low refractive index and a low light absorption relative to the light from the light-emitting layer, and TPBi (refractive index n: 1.798 and extinction coefficient k: 0 relative to the emission wavelength of BSBCz) can be used preferably. The organic electroluminescent device targeted by the invention can also have any other layers than the hole injection section, the electron injection section, the light-emitting layer, and the first spacer layer. The other layers can include a hole-blocking layer, an electron-blocking layer, an electron transport layer, a hole transport layer and a second spacer layer, and can have any other layers and substrates. Also, for the description of these layers, reference can be made to the description in the section of [First Embodiment] and the section of [Second Embodiment] given hereinabove. Here, at least one of the thickness and the refractive index of the second spacer layer can be adjusted using the second method below.

The organic electroluminescent device can be the organic solid-state semiconductor laser of the first embodiment or the second embodiment, or the organic electroluminescent device with the optical resonator excluded from these organic solid-state semiconductor lasers. However, in the organic electroluminescent devices targeted by the invention, the first spacer layer is considered an essential layer, and the device may or may not have a hole-blocking layer and an electron-blocking layer. The device targeted by the invention can have only one of the hole-blocking and the electron-blocking layers, or can have the both.

The absorption model used in the first method is, for example, an absorption model for a stack sample of the constituent members of the target organic electroluminescent device, in which the light-emitting layer, the first spacer layer and the electron injection section are stacked in that order. Here, at least one (preferably only one) of the thickness and the refractive index is varied for the first spacer layer, while the other layers are formed of the same material and the same thickness as the target organic electroluminescent device.

A specific example of the stack sample is shown in Fig. 3(a). The stack sample shown in Fig. 3(a) includes a BSBCz light-emitting layer (200 nm), a TPBi spacer layer ($X_1$ nm), and an Ag electron injection section (100 nm) stacked on a glass substrate in that order. Simulation results of the electric field intensity distribution of the resonance mode for the stack sample are shown in Figs. 3(b) and 3(c). Fig. 3(c) shows an enlarged view of the circled area in Fig. 3(b). Thus, by arranging the first spacer layer (TPBi) and increasing its thickness $X_1$, the portion of the electric field intensity distribution on the electron injection section (Ag) is reduced, and the optical absorption loss in the electron injection section is thereby suppressed. Specifically, by using TPBi, which is transparent in the emission wavelength region of BSBCz, as a spacer, the electrode (Ag) is kept away from the light-emitting layer (BSBCx) to reduce the absorption loss by Ag of the electromagnetic waves emitted from the BSBCz. The invention adjusts at least one of the thickness and the refractive index of the

first spacer layer, which exhibits these effects, based on an absorption model.

For example, in one aspect of the invention, the relationship between the thickness of the first spacer layer and the absorption coefficient α of the stack sample is determined by the absorption model for the stack sample, and in that relationship, the thickness of the first spacer layer of the device is selected from the range of the thicknesses of the first spacer layer in which the absorption coefficient α is equal to or less than the set reference threshold.

The results of the relationship between the thickness of the TPBi spacer layer and the calculated absorption coefficient α and the measured ASE threshold (ASE Eth) for the stack sample shown in Fig. 3(a) are shown in Fig. 4. Thus, the calculated value of the absorption coefficient α and the measured value of the ASE threshold are in good agreement with the thickness dependence of the first spacer layer. Therefore, by selecting the thickness of the first spacer layer of the device from the range of thicknesses of the first spacer layer in which the calculated value of the absorption coefficient α is equal to or less than the set reference value, an organic electroluminescent device with a low optical absorption loss and a low ASE threshold, and also an organic solid-state semiconductor laser with a low laser oscillation threshold can be obtained.

In one aspect of the invention, the relationship between the refractive index of the first spacer layer and the absorption coefficient α of the stack sample is determined for the absorption model , and in that relationship, the refractive index of the first spacer layer of the device is selected from the range of the refractive index of the first spacer layer in which the absorption coefficient is equal to or less than the set reference threshold.

It is confirmed that the calculated value of the absorption coefficient α of the stack sample and the measured value of the ASE threshold are in good agreement in the refractive index dependence of the first spacer layer. Therefore, by selecting the refractive index of the first spacer layer of the device from the range of the refractive index of the first spacer layer in which the calculated value of the absorption coefficient α is equal to or less than the set reference value, it is possible to obtain an organic electroluminescent device with a low optical absorption loss and a low ASE threshold and also an organic solid-state semiconductor laser with a low laser oscillation threshold.

In one aspect of the invention, the relationship between the thickness of the first spacer layer and the absorption coefficient α of the stack sample is determined by the absorption model for the stack sample further having an optical resonator, and in that relationship, the thickness of the first spacer layer of the device is selected from the range of the thicknesses of the first spacer layer in which the absorption coefficient α is equal to or less than the set reference threshold.

It is confirmed that the calculated value of the absorption coefficient α of the stack sample and the measured value of the laser oscillation threshold are in good agreement in the thickness dependence of the first spacer layer. Therefore, by selecting the thickness of the first spacer layer of the device from the range of thicknesses of the first spacer layer where the calculated value of the absorption coefficient α is equal to or less than the set reference value, an organic solid-state semiconductor laser with a small optical absorption loss and a low laser oscillation threshold can be obtained.

In one aspect of the invention, the relationship between the refractive index of the first spacer layer and the absorption coefficient α of the stack sample is determined for the stack sample further having an optical resonator from the absorption model, and in that relationship, the refractive index of the first spacer layer of the device is selected from the range of the refractive index of the first spacer layer in which the absorption coefficient α is equal to or less than the set reference value.

It is confirmed that the calculated value of the absorption coefficient α of the stack sample and the measured value of the laser oscillation threshold are also in good agreement in the refractive index dependence of the first spacer layer. Therefore, by selecting the refractive index of the first spacer layer of the device from the range of the refractive index of the first spacer layer in which the calculated value of the absorption coefficient α is equal to or less than the set reference value, it is possible to obtain an organic solid-state semiconductor laser with a low optical absorption loss and a low laser oscillation threshold.

[Second Method]

The second method is a method for adjusting at least one of a thickness and a refractive index of the second spacer layer of an organic electroluminescent device, provided with a hole injection section of injecting holes, an electron injection section of injecting electrons, a light-emitting layer arranged between the hole injection section and the electron injection section to emit light by recombining holes and electrons, and a second spacer layer arranged between the light-emitting layer and the hole injection section, the method including:

adjusting at least one of the thickness and the refractive index of the second spacer layer using an absorption model.

For the description of the organic electroluminescent device targeted by the second method, the description in the [First Method] section above can be referred to. However, the organic electroluminescent devices targeted by the second method have the second spacer layer between the light-emitting layer and the hole injection section, and may or may not have the first spacer layer between the light-emitting layer and the electron injection section. In other words, the organic electroluminescent device targeted by the second method of the invention may have only the second spacer layer of the first and second spacer layers, or may have both the first and second spacer layers. Here, at least one of the

thickness and the refractive index of the first spacer layer can be adjusted using the above-mentioned first method. The second spacer layer corresponds to the "spacer layer" in the second embodiment. For the material for the second spacer layer, it is preferable to use a material with a low refractive index and a low light absorption relative to the light from the light-emitting layer, and NPD (refractive index n: 1.866 and extinction coefficient k: 0 relative to the emission wavelength of $BSBC_Z$) can be used preferably.

The absorption model used in the second method is, for example, an absorption model for a stack sample of the constituent members of the target organic electroluminescent device, in which the hole injection section, the second spacer layer and the light-emitting layer are stacked in that order. Here, at least one (preferably only one) of the thickness and the refractive index is varied for the second spacer layer, while the other layers are formed of the same material and the same thickness as the target organic electroluminescent device.

A specific example of the stack sample is shown in Fig. 5(a). The stack sample shown in Fig. 5(a) includes an ITO hole injection section (30 nm), an NPD spacer layer ($X_2$ nm), and a BSBCz light-emitting layer (200 nm) stacked on a glass substrate in that order. Simulation results of the electric field intensity distribution of the resonance mode for the stack sample are shown in Figs. 5(b) and 5(c). Fig. 5(c) shows an enlarged view of the circled area in Fig. 5(b). Thus, by arranging the second spacer layer (NPD) and increasing its thickness $X_2$, the portion of the electric field intensity distribution on the hole injection section (ITO) is reduced, and the optical absorption loss in the ITO hole injection section is thereby suppressed. Using NPD, which is transparent in the emission wavelength region of $BSBC_Z$, as a spacer, the electrode (ITO) is kept away from the light-emitting layer (BSBCz) to reduce the absorption loss by ITO of the electromagnetic waves emitted from the BSBCz. The invention adjusts at least one of the thickness and the refractive index of the second spacer layer, which exhibits these effects, based on the absorption model.

For example, in one aspect of the invention, the relationship between the thickness of the second spacer layer and the absorption coefficient $\alpha$ of the stack sample is determined for the stack sample, and in that relationship, the thickness of the second spacer layer of the device is selected from the range of the thicknesses of the second spacer layer in which the absorption coefficient $\alpha$ is equal to or less than the set reference threshold.

The results of the relationship between the thickness of the NPD spacer layer and the calculated absorption coefficient $\alpha$ and the measured ASE threshold (ASE Eth) for the stack sample shown in Fig. 5(a) are shown in Fig. 6. Thus, the calculated value of the absorption coefficient $\alpha$ and the measured value of the ASE threshold are in good agreement with the thickness dependence of the second spacer layer. Therefore, by selecting the thickness of the second spacer layer of the device from the range of thicknesses of the second spacer layer in which the calculated value of the absorption coefficient $\alpha$ is equal to or less than the set reference value, an organic electroluminescent device with a low optical absorption loss and a low ASE threshold, and also an organic solid-state semiconductor laser with a low laser oscillation threshold can be obtained.

In one aspect of the invention, the relationship between the refractive index of the second spacer layer and the absorption coefficient $\alpha$ of the stack sample is determined for the stack sample from the absorption model, and in that relationship, the refractive index of the second spacer layer of the device is selected from the range of the refractive index of the second spacer layer in which the absorption coefficient $\alpha$ is equal to or less than the set reference threshold.

It is confirmed that the calculated value of the absorption coefficient $\alpha$ of the stack sample and the measured value of the ASE threshold are in good agreement in the refractive index dependence of the second spacer layer. Therefore, by selecting the refractive index of the second spacer layer of the device from the range of the refractive index of the second spacer layer in which the calculated value of the absorption coefficient $\alpha$ is equal to or less than the set reference value, it is possible to obtain an organic electroluminescent device with a low optical absorption loss and a low ASE threshold and also an organic solid-state semiconductor laser with a low laser oscillation threshold.

In one aspect of the invention, the relationship between the thickness of the second spacer layer and the absorption coefficient $\alpha$ of the stack sample is determined by the absorption model for the stack sample further having an optical resonator, and in that relationship, the thickness of the second spacer layer of the device is selected from the range of the thicknesses of the second spacer layer in which the absorption coefficient $\alpha$ is equal to or less than the set reference threshold.

It is confirmed that the calculated value of the absorption coefficient $\alpha$ of the stack sample and the measured value of the laser oscillation threshold are in good agreement in the thickness dependence of the second spacer layer. Therefore, by selecting the thickness of the second spacer layer of the device from the range of thicknesses of the second spacer layer where the absorption coefficient $\alpha$ is equal to or less than the set reference value, an organic solid-state semiconductor laser with a small optical absorption loss and a low laser oscillation threshold can be fabricated.

In one aspect of the invention, the relationship between the refractive index of the second spacer layer and the absorption coefficient $\alpha$ of the stack sample is determined for the stack sample further having an optical resonator from the absorption model, and in that relationship, the refractive index of the second spacer layer of the device is selected from the range of the refractive index of the second spacer layer in which the absorption coefficient $\alpha$is equal to or less than the set reference value.

It is confirmed that the calculated value of the absorption coefficient $\alpha$ of the stack sample and the measured value

of the laser oscillation threshold are also in good agreement in the refractive index dependence of the second spacer layer. Therefore, by selecting the refractive index of the second spacer layer of the device from the range of the refractive index of the second spacer layer in which the calculated value of the absorption coefficient $\alpha$ is equal to or less than the set reference value, it is possible to obtain an organic solid-state semiconductor laser with a low optical absorption loss and a low laser oscillation threshold.

In the first and second methods, for example, the value of the absorption coefficient $\alpha$ at which the ASE threshold or laser oscillation threshold is sufficiently low can be used as the set reference value for the calculated value of the absorption coefficient $\alpha$.

Examples

The characteristics of the present invention will be explained more specifically with reference to Examples below. The materials, processes and procedures shown below can be appropriately modified unless they deviate from the substance of the invention. Accordingly, the scope of the present invention is not construed as being limited to the specific examples shown below. The light emission characteristics of the devices were evaluated using a spectrophotometer (Hamamatsu Photonics: PMA-50) with DC voltage or rectangular pulse voltage (pulse width: 400 ns, repetition frequency: 1 kHz) applied to the device, and the current density-voltage characteristics were evaluated using an integrating sphere system (Hamamatsu Photonics: A10094) at room temperature.

[1] Fabrication and evaluation of bottom-emission organic solid-state semiconductor lasers

(Example 1)

First, a second-order DFB diffraction grating was formed on a glass substrate with an anode containing indium tin oxide (ITO) with a film thickness of 30 nm by electron beam lithography using the following procedure.

After UV ozone treatment on the ITO surface, a 100 nm thick $SiO_2$ layer was formed by a sputtering method. Here, the sputtering method was performed with an argon pressure: 0.66 Pa, a temperature: 100°C, and an RF power: 100 W. The surface of the $SiO_2$ layer was cleaned and UV ozone treated, then hexamethyldisilazane (HMDS) was dropwise applied thereto for spin-coating at 4000 rpm for 15 seconds and annealed at 120 °C for 120 seconds. Then, a resist solution (ZEP520A-7 by ZEON Corporation) was dropwise applied onto the substrate and spin-coated at 4000 rpm for 30 seconds, followed by baking at 180 °C for 240 seconds to form a resist layer with a thickness of 70 nm. This resist layer was irradiated with an electron beam and treated with a developing solution (ZEON Corporation: ZEDN50) to form a resist mask with a lattice planar shape. Then, plasma etching using $CHF_3/O_2$ as the process gas was performed through this resist mask to remove the portion of the $SiO_2$ layer not covered by the resist mask to expose the ITO surface, thereby forming a second-order DFB diffraction grating. Here, the length of the portion of the grating protrusion that penetrates into the light-emitting layer (the penetration area) is 70 nm.

Next, thin films were stacked on the substrate with ITO (DFB substrate) on which the DFB diffraction grating was formed by a vacuum evaporation method (vacuum degree $1.5 \times 10^{-5}$ Pa) using the following procedure.

On top of the ITO and DFB diffraction grating, a 10 nm thick layer of HATCN was deposited to form a hole injection layer, and on top of that, a 20 nm thick layer of NPD was deposited to form a hole transport layer. Next, BSBCz was deposited to a thickness of 90 nm to form a light-emitting layer. Then, T2T was deposited to a thickness of 10 nm to form a hole-blocking layer, and TPBi was deposited to a thickness of 60 nm to form an electron transport layer on top of it. Then, LiF was deposited to a thickness of 1 nm, and on this, Al was deposited to a thickness of 1 nm, and further Ag was deposited to a thickness of 100 nm to form the cathode, resulting in fabricating a bottom emission type organic solid-state semiconductor laser (laser device 1). Finally, the fabricated organic solid-state semiconductor laser was encapsulated in a nitrogen-filled glove box using a glass lid and a UV-curable epoxy resin.

The energy level diagram of the fabricated laser device 1 is shown in Fig. 7. In Fig. 7, "HIL" represents a hole injection layer, "HTL" represents a hole transport layer, "EML" represents a light-emitting layer, "HBL" represents a hole-blocking layer, and "ETL" represents an electron transport layer.

(Example 2)

An organic solid-state semiconductor laser (laser device 2) was fabricated in the same way as in Example 1, in which the thickness of each layer was changed as in Table 1.

(Example 3)

An organic solid-state semiconductor laser (laser device 3) was fabricated in the same way as in Example 1, in

which the thickness of each layer was changed as shown in Table 1, the electron transport layer was not formed and a hole-blocking layer was formed of TPBi.

(Example 4)

An organic solid-state semiconductor laser (laser device 4) was fabricated in the same way as in Example 2, except that the light-emitting layer was formed by co-deposition of BSBCz and CBP. In this, the concentration of BSBCz was set at 5% by weight.

(Comparative Example 1)

An organic solid-state semiconductor laser having the same layer configuration as the laser device described in WO2018/147470 was fabricated by stacking thin films on a DFB substrate fabricated by the same procedure as in Example 1, using the vacuum deposition method.

Specifically, Cs and BSBCz were co-deposited on the ITO and diffraction grating of the DFB substrate to form a 60 nm thick layer, and on top of this, BSBCz was deposited to a thickness of 150 nm to form a light-emitting layer. In co-deposition, the concentration of BSBCz was 20% by weight. Subsequently, an anode was formed by depositing $MoO_3$, Ag, and Al to a thicknesses of 10 nm, 10 nm, and 90 nm, respectively, in that order, to fabricate an organic solid-state semiconductor laser (comparative laser device 1). The organic solid-state semiconductor laser was encapsulated in the same way as in Example 1.

Table 1

| | Anode | Hole Injection Layer | Hole Transport Layer | Light-Emitting Layer |
|---|---|---|---|---|
| Laser Device 1 | ITO (30 nm) | HATCN (10 nm) | NPD (20 nm) | BSBCz (90 nm) |
| Laser Device 2 | ITO (30 nm) | HATCN (10 nm) | NPD (20 nm) | BSBCz (70 nm) |
| Laser Device 3 | ITO (30 nm) | HATCN (5 nm) | NPD (5 nm) | BSBCz (195 nm) |
| Laser Device 4 | ITO (30 nm) | HATCN (10 nm) | NPD (20 nm) | 5wt% BSBCz,CBP (70 nm) |

Table 1 (continued)

| | Hole-Blocking Layer | Electron Transport Layer | Cathode |
|---|---|---|---|
| Laser Device 1 | T2T (10 nm) | TPBi (60 nm) | LiF (1 nm)/Al (1 nm)/Ag (100 nm) |
| Laser Device 2 | T2T (10 nm) | TPBi (80 nm) | LiF (1 nm)/Al (1 nm)/Ag (100 nm) |
| Laser Device 3 | TPBi (5 nm) | - | LiF (1 nm)/Al (1 nm)/Ag (100 nrn) |
| Laser Device 4 | T2T (10 nm) | TPBi (80 nm) | LiF (1 nm)/Al (1 nm)/Ag (100 nm) |

The calculated exciton density distributions of the laser devices 2 and 3 and the comparison laser device 1 are shown in Fig. 8. In Fig. 8, the horizontal axis represents the distance from the upper surface (cathode side surface) of the light-emitting layer, with positive numbers representing the distance from the top surface to the anode side (in the thickness direction of the light-emitting layer) and negative numbers representing the distance from the top surface to the cathode side (in the thickness direction of the hole-blocking layer). As shown in Fig. 8, in the comparative laser device 1 not having a hole-blocking layer, the exciton density is uniformly low throughout the entire light-emitting layer, suggesting that carrier recombination occurs sparsely throughout the light-emitting layer. In contrast, in the laser devices 2 and 3 each having the hole-blocking layer, the exciton density near the interface of the light-emitting layer with the hole-blocking layer is much higher than in other regions, indicating that carrier recombination occurs intensively near this interface.

Applying a 5 V or 10 V DC voltage to the laser device 1, the photonic band diagram, the emission spectrum, and the angular light intensity distribution were measured from the substrate side. The measurement results at 5 V are shown in Fig. 9(a) and at 10 V are shown in Fig. 9(b). Applying a DC voltage to the laser devices 2 to 4 and the comparative laser device 1, the photonic band diagram, the emission spectrum, and the angular light intensity distribution were measured from the substrate side while the emission spectrum was also measured with changing the applied voltage, and the measurement results are shown in Figs. 10 to 13. Here, the horizontal axis of the angular light intensity distribution (the upper light intensity distribution in each figure) indicates the light-receiving angle when the vertical direction to the substrate plane is 0°. The emission spectra (light intensity distributions on the right side of Figs. 9 and 12, and on the right and bottom sides of Figs. 10, 11, and 13) are light intensity distributions relative to wavelengths measured with the light-receiving angle set at 0°.

As shown in Fig. 13, in the emission spectrum of the comparative laser device 1 not having a hole-blocking layer, two emission peaks with a wide line width were observed while multiple broad peaks were observed over a wide angular range in the angular light intensity distribution. This means that the peak wavelength varies depending on the light-receiving angle. On the other hand, as shown in Fig. 4(b) and Figs. 10 to 12, in laser devices 1-4 each having a hole-blocking layer, a sharp peak with a narrow full-width half-maximum was observed in both the emission spectrum and the angular light intensity distribution when a voltages not lower than the laser oscillation threshold was applied. This indicates that the arrangement of the hole-blocking layer reduces both the peak width of the emission spectrum and the peak width of the angular light intensity distribution, and improves the laser efficiency and monochromaticity. Since equivalent emission spectra and angular light intensity distributions were observed with the laser device 2, which uses a single BSBCz film in the light-emitting layer, and with the laser device 4, which uses a doped BSBCz film, it is known that the light-emitting layer can contain a laser oscillation material alone or can contain a doped film of a laser oscillation material doped with a host material.

[2] Fabrication and evaluation of dual-emission organic solid-state semiconductor lasers (Examples 5 and 6)

A bottom-emission organic solid-state semiconductor laser (laser device 5) was fabricated in the same way as in Example 2, except that the cathode was changed to the DMD structure shown in Table 2.

An organic solid-state semiconductor laser (laser device 6) was fabricated in the same way, in which the thickness of Ag in the cathode was changed to 20 nm.

(Examples 7 and 8)

An organic solid-state semiconductor laser (laser device 7) was fabricated in the same way as in Example 5, except that the layer configuration of the cathode was changed as in Table 2.

An organic solid-state semiconductor laser (laser device 8) was fabricated in the same way, in which the thickness of Ag in the cathode was changed to 20 nm.

(Example 9)

An organic solid-state semiconductor laser (laser device 9) was fabricated in the same way as in Example 5, except that the layer configuration of the cathode was changed as in Table 2.

Table 2

| | Anode | Hole Injection Layer | Hole Transport Layer | Light-Emitting Layer |
|---|---|---|---|---|
| Laser Device 5 | ITO (30 nm) | HATCN (10 nm) | NPD (20 nm) | BSBCz (70 nm) |
| Laser Device 6 | ITO (30 nm) | HATCN (10 nm) | NPD (20 nm) | BSBCz (70 nm) |
| Laser Device 7 | ITO (30 nm) | HATCN (10 nm) | NPD (20 nm) | BSBCz (70 nm) |
| Laser Device 8 | ITO (30 nm) | HATCN (10 nm) | NPD (20 nm) | BSBCz (70 nm) |
| Laser Device 9 | ITO (30 nm) | HATCN (10 nm) | NPD (20 nm) | BSBCz (70 nm) |

Table 2 (continued)

| | Hole-Blocking Layer | Electron Transport Layer | Cathode |
|---|---|---|---|
| Laser Device 5 | T2T (10 nm) | TPBi (80 nm) | $MoO_3$ (5 nm)/Ag (15 nm)/$MoO_3$ (20 nm) |
| Laser Device 6 | T2T (10 nm) | TPBi (80 nm) | $MoO_3$ (5 nm)/Ag (20 nm)/$MoO_3$ (20 nm) |
| Laser Device 7 | T2T (10 nm) | TPBi (80 nm) | LiF (1 nm)/Al (1 nm)/Ag (15 nm) |
| Laser Device 8 | T2T (10 nm) | TPBi (80 nm) | LiF (1 nm)/Al (1 nm)/Ag (20 nm) |
| Laser Device 9 | T2T (10 nm) | TPBi (80 nm) | LiF (1 nm)/Al (1 nm)/$MoO_3$ (5 nm)/Ag (20 nm)/$MoO_3$ (20 nm) |

Applying a 40 V DC voltage to the laser devices 5 to 8, the photonic band diagram, the emission spectrum, and the

angular light intensity distribution were measured from the substrate side, and the results are shown in Figs. 14 to 17. The photonic band diagram, the emission spectrum, and the angular light intensity distribution of the laser device 9 are measured from the substrate side by applying a 40 V DC voltage, and the results are shown in Fig. 18(a), and the results from the cathode side are shown in Fig. 18(b). Here, the horizontal axis of the angular light intensity distribution (the upper light intensity distribution in each figure) indicates the light-receiving angle when the vertical direction to the substrate plane is 0°. The emission spectrum (light intensity distribution on the right side of each figure) is the light intensity distribution relative to the wavelength measured with the light-receiving angle set at 0°.

As shown in Figs. 14 to 18, in both the emission spectrum and the angular light intensity distribution of the dual-emission laser devices 5 to 9, a sharp peak with a narrow full-width half-maximum was observed. With the laser device 9, these narrow peaks were observed on both the substrate side and the cathode side. Consequently, it was found that the peak narrowing effect for the emission spectrum and the angular light intensity distribution by the hole-blocking layer is beneficial also in the dual-emission devices, and this enables the realization of dual-emission organic solid-state semiconductor laser devices with excellent laser characteristics.

(Example 10)

Thin films were stacked on a DFB substrate prepared by the same procedure as in Example 1, using the vacuum evaporation method at a vacuum degree of $1.5 \times 10^{-5}$ Pa.

First, a cathode having a stack structure ITO/Al/LiF was formed by depositing Al to a thickness of 1 nm on top of the ITO and DFB diffraction grating, followed by LiF to a thickness of 1 nm on top of it. Then, TPBi was deposited to a thickness of 80 nm to form an electron transport layer, and BSBCz was deposited to a thickness of 70 nm to form a light-emitting layer on top of it. Then, NPD was deposited to a thickness of 20 nm to form an electron-blocking layer, and HATCN was deposited to a thickness of 10 nm to form a hole injection layer on top of it. Subsequently, an anode having a DMD structure was formed by depositing $MoO_3$, Ag, and $MoO_3$ to a thicknesses of 5 nm, 20 nm, and 20 nm, respectively, in that order, to fabricate an organic solid-state semiconductor laser (laser device 10). The organic solid-state semiconductor laser was encapsulated in the same way as in Example 1.

In both the emission spectrum and the angular light intensity distribution of the laser device 10, a sharp peak with a narrow full-width half-maximum was observed.

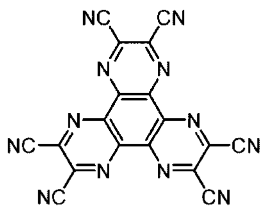

HATCN

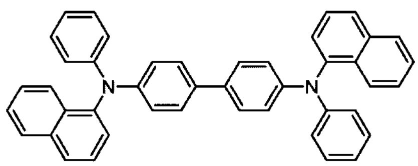

NPD

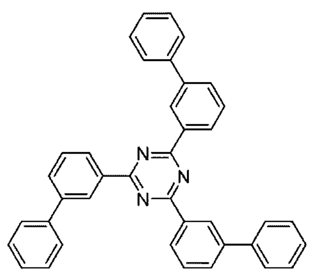

T2T

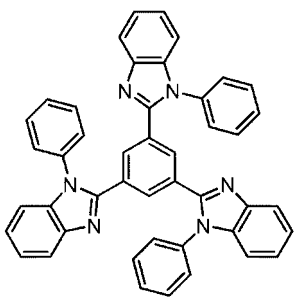

TPBi

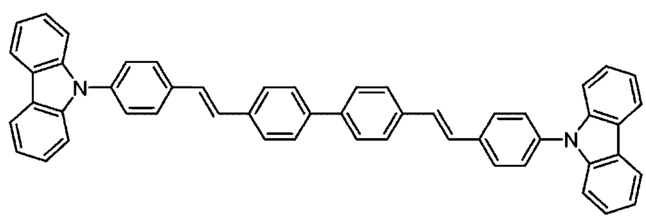

BSBCz

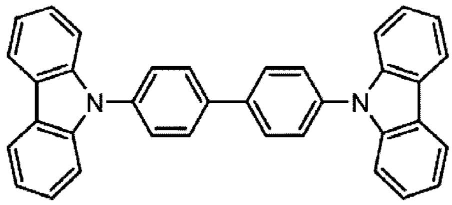

CBP

Industrial Applicability

The organic solid-state semiconductor laser of the invention can achieve high laser efficiency and excellent monochromaticity because both the peak width of the emission spectrum and the peak width of the angular light intensity distribution are small, and can be effectively used in various fields using laser light. Accordingly, the industrial applicability of the present invention is great.

Reference Signs List

11, 21 Hole injection section
12 Hole Injection Layer
13, 22 Hole Transport Layer
14, 24 Light-Emitting Layer
15 Hole-Blocking Layer
16, 25 Electron Transport Layer
17, 27 Electron injection section
18, 28 Diffraction Grating of Optical Resonator
23 Electron-Blocking Layer
26 Electron Injection Layer

## Claims

1. A method for narrowing a full-width half-maximum (FWHM) of an emission wavelength peak of an emission spectrum of an organic electroluminescent device provided with:

   a hole injection section of injecting holes,
   an electron injection section of injecting electrons, and
   a light-emitting layer of emitting light by recombining holes and electrons, wherein
   the light generated in the light-emitting layer propagates in a lateral direction of the light-emitting layer, the method comprising:
   arranging a recombination-active region along the lateral direction of the light-emitting layer.

2. A method for narrowing a full-width half-maximum (FWHM) of an emission wavelength peak of an emission spectrum of an organic electroluminescent device provided with:

   a hole injection section of injecting holes,
   an electron injection section of injecting electrons, and
   a light-emitting layer arranged between the hole injection section and the electron injection section to emit light by recombining holes and electrons, wherein
   the light generated in the light-emitting layer propagates in a lateral direction of the light-emitting layer, the method comprising:

      when a side of the light-emitting layer that is an exciton-dense region is on the electron injection section side, arranging a hole-blocking layer at a position between the light-emitting layer and the electron injection section and adjacent to the light-emitting layer; and

when the side of the light-emitting layer that is the exciton-dense region is on the hole injection section side, arranging an electron-blocking layer at a position between the light-emitting layer and the hole injection section and adjacent to the light-emitting layer.

3. The method according to claim 2, wherein the device is provided with a low refractive index layer with a lower refractive index than the light-emitting layer between the light-emitting layer and the hole injection section, and between the light-emitting layer and the electron injection section.

4. The method according to claim 2, wherein the position of the exciton-dense region in the light-emitting layer is determined by simulating an exciton density distribution in the light-emitting layer.

5. The method according to claim 2, wherein the organic electroluminescent device is further provided with an optical resonator that propagates the emitted light inside the light-emitting layer, and the organic electroluminescent device emits laser light.

6. The method according to claim 5, wherein the optical resonator has a diffraction grating.

7. The method according to claim 6, wherein the hole-blocking layer or the electron-blocking layer is formed along the flat interface of the light-emitting layer.

8. The method according to claim 6, wherein the diffraction grating is positioned between the exciton-dense region and the hole injection section, or between the exciton-dense region and the electron injection section.

9. The method according to claim 8, wherein:

when the device has a diffraction grating between the exciton-dense region and the hole injection section, the hole-blocking layer is positioned between the light-emitting layer and the electron injection section and adjacent to the light-emitting layer, and
when the device has a diffraction grating between the exciton-dense region and the electron injection section, the electron-blocking layer is positioned between the light-emitting layer and the hole injection section and adjacent to the light-emitting layer.

10. The method according to claim 2, wherein a spacer layer is arranged between at least any one of the hole injection section or the electron injection section, and the exciton-dense region.

11. An organic electroluminescent device fabricated by implementing the method described in any one of claims 1 to 10, wherein the full-width half-maximum (FWHM) of the emission wavelength peak of the emission spectrum is reduced.

12. An organic solid-state semiconductor laser fabricated by implementing the method described in claim 5, wherein the full-width half-maximum (FWHM) of the emission wavelength peak of the emission spectrum is reduced.

13. A method for adjusting at least one of a thickness and a refractive index of a first spacer layer of an organic electroluminescent device, provided with:

a hole injection section of injecting holes,
an electron injection section of injecting electrons,
a light-emitting layer arranged between the hole injection section and the electron injection section to emit light by recombining holes and electrons, and
a first spacer layer arranged between the light-emitting layer and the electron injection section, the method comprising:
adjusting at least one of the thickness and the refractive index of the first spacer layer using an absorption model.

14. The method according to claim 13, wherein at least one of the thickness and the refractive index of the first spacer layer of the organic electroluminescent device is adjusted using an absorption model for a stack sample formed by stacking a light-emitting layer, a first spacer layer, and an electron injection section in that order.

15. The method according to claim 14, wherein the stack sample further has an optical resonator, and at least one of the thickness and the refractive index of the first spacer layer of the organic electroluminescent device is adjusted using an

absorption model for the stack sample.

**16.** The method according to claim 14, wherein a relationship between the thickness of the first spacer layer and the absorption coefficient of the stack sample is determined for the stack sample using the absorption model, and in this relationship, the thickness of the first spacer layer of the organic electroluminescent device is selected from the range of the thicknesses of the first spacer layer for which the absorption coefficient is equal to or less than a set reference threshold.

**17.** The method according to claim 14, wherein a relationship between the refractive index of the first spacer layer and the absorption coefficient of the stack sample is determined for the stack sample using the absorption model, and in this relationship, the refractive index of the first spacer layer of the organic electroluminescent device is selected from the range of the refractive index of the first spacer layer for which the absorption coefficient is equal to or less than a set reference threshold.

**18.** A method for adjusting at least one of a thickness and a refractive index of a second spacer layer of an organic electroluminescent device provided with:

a hole injection section of injecting holes,
an electron injection section of injecting electrons,
a light-emitting layer arranged between the hole injection section and the electron injection section to emit light by recombining holes and electrons, and
a second spacer layer arranged between the light-emitting layer and the hole injection section, the method comprising: adjusting at least one of the thickness and the refractive index of the second spacer layer using an absorption model.

**19.** The method according to claim 18, wherein at least one of the thickness and the refractive index of the second spacer layer of the organic electroluminescent device is adjusted using an absorption model for a stack sample formed by stacking a hole injection section, a second spacer layer and a light-emitting layer in that order.

**20.** The method according to claim 19, wherein the stack sample further has an optical resonator, and at least one of the thickness and the refractive index of the second spacer layer of the organic electroluminescent device is adjusted using an absorption model for the stack sample.

**21.** The method according to claim 19, wherein a relationship between the thickness of the second spacer layer and the absorption coefficient of the stack sample is determined for the stack sample using the absorption model, and in this relationship, the thickness of the second spacer layer of the organic electroluminescent device is selected from the range of the thicknesses of the second spacer layer for which the absorption coefficient is equal to or less than a set reference threshold.

**22.** The method according to claim 19, wherein a relationship between the refractive index of the second spacer layer and the absorption coefficient of the stack sample is determined for the stack sample using the absorption model, and in this relationship, the refractive index of the second spacer layer of the organic electroluminescent device is selected from the range of the refractive index of the second spacer layer for which the absorption coefficient is equal to or less than a set reference threshold.

**23.** An organic electroluminescent device, fabricated by implementing the method described in any one of claims 13 to 22.

**24.** An organic solid-state semiconductor laser, fabricated by implementing the method described in claim 13.

**25.** An organic solid-state semiconductor laser, fabricated by implementing the method described in claim 18.

**26.** An organic solid-state semiconductor laser comprising:

a hole injection section of injecting holes;
an electron injection section of injecting electrons;
a light-emitting layer arranged between the hole injection section and the electron injection section to emit light by recombining holes and electrons; and
an optical resonator that propagates the emitted light inside the light-emitting layer,

the organic solid-state semiconductor laser comprising
a hole-blocking layer on the electron injection section side of the light-emitting layer so as to be adjacent to the light-emitting layer, or
an electron-blocking layer on the hole injection section side of the light-emitting layer so as to be adjacent to the light-emitting layer.

**27.** The organic solid-state semiconductor laser according to any one of claims 12, and 24 to 26, having a hole-blocking layer on the electron injection section side of the light-emitting layer so as to be adjacent to the light-emitting layer.

**28.** The organic solid-state semiconductor laser according to claim 27, wherein the absolute value of the HOMO energy of the hole-blocking layer is greater than the absolute value of the HOMO energy of the light-emitting layer.

**29.** The organic solid-state semiconductor laser according to claim 27, wherein the absolute value of the HOMO energy of the hole-blocking layer is greater by at least 0.1 eV than the absolute value of the HOMO energy of the light-emitting layer.

**30.** The organic solid-state semiconductor laser according to claim 27, having one or more layers between the hole-blocking layer and the electron injection section.

**31.** The organic solid-state semiconductor laser according to any one of claims 12, and 24 to 26, wherein the hole mobility of the light-emitting layer is greater by at least 10 times than the electron mobility thereof.

**32.** The organic solid-state semiconductor laser according to any one of claims 12, and 24 to 26, wherein the light-emitting layer contains a laser oscillation material and a dopant material.

**33.** The organic solid-state semiconductor laser according to any one of claims 12, and 24 to 26, wherein the thickness of the light-emitting layer is 10 nm or more and less than 200 nm.

**34.** The organic solid-state semiconductor laser according to any one of claims 12, and 24 to 26, wherein a full-width half-maximum of an emission angle peak is 10 degrees or less, and the full-width half-maximum of the emission wavelength peak is 10 nm or less.

**35.** The organic solid-state semiconductor laser according to any one of claims 12, and 24 to 26, wherein at least one of the electron injection section and the hole injection section is an electrode having a visible light transmittance of 10% or more.

**36.** The organic solid-state semiconductor laser according to any one of claims 12, and 24 to 26, wherein the light generated in the light-emitting layer propagates in the lateral direction of the light-emitting layer.

**37.** The organic solid-state semiconductor laser according to claim 36, wherein the device is provided with a low refractive index layer with a lower refractive index than the light-emitting layer between the light-emitting layer and the hole injection section, and between the light-emitting layer and the electron injection section.

**38.** The organic solid-state semiconductor laser according to claim 26, wherein the optical resonator has a diffraction grating.

**39.** The organic solid-state semiconductor laser according to claim 38, wherein the hole-blocking layer or the electron-blocking layer is formed along the flat interface of the light-emitting layer.

**40.** The organic solid-state semiconductor laser according to claim 38, wherein the base edge of the diffraction grating is located at an interface on the hole injection section side of the light-emitting layer or is located on the hole injection section side than the interface, and the hole-blocking layer is located between the light-emitting layer and the electron injection section and adjacent to the light-emitting layer.

**41.** The organic solid-state semiconductor laser according to claim 38, wherein the base edge of the diffraction grating is located at an interface on the electron injection section side of the light-emitting layer or is located on the electron injection section side than the interface, and
the electron-blocking layer is located between the light-emitting layer and the hole injection section and adjacent to the

light-emitting layer.

**42.** The organic solid-state semiconductor laser according to any one of claims 12, and 24 to 26, which is a top emission type.

**43.** The organic solid-state semiconductor laser according to any one of claims 12, and 24 to 26, which is a bottom emission type.

**44.** The organic solid-state semiconductor laser according to any one of claims 12, and 24 to 26, which is a dual emission type.

**45.** The organic solid-state semiconductor laser according to any one of claims 12, and 24 to 26, which is an edge emission type.

[FIG. 1]

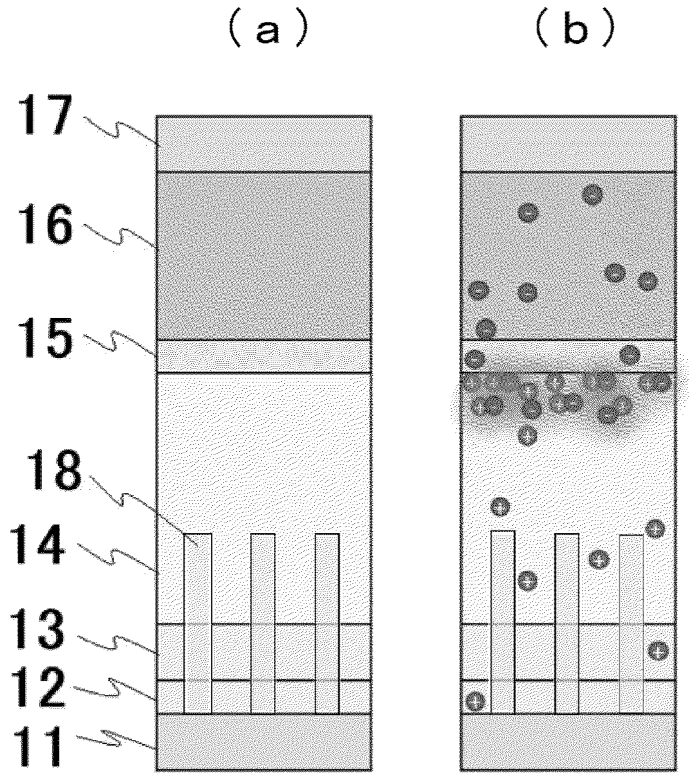


[FIG. 2]

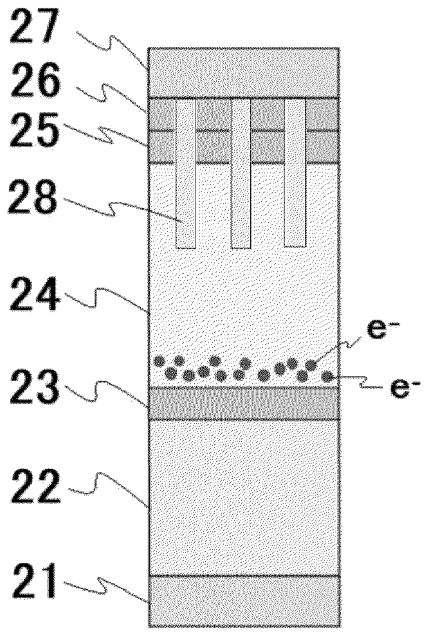

[FIG. 3]

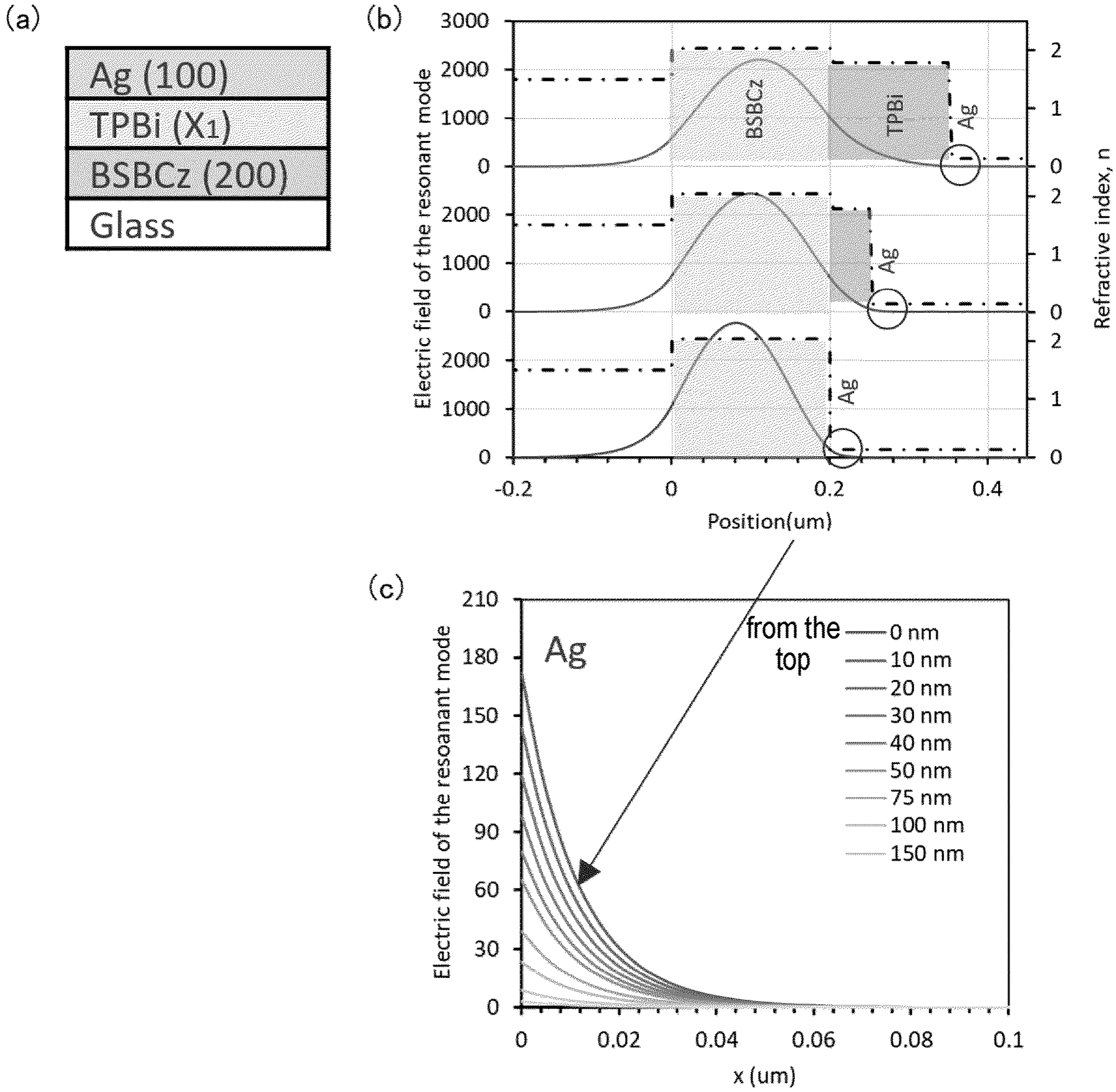
(a)
Ag (100)
TPBi (X1)
BSBCz (200)
Glass
(b)
Electric field of the resonant mode
Refractive index, n
BSBCz
TPBi
Ag
Position(um)
(c)
Ag
from the top
0 nm
10 nm
20 nm
30 nm
40 nm
50 nm
75 nm
100 nm
150 nm
Electric field of the resoanant mode
x (um)

[FIG. 4]

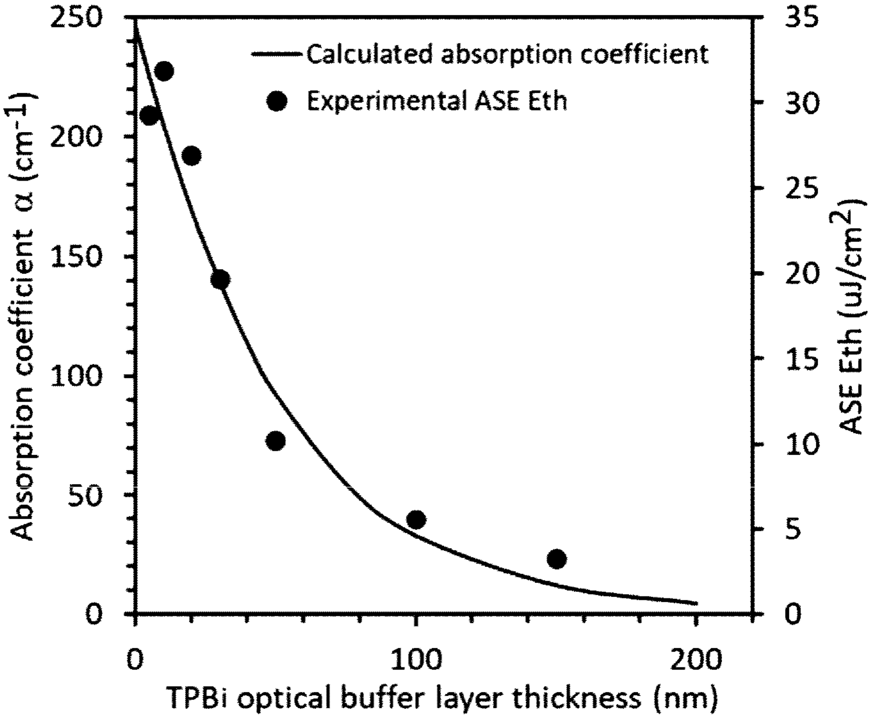

Calculated absorption coefficient
Experimental ASE Eth
Absorption coefficient α (cm-1)
ASE Eth (uJ/cm2)
TPBi optical buffer layer thickness (nm)
0
50
100
150
200
250
5
10
15
20
25
30
35

[FIG. 5]

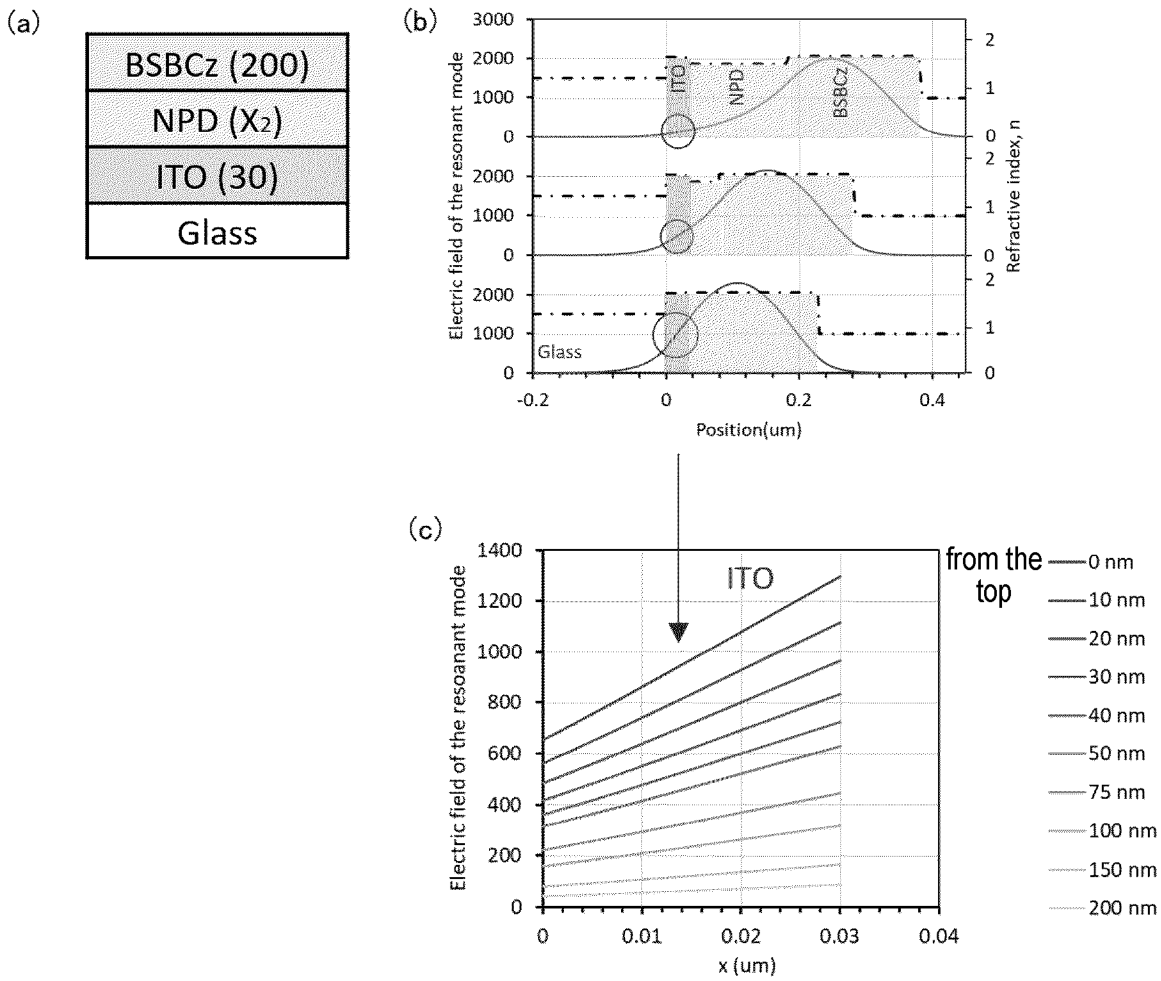
(a)
BSBCz (200)
NPD (X2)
ITO (30)
Glass
(b)
Electric field of the resonant mode
Refractive index, n
ITO
NPD
BSBCz
Glass
Position(um)
(c)
Electric field of the resoanant mode
ITO
x (um)
from the top
0 nm
10 nm
20 nm
30 nm
40 nm
50 nm
75 nm
100 nm
150 nm
200 nm

[FIG. 6]

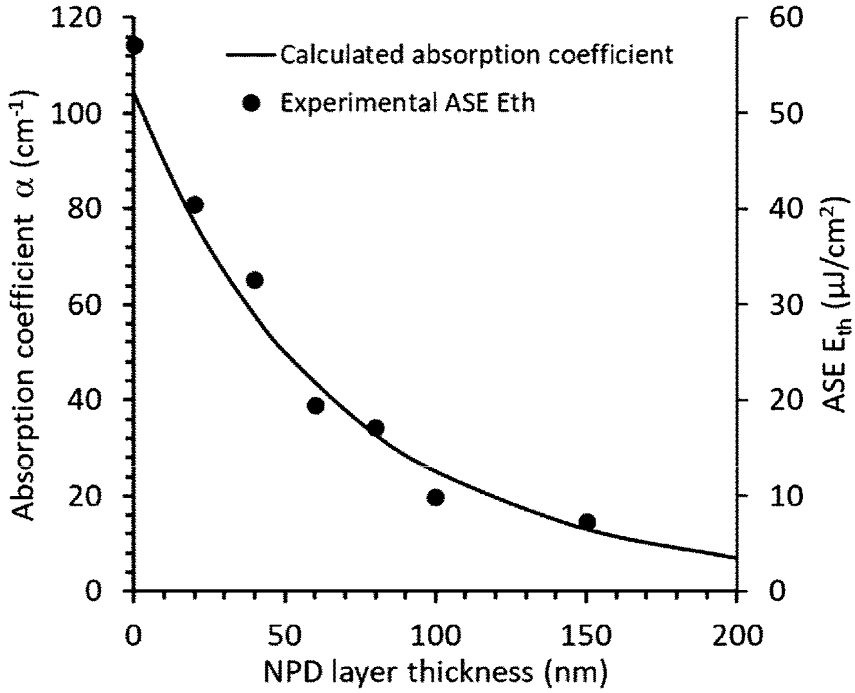
120
100
80
60
40
20
0
Absorption coefficient α (cm-1)
60
50
40
30
20
10
0
ASE Eth (μJ/cm2)
Calculated absorption coefficient
Experimental ASE Eth
0
50
100
150
200
NPD layer thickness (nm)

[FIG. 7]

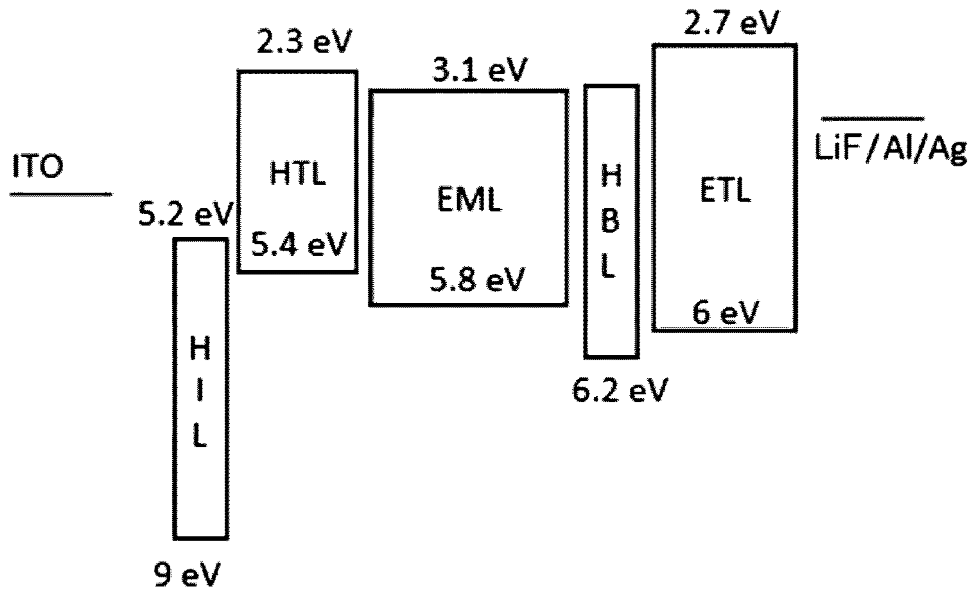
ITO
5.2 eV
HIL
9 eV
2.3 eV
HTL
5.4 eV
3.1 eV
EML
5.8 eV
HBL
6.2 eV
2.7 eV
ETL
6 eV
LiF/Al/Ag

[FIG. 8]

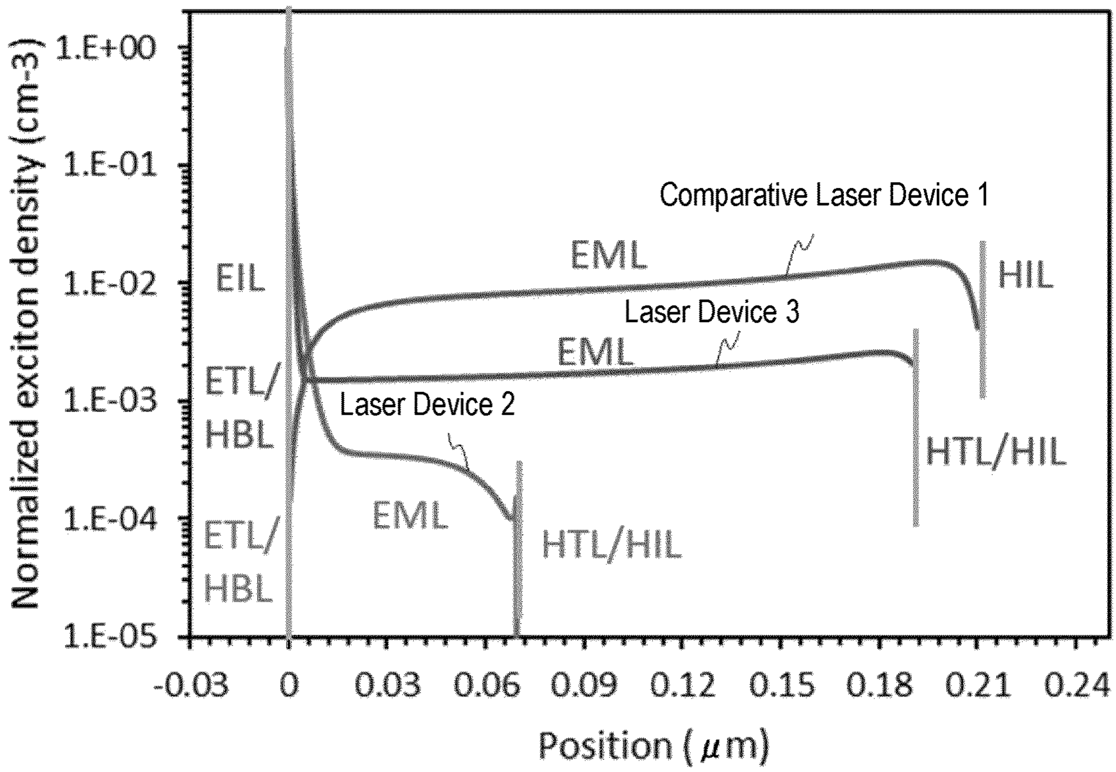
Normalized exciton density (cm-3)
1.E+00
1.E-01
1.E-02
1.E-03
1.E-04
1.E-05
-0.03
0
0.03
0.06
0.09
0.12
0.15
0.18
0.21
0.24
Position (μm)
EIL
ETL/ HBL
ETL/ HBL
EML
EML
EML
HIL
HTL/HIL
HTL/HIL
Comparative Laser Device 1
Laser Device 3
Laser Device 2

[FIG. 9]

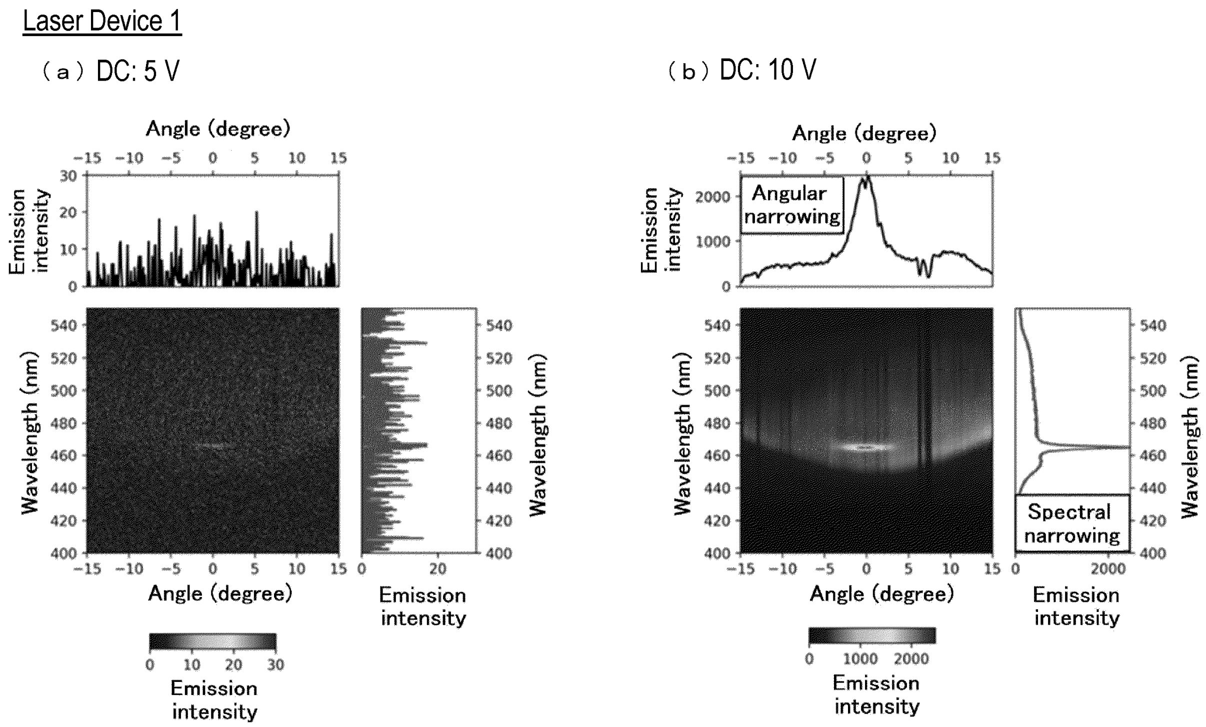
Laser Device 1
(a) DC: 5 V
(b) DC: 10 V
Angle (degree)
Emission intensity
Wavelength (nm)
Angular narrowing
Spectral narrowing

[FIG. 10]

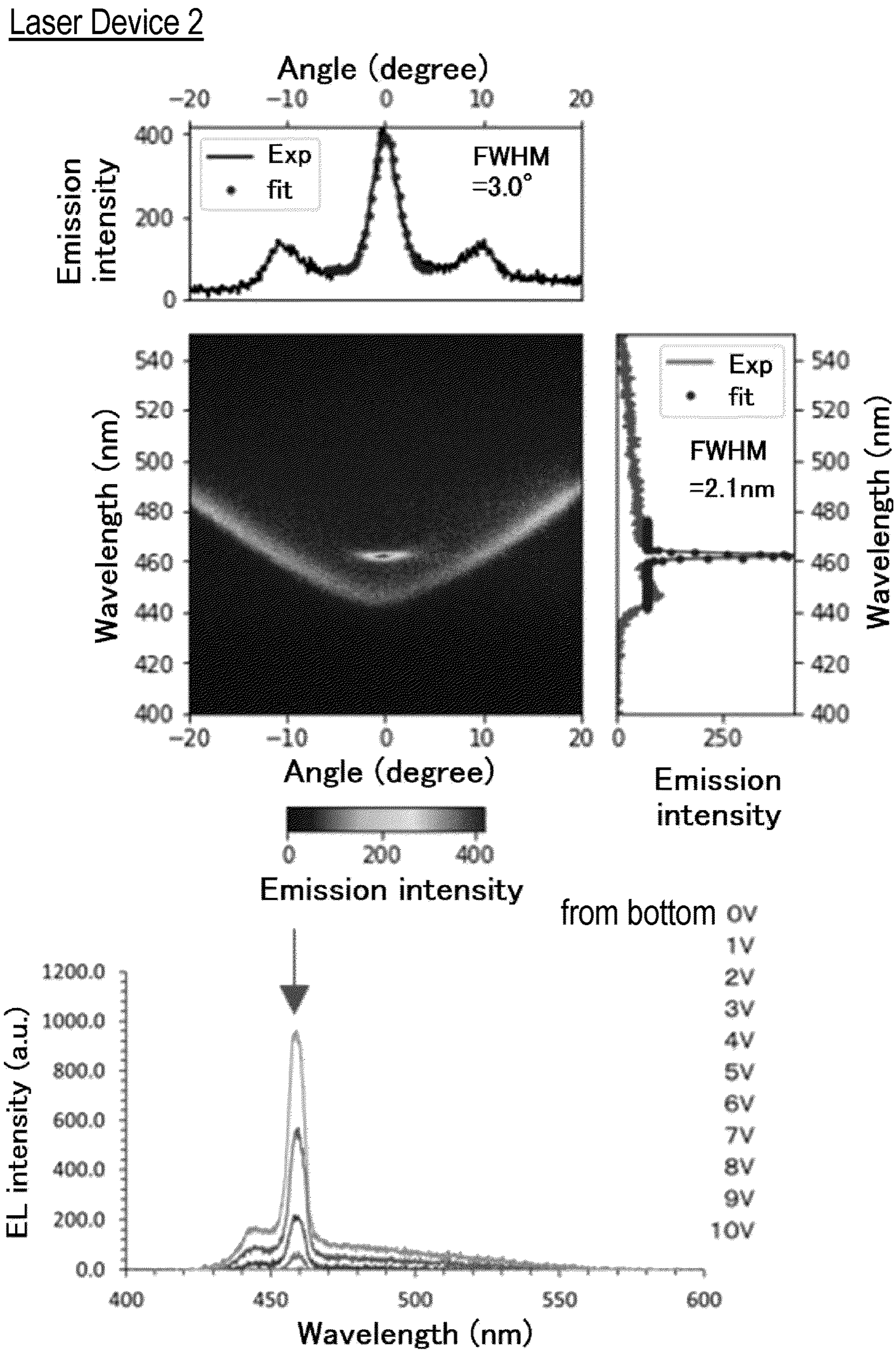
Laser Device 2
Angle (degree)
Emission intensity
Exp
fit
FWHM =3.0°
Wavelength (nm)
Exp
fit
FWHM =2.1nm
Wavelength (nm)
Angle (degree)
Emission intensity
Emission intensity
from bottom 0V
1V
2V
3V
4V
5V
6V
7V
8V
9V
10V
EL intensity (a.u.)
Wavelength (nm)

[FIG. 11]

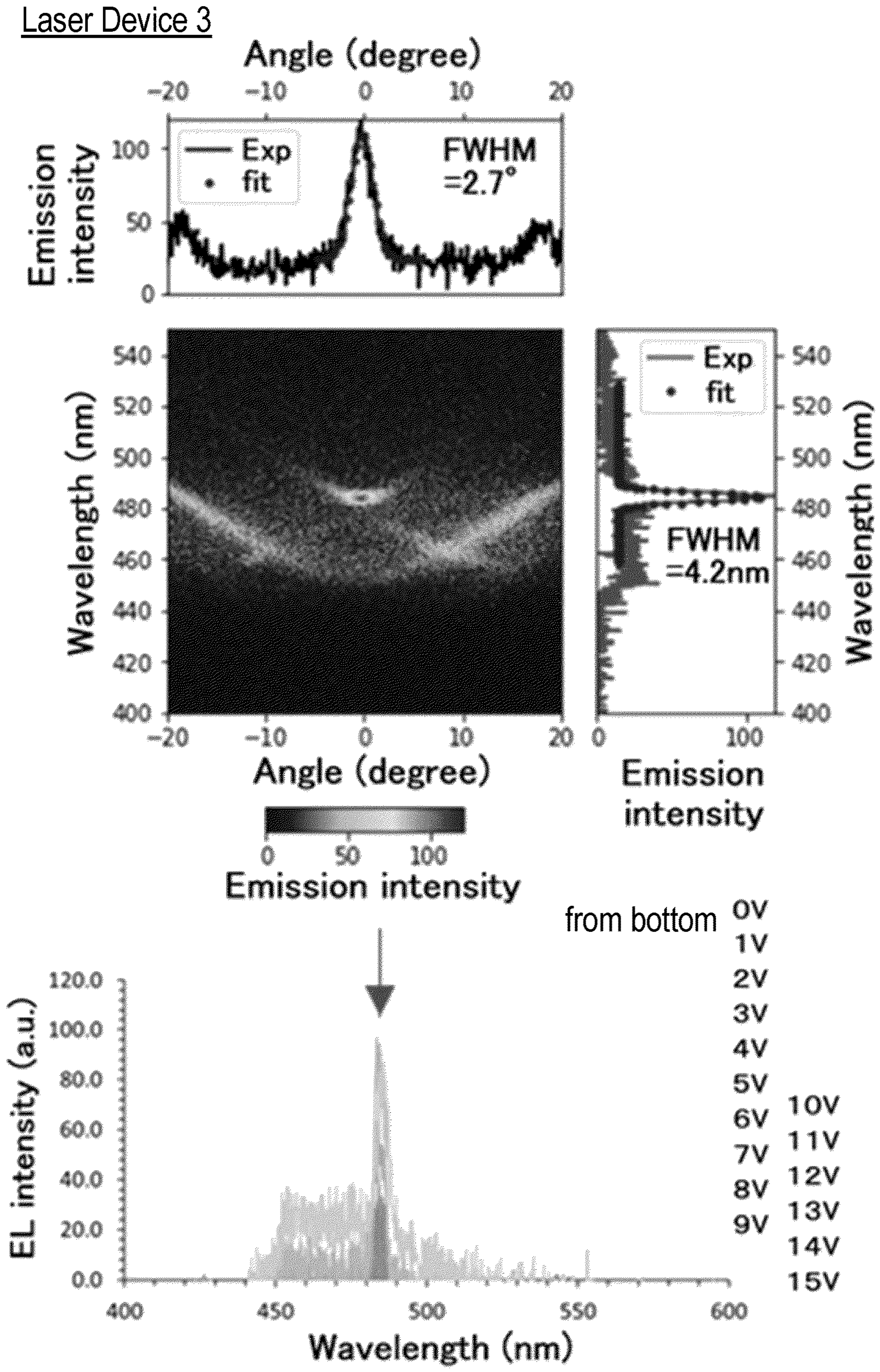
Laser Device 3
Angle (degree)
-20 -10 0 10 20
Emission intensity
0 50 100
Exp
fit
FWHM =2.7°
Wavelength (nm)
400 420 440 460 480 500 520 540
-20 -10 0 10 20
Angle (degree)
0 100
Emission intensity
FWHM =4.2nm
0 50 100
Emission intensity
from bottom
0V 1V 2V 3V 4V 5V 6V 7V 8V 9V 10V 11V 12V 13V 14V 15V
EL intensity (a.u.)
0.0 20.0 40.0 60.0 80.0 100.0 120.0
400 450 500 550 600
Wavelength (nm)

[FIG. 12]

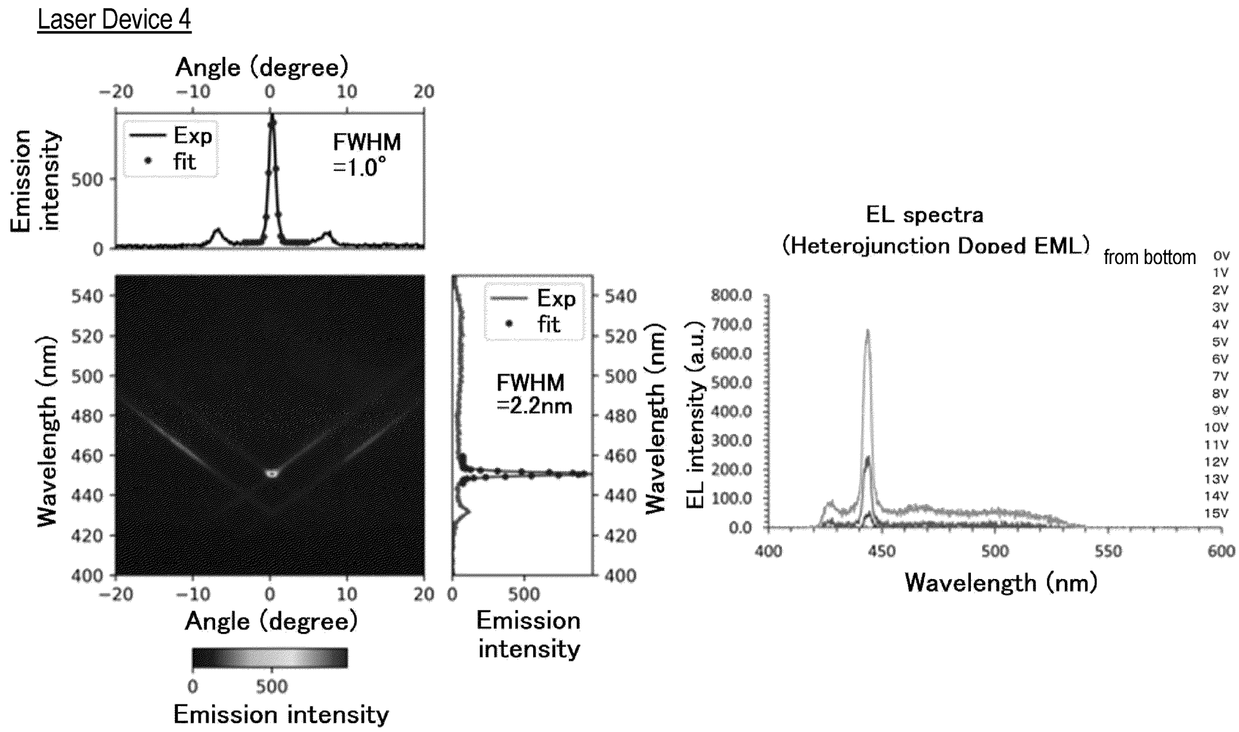
Laser Device 4
Angle (degree)
Emission intensity
Exp
fit
FWHM =1.0°
Wavelength (nm)
Exp
fit
FWHM =2.2nm
Angle (degree)
Emission intensity
Emission intensity
EL spectra
(Heterojunction Doped EML)
from bottom
0V
1V
2V
3V
4V
5V
6V
7V
8V
9V
10V
11V
12V
13V
14V
15V
EL intensity (a.u.)
Wavelength (nm)

[FIG. 13]

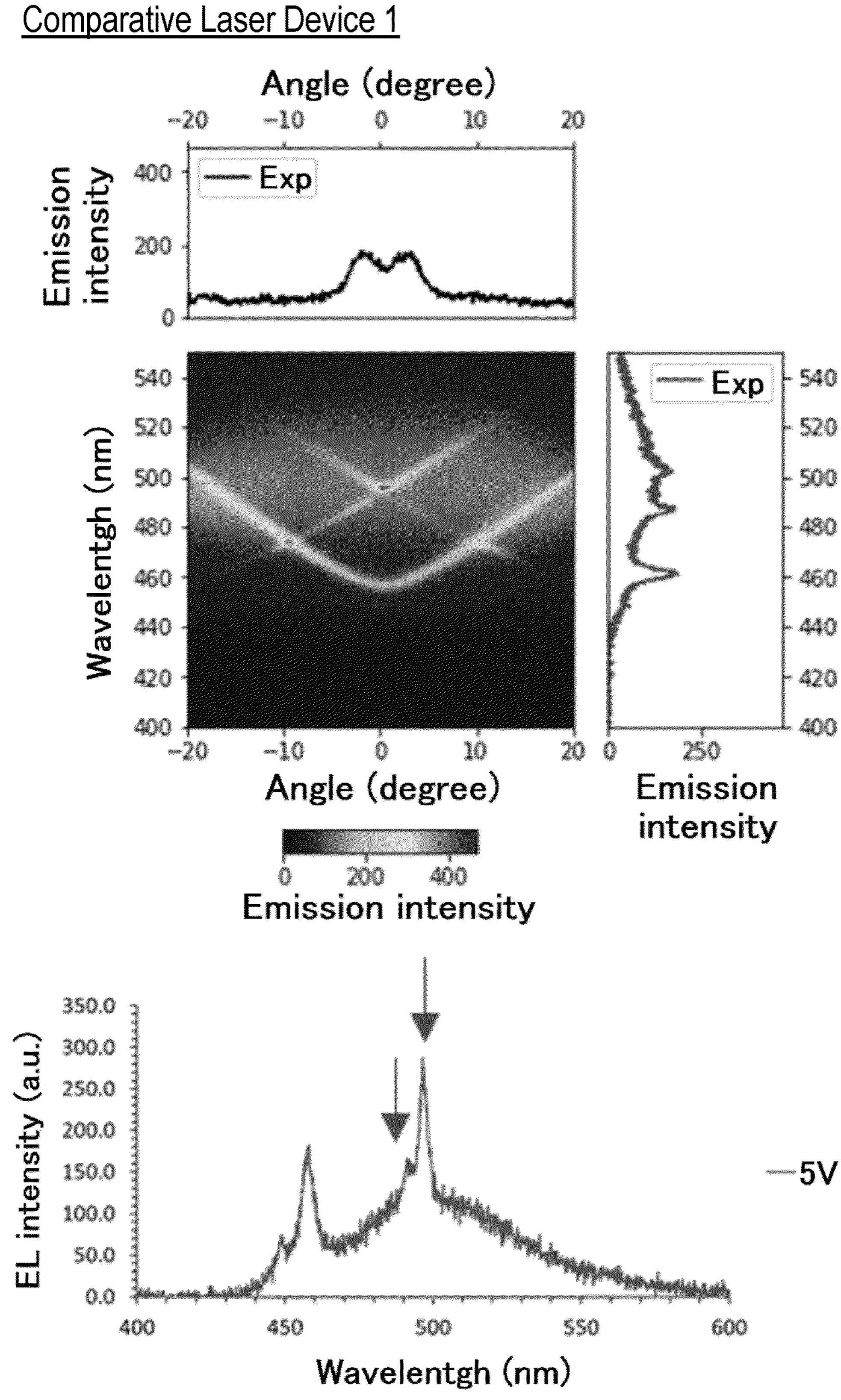
Comparative Laser Device 1
Angle (degree)
-20
-10
0
10
20
Emission intensity
400
200
0
Exp
540
520
500
480
460
440
420
400
Wavelentgh (nm)
Angle (degree)
0
250
Emission intensity
0
200
400
Emission intensity
EL intensity (a.u.)
350.0
300.0
250.0
200.0
150.0
100.0
50.0
0.0
400
450
500
550
600
Wavelentgh (nm)
5V

[FIG. 14]

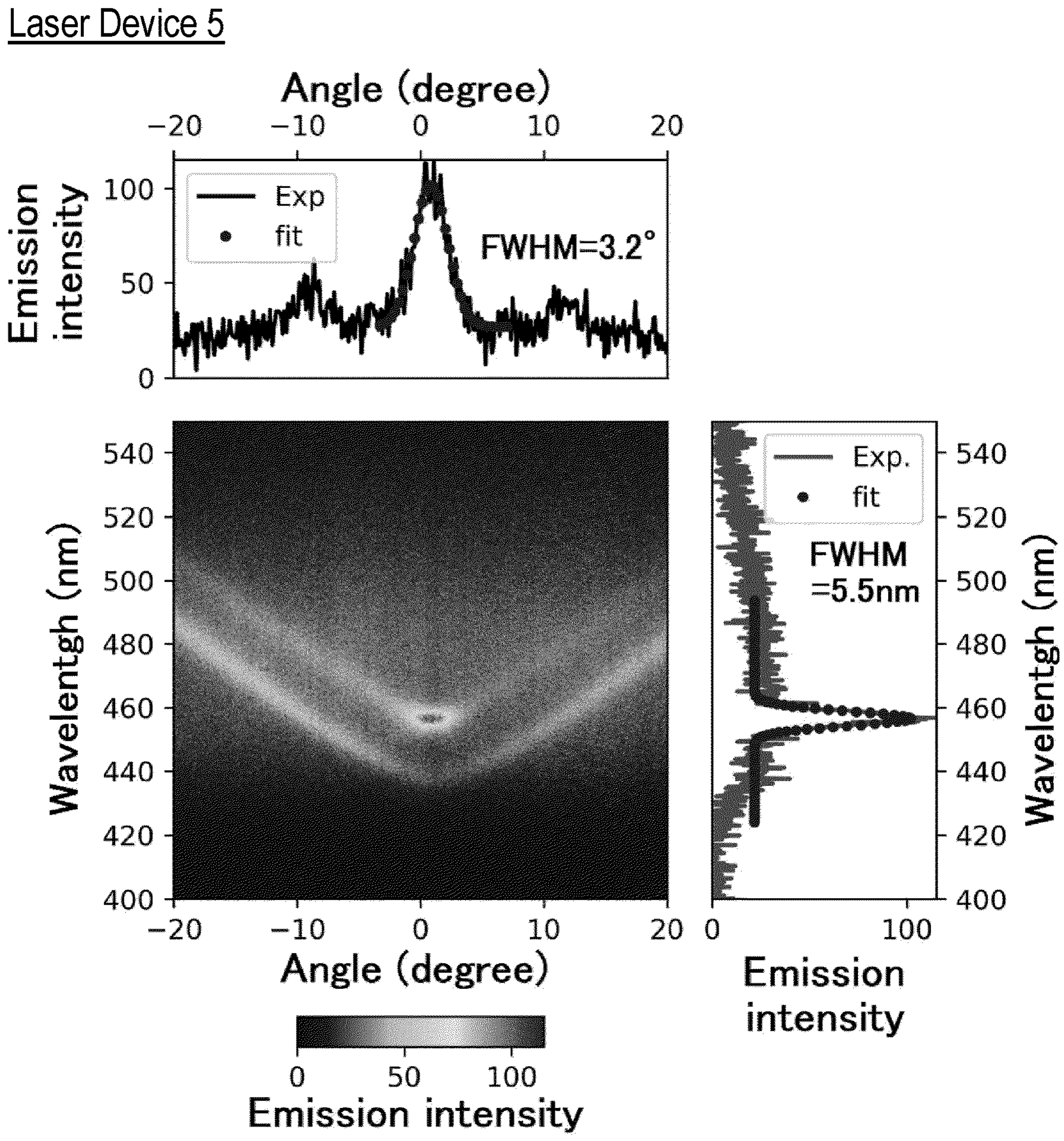
Laser Device 5
Angle (degree)
−20
−10
0
10
20
Emission intensity
100
50
0
Exp
fit
FWHM=3.2°
540
520
500
480
460
440
420
400
Wavelentgh (nm)
Angle (degree)
Exp.
fit
FWHM
=5.5nm
Emission intensity
0
50
100
Emission intensity

[FIG. 15]

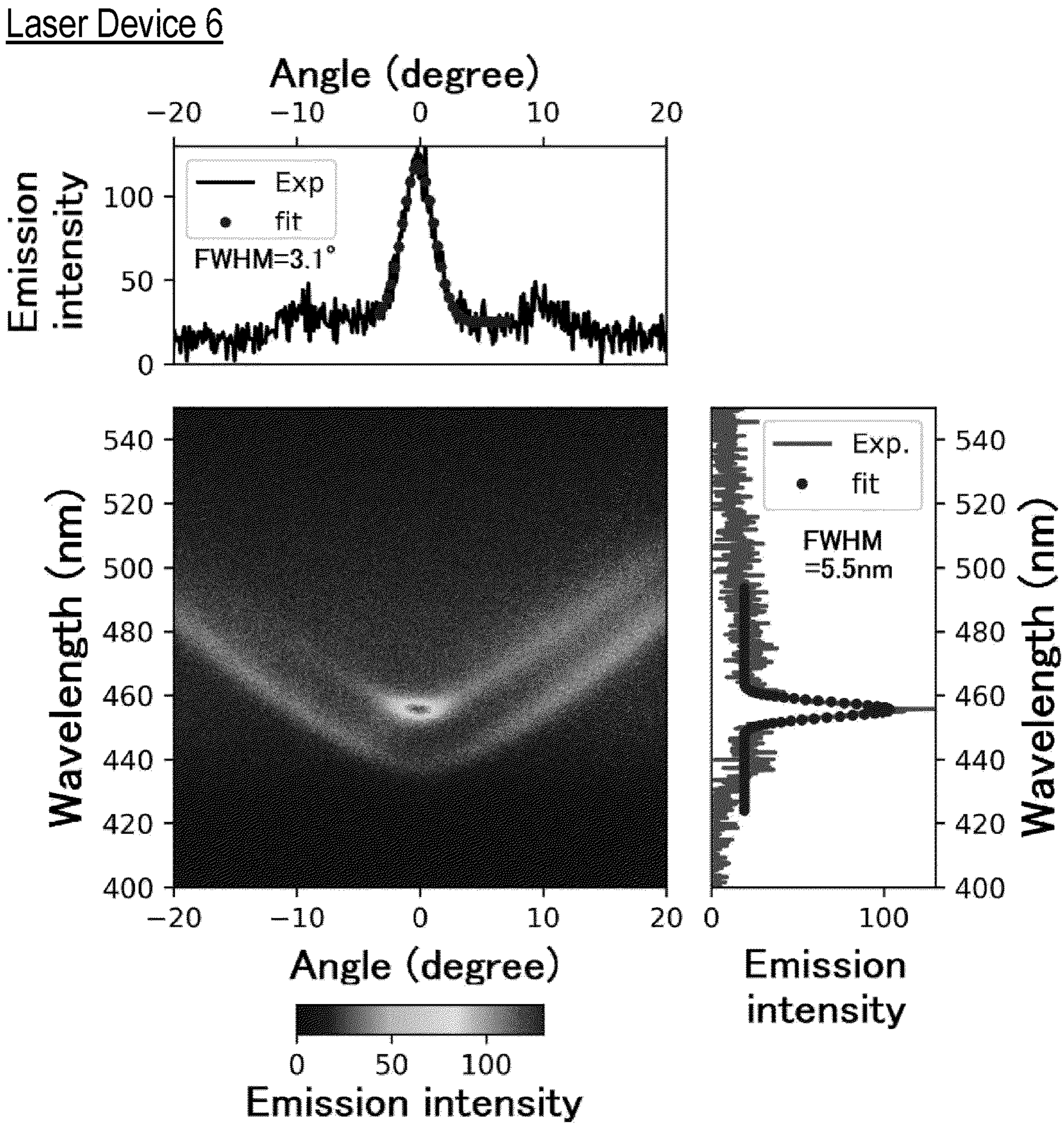
Laser Device 6
Angle (degree)
−20
−10
0
10
20
Emission intensity
100
50
0
Exp
fit
FWHM=3.1°
540
520
500
480
460
440
420
400
Wavelength (nm)
Angle (degree)
Exp.
fit
FWHM
=5.5nm
Emission intensity
0
50
100
Emission intensity

[FIG. 16]

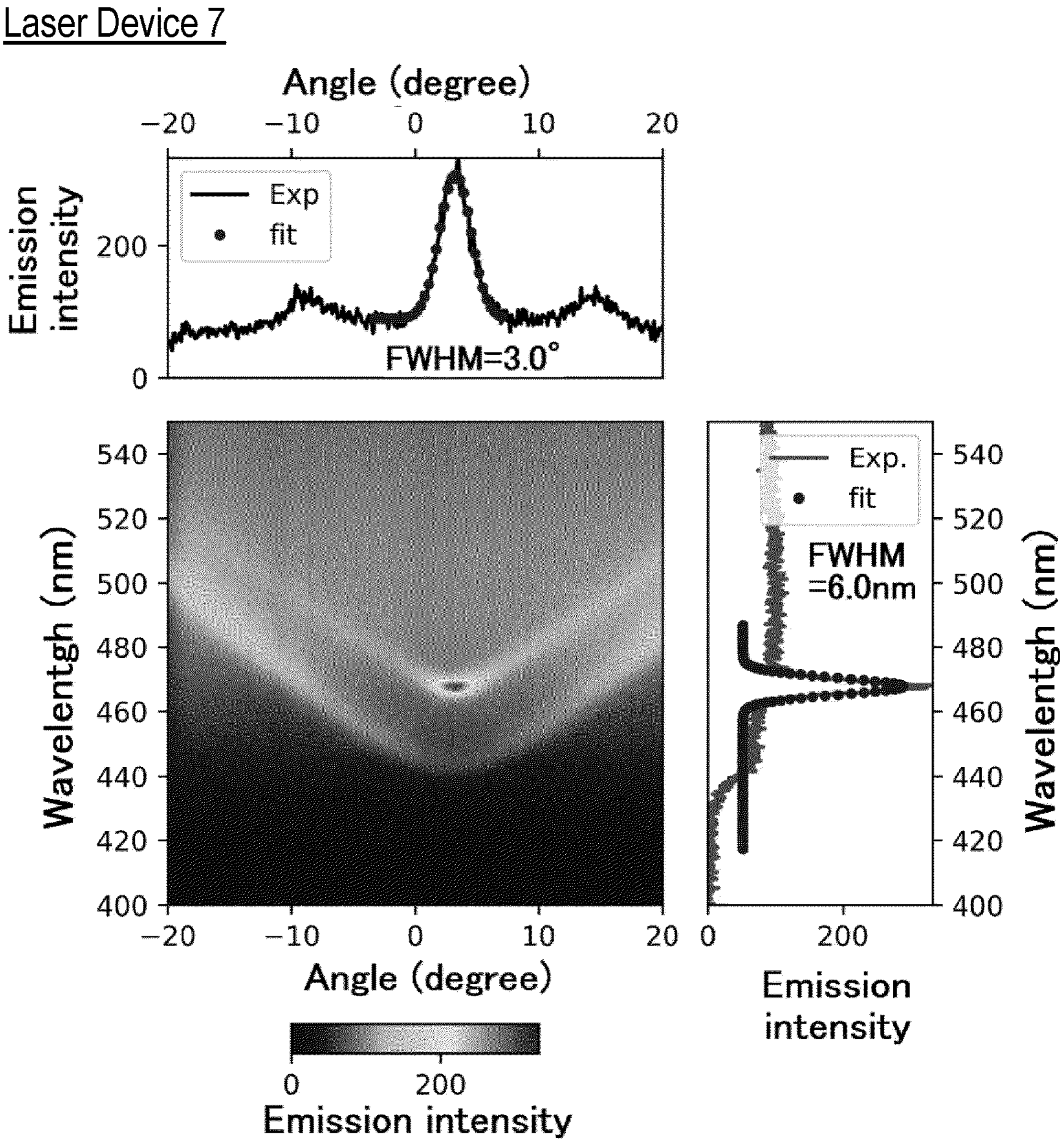
Laser Device 7
Angle (degree)
−20
−10
0
10
20
Emission intensity
200
0
Exp
fit
FWHM=3.0°
540
520
500
480
460
440
420
400
Wavelentgh (nm)
Angle (degree)
Exp.
fit
FWHM =6.0nm
Emission intensity
0
200
Emission intensity

[FIG. 17]

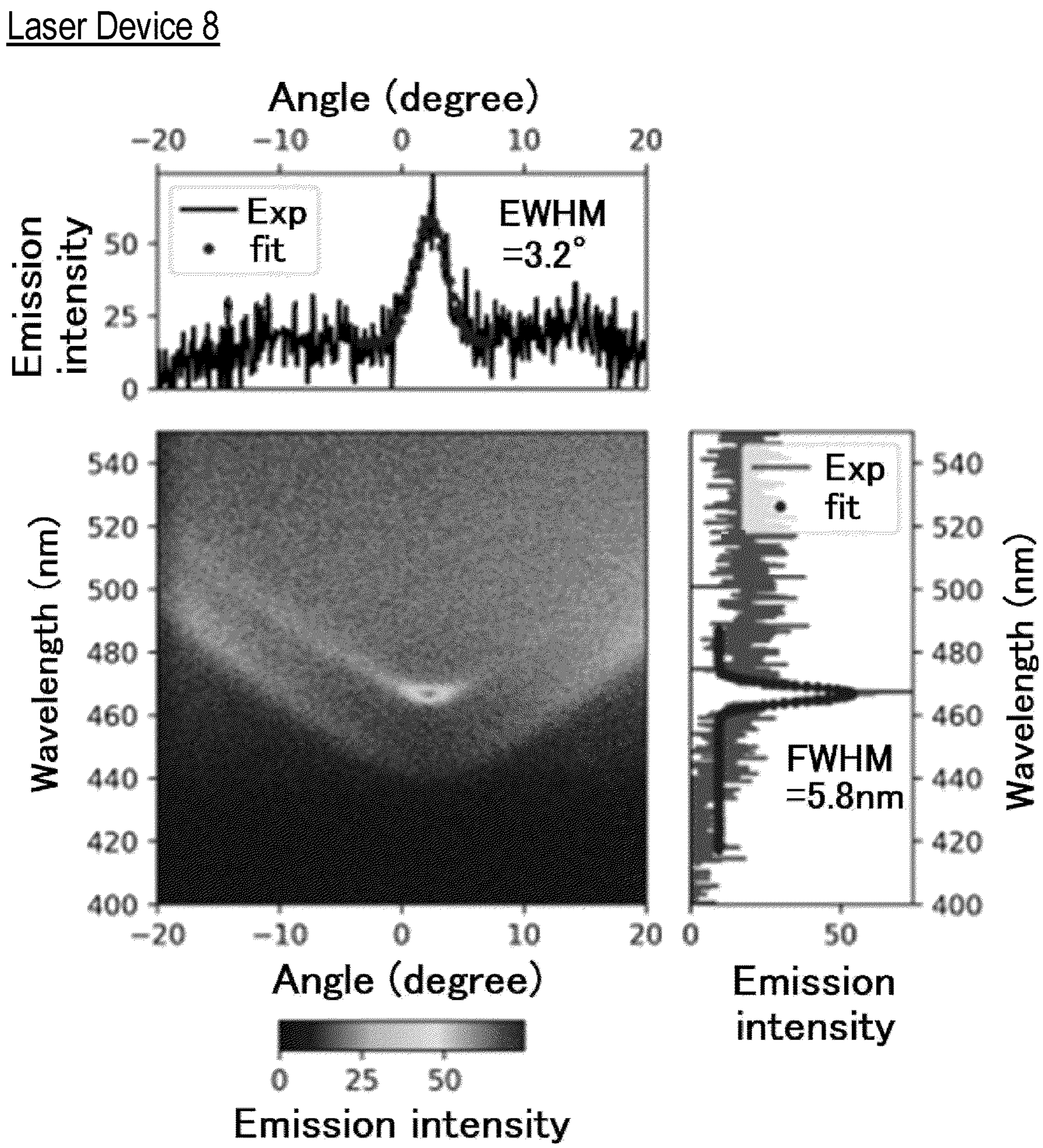
Laser Device 8
Angle (degree)
-20 -10 0 10 20
Emission intensity
0 25 50
Exp
fit
EWHM
=3.2°
Wavelength (nm)
400 420 440 460 480 500 520 540
FWHM
=5.8nm
Angle (degree)
Emission intensity
Emission intensity

[FIG. 18]

Laser Device 9

(a) Light-Received from Substrate Side

(b) Light-Received from Cathode Side

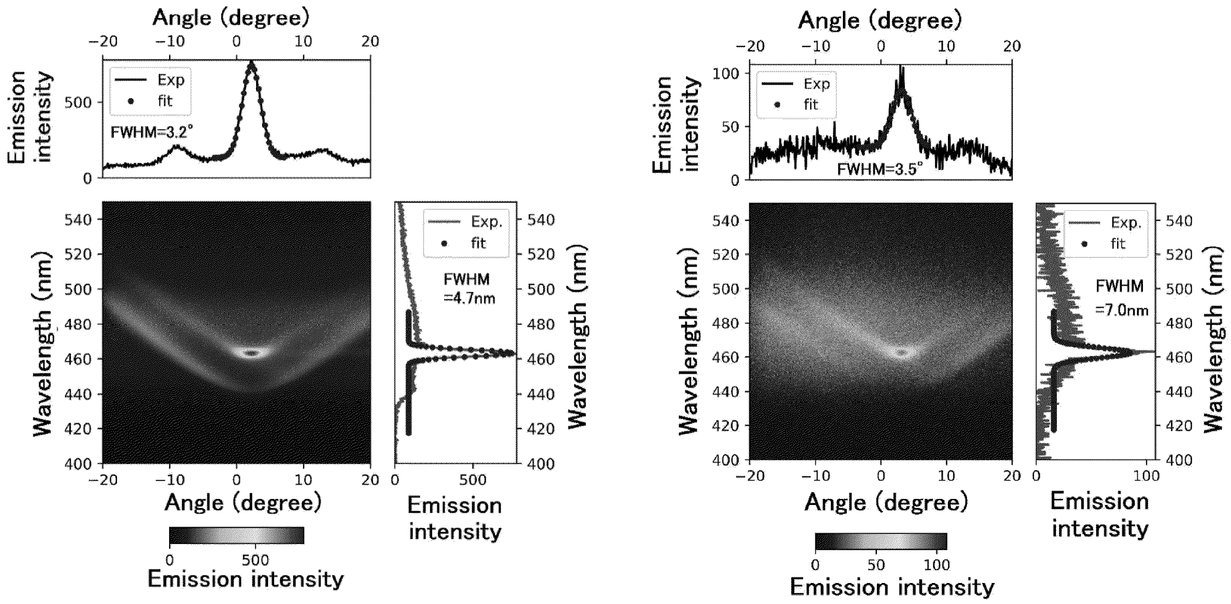

[FIG. 19]

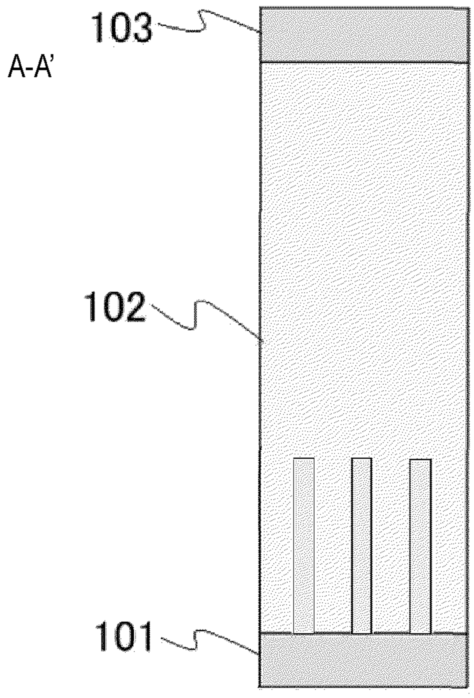
103
A-A'
102
101

[FIG. 20]

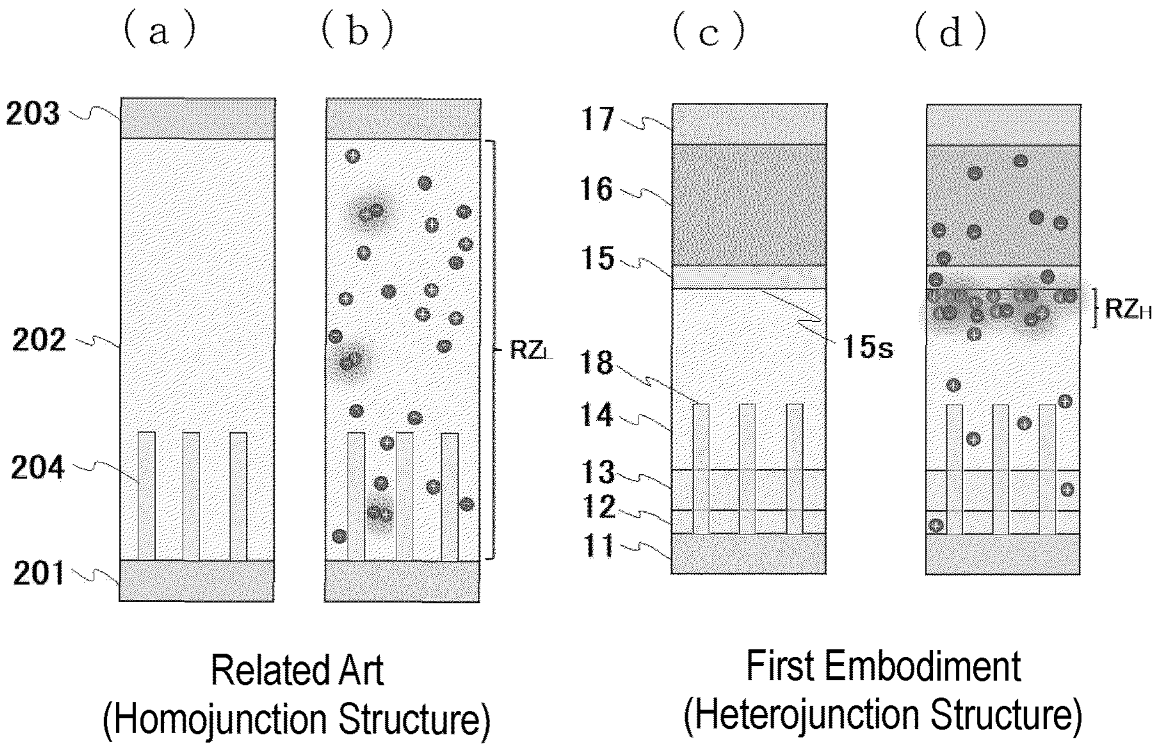
(a)
(b)
(c)
(d)
203
202
204
201
RZL
17
16
15
15s
18
14
13
12
11
RZH
Related Art
(Homojunction Structure)
First Embodiment
(Heterojunction Structure)

**INTERNATIONAL SEARCH REPORT**

International application No. **PCT/JP2024/005609**

**A. CLASSIFICATION OF SUBJECT MATTER**

***H10K 50/852***(2023.01)i; ***H01S 5/36***(2006.01)i; ***H10K 50/15***(2023.01)i; ***H10K 50/16***(2023.01)i; ***H10K 50/18***(2023.01)i; ***H10K 50/858***(2023.01)i

FI: H10K50/852; H10K50/18; H10K50/15; H10K50/16; H10K50/858; H01S5/36

According to International Patent Classification (IPC) or to both national classification and IPC

**B. FIELDS SEARCHED**

Minimum documentation searched (classification system followed by classification symbols)

H10K50/852; H01S5/36; H10K50/15; H10K50/16; H10K50/18; H10K50/858

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2020-506527 A (KYUSHU UNIVERSITY) 27 February 2020 (2020-02-27) claims, paragraphs [0035], [0036], [0040], [0042], etc. | 26-45<br>1-25 |
| Y | JP 2019-153659 A (JAPAN DISPLAY INC.) 12 September 2019 (2019-09-12) paragraphs [0014], [0020], [0025], fig. 1, etc. | 26-45 |
| Y | JP 2009-48837 A (KYUSHU UNIVERSITY) 05 March 2009 (2009-03-05) paragraphs [0029], [0032], etc. | 36-37, 45 |

☐ Further documents are listed in the continuation of Box C.

☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **22 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/005609**

| Patent document cited in search report | Publication date (day/month/year) | Patent family member(s) | Publication date (day/month/year) |
|---|---|---|---|
| JP 2020-506527 A | 27 February 2020 | US 2020/0028331 A1<br>claims, paragraphs [0093], [0094], [0100], [0103], etc.<br>WO 2018/043763 A1<br>EP 3580821 A1<br>KR 10-2018-0026320 A<br>TW 201820729 A<br>CN 109792134 A | |
| JP 2019-153659 A | 12 September 2019 | (Family: none) | |
| JP 2009-48837 A | 05 March 2009 | US 7965037 B2<br>column 4, lines 31-35, column 5, lines 38-67 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2018147470 A